# EUROPEAN PATENT SPECIFICATION

(11) **EP 2 159 640 B1**
(45) Date of publication and mention of the grant of the patent: **24.07.2013**
(21) Application number: 09168883.8
(22) Date of filing: 28.08.2009
(51) Int. Cl.: G03F 7/32

(54) **Method of preparing lithographic printing plate**
Verfahren zur Vorbereitung einer lithografischen Druckplatte
Procédé de préparation de plaque d'impression lithographique

(30) Priority: 29.08.2008 JP 2008221664
(43) Date of publication of application: 03.03.2010
(73) Proprietor: Fujifilm Corporation, Minato-ku Tokyo (JP)
(72) Inventor: Ohishi, Chikashi, Haibara-gun Shizuoka (JP); Kawauchi, Ikuo, Haibara-gun Shizuoka (JP); Adachi, Keiichi, Haibara-gun Shizuoka (JP)
(74) Representative: Grünecker, Kinkeldey, Stockmair & Schwanhäusser

(56) References cited:
- EP-A1- 1 722 272
- EP-A1- 2 103 993
- EP-A1- 2 103 994
- EP-A2- 0 415 392
- EP-A2- 1 437 626

## Description

### FIELD OF THE INVENTION

The present invention relates to a method of preparing a lithographic printing plate.

### BACKGROUND OF THE INVENTION

In general, a lithographic printing plate is composed of an oleophilic image area accepting ink and a hydrophilic non-image area accepting dampening water in the process of printing. Lithographic printing is a printing method which comprises rendering the oleophilic image area of the lithographic printing plate to an ink-receptive area and the hydrophilic non-image area thereof to a dampening water-receptive area (ink unreceptive area), thereby making a difference in adherence of ink on the surface of the lithographic printing plate, and depositing the ink only on the image area by utilizing the nature of water and printing ink to repel with each other, and then transferring the ink to a printing material, for example, paper.

In order to prepare the lithographic printing plate, a lithographic printing plate precursor (PS plate) comprising a hydrophilic support having provided thereon an oleophilic photosensitive resin layer (also referred to as a photosensitive layer or an image-recording layer) has heretofore been broadly used. Ordinarily, the lithographic printing plate is obtained by conducting plate making according to a method of exposing the lithographic printing plate precursor through an original, for example, a lith film, and then removing the unnecessary portion of the image-recording layer by dissolving with an alkaline developer or an organic solvent thereby revealing the hydrophilic surface of support to form the non-image area while leaving the image-recording layer in the portion for forming the image area.

Thus, in the hitherto known plate making process of lithographic printing plate precursor, after exposure, the step of removing the unnecessary portion of the image-recording layer by dissolving, for example, with a developer is required. However, in view of the environment and safety, a processing with a developer closer to a neutral range and a small amount of waste liquid are problems to be solved. Particularly, since disposal of waste liquid discharged accompanying the wet treatment has become a great concern throughout the field of industry in view of the consideration for global environment in recent years, the demand for the resolution of the above-described problems has been increased more and more.

On the other hand, digitalized technique of electronically processing, accumulating and outputting image information using a computer has been popularized in recent years, and various new image outputting systems responding to the digitalized technique have been put into practical use. Correspondingly, attention has been drawn to a computer-to-plate (CTP) technique of carrying digitalized image information on highly converging radiation, for example, laser light and conducting scanning exposure of a lithographic printing plate precursor with the light thereby directly preparing a lithographic printing plate without using a lith film. Thus, it is one of important technical subjects to obtain a lithographic printing plate precursor adaptable to the technique described above.

As described above, the decrease in alkali concentration of developer and the simplification of processing step have been further strongly required from both aspects of the consideration for global environment and the adaptation for space saving and low running cost However, since hitherto known development processing comprises three steps of developing with an aqueous alkali solution having pH of 11 or more, washing of the alkali agent with a water-washing bath and then treating with a gum solution mainly comprising a hydrophilic resin as described above, an automatic developing machine per se requires a large space and problems of the environment and running cost, for example, disposal of the development waste liquid, water-washing waste liquid and gum waste liquid still remain.

In response to the above situation, for instance, a developing method of processing by immersing the lithographic printing plate precursor in a developer having pH of 8.5 to 11.5 and a dielectric constant of 3 to 30 mS/cm and containing an alkali metal carbonate and an alkali metal hydrogen carbonate is proposed in JP-A-11-65126 (the term "JP-A" as used herein means an "unexamined published Japanese patent application"). However, since the developing method is required a water-washing step and a treatment step with a gum solution after the developing of the lithographic printing plate precursor, it does not resolve the problems of the environment and running cost.

One-solution processing with a processing solution having pH of 11.9 to 12.1 and containing a water-soluble polymer compound is described in the example of EP-A-1868036. However, since the printing plate obtained by the processing is left in the state that the alkali of pH 12 adheres on the surface thereof, a problem in view of safety of an operator arises and with the lapse of long time after the preparation of the printing plate until the initiation of printing, the image area gradually dissolves to result in deterioration in printing durability or ink-receptive property.

In JP-T-2007-538279 (the term "JP-T' as used herein means a published Japanese translation of a PCT patent application), processing with a processing solution having pH of 3 to 9 and containing a water-soluble polymer compound is described. However, since the processing solution does not contain a basic component, it is necessary to enable development by making a polymer used in a photosensitive layer hydrophilic and thus, a problem occurs in that printing durability severely degrades.

Further, in Japanese Patent 3,784,931, a method of developing with an aqueous solution of an alkali metal carbonate and an alkali metal hydrogen carbonate is described. However, the method includes the treatment step with a gum solution and thus, it does not resolve the problems of consideration for global environment, space saving and low running cost.

Moreover, in WO 2007/144096, an embodiment where a treatment step with a gum solution is omitted after development processing with an alkali solution having pH of 9.5 to 14 is described. However the embodiment is still insufficient in view of development processing property, tackiness of plate surface after development, development scum, repeated running aptitude or the like.

Further, since the embodiment in WO 2007/144096 does not include the treatment step with a gum solution, it is poor in surface protection function. Specifically, the non-image area is apt to be stained by an external factor and in particular, there is a problem of printing stain (hereinafter, also.referred to as fingerprint stain) occurred when the non-image area of the plate after development is held with bare hands.

EP2103993A1 discloses an automatic processing method for obtaining a lithographic printing plate including dip development.

EP1722272A1 describes a method for preparing a lithographic printing plate precursor having a photosensitive layer containing oligo- and polysaccharides.

EP 04115392A2 discloses a printing plate processing apparatus wherein the circulation of the aqueous solution between the developing tank and an eternal tank (overflow tank 18) is provided in order to keep the liquid level in the developing tank constant.

### SUMMARY OF THE INVENTION

The present invention has been made in view of the circumstances described above. An object of the invention is to provide a method of preparing a lithographic printing plate which is safe and exhibits excellent processing ability. Another object of the invention is to provide a method of preparing a lithographic printing plate which enables simplification of processing steps without accompanying damage to performances of the lithographic printing plate obtained.

### [Means for solving the problems]

(1) A method of preparing a lithographic printing plate comprising exposing imagewise a lithographic printing plate precursor comprising a hydrophilic support and an image-recording layer containing a sensitizing dye, a polymerization initiator, an addition polymerizable compound having an ethylenically unsaturated double bond and a binder polymer wherein the binder polymer has an acid group in a ride chain and processing the imagewise exposed lithographic printing plate precursor in a state where the imagewise exposed lithographic printing plate precursor is immersed in a developing tank holding an aqueous solution having pH of 8.5 to 10.8 and containing a low molecular weight hydroxycarboxylate ion having a molecular weight of 500 or less, a pH buffer agent and a surfactant with circulation of the aqueous solution between the developing tank and an external tank provided outside a processing path line including the developing tank so as to keep constant a liquid level of the aqueous solution in the developing tank, wherein the exposed lithographic printing plate precursor is processed with only one solution of the aqueous solution.
(2) The method of preparing a lithographic printing plate as described in (1) above, wherein the lithographic printing plate precursor is contacted with at least one rubbing member which rotates in the aqueous solution in the developing tank to remove a non-image area of the lithographic printing plate precursor.
(3) The method of preparing a lithographic printing plate as described in (2) above, wherein the removal operation of the non-image area of the lithographic printing plate precursor by contact with the rubbing member which rotates is performed at least 2 seconds after a part of the lithographic printing plate precursor to be subjected to contact with the rubbing member is contacted with the aqueous solution.
(4) The method of preparing a lithographic printing plate as described in (3) above, wherein the rubbing member is deposited on a downstream side of a center of transporting path of the lithographic printing plate precursor in the developing bath (developing tank) in a transporting direction.
(5) The method of preparing a lithographic printing plate as described in (4) above, wherein the aqueous solution in the external tank is sprayed to the lithographic printing plate precursor near a lead-in roller provided on an upstream side than the developing bath in a transporting direction and a lead-out roller provided on a downstream side than the developing bath in a transporting direction in a transporting path of the lithographic printing plate precursor.
(6) The method of preparing a lithographic printing plate as described in any one of (1) to (5) above, wherein the imagewise exposed lithographic printing plate precursor is subjected to a heat treatment and then processed in a state where the imagewise exposed lithographic printing plate precursor is immersed in the developing tank.
(7) The method of preparing a lithographic printing plate as described in any one of (1) to (6) above, wherein the aqueous solution contains a water-soluble resin.
(8) The method of preparing a lithographic printing plate as described in any one of (1) to (7) above, wherein the low molecular weight hydroxycarboxylate ion is a hydroxycarboxylate ion having at least two carboxylic acid groups.
(9) The method of preparing a lithographic printing plate as described in any one of (1) to (7) above, wherein the low molecular weight hydroxycarboxylate ion is at least one selected from the group consisting of a citrate ion, a tartrate ion and a malate ion.
(10) The method of preparing a lithographic printing plate as described in any one of (1) to (9) above, wherein the pH buffer agent is at least one selected from the group consisting of a carbonate ion and a hydrogen carbonate ion, a borate ion, and a water-soluble amine compound and an ion of the amine compound.
(11) The method of preparing a lithographic printing plate as described in any one of (1) to (10) above, wherein the sensitizing dye is a sensitizing dye represented by any one of the following formulae (1) to (5): 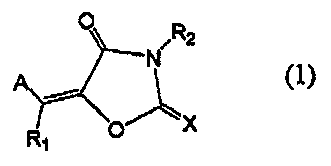 in formula (1), A represents an aromatic cyclic group which may have a substituent or a heterocyclic group which may have a substituent, X represents an oxygen atom, a sulfur atom or =N-R₃, and R₁, R₂ and R₃ each independently represents a monovalent non-metallic atomic group, or A and R₁ or R₂ and R₃ may be combined with each other to form an aliphatic or aromatic ring; 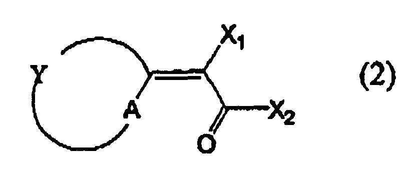 in formula (2), A represents a sulfur atom or NR₆, R₆ represents a monovalent non-metallic atomic group, Y represents a non-metallic atomic group necessary for forming a basic nucleus of the dye together with adjacent A and the adjacent carbon atom, and X₁ and X₂ each independently represents a monovalent non-metallic atomic group or X₁ and X₂ may be combined with each other to form an acidic nucleus of the dye; 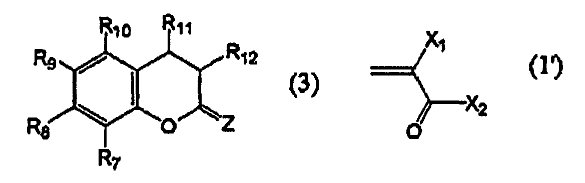 in formula (3), =Z represents an oxo group, a thioxo group, an imino group or an alkylydene group represented by partial structural formula (I') described above, X₁ and X₂ have the same meanings as defined in formulae (2) respectively, and R₇ to R₁₂ each independently represents a monovalent non-metallic atomic group; 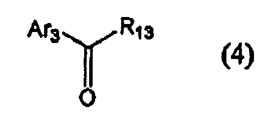 in formula (4), Ar₃ represents an aromatic group which may have a substituent or a heteroaromatic group which may have a substituent. R₁₃ preferably represents an aromatic group or a heteroaromatic group, Alternatively, Ar₃ and R₁₃ may be combined with each other to form a ring; 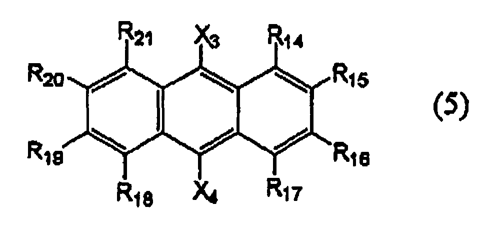 in formula (5), X₃, X₄ and R₁₄ to R₂₁ each independently represents a monovalent non-metallic atomic group. Preferably, X₃ and X₄ each independently represents an electron-donating group having a negative Hammett substituent constant
(12) The method of preparing a lithographic printing plate as described in any one of (1) to (11) above, wherein the lithographic printing plate precursor is exposed imagewise by a laser beam having a wavelength of 350 to 450 nm.
(13) The method of preparing a lithographic printing plate as described in any one of (1) to (12) above, wherein the lithographic printing plate precursor has a protective layer on the image-recording layer.

According to the present invention, since an aqueous low alkali solution having pH of 8.5 to 10.8 and containing a low molecular weight hydroxycarboxylate ion, a pH buffer agent and a surfactant is used as an aqueous solution for processing a lithographic printing plate precursor, stain of a lithographic printing plate can be inhibited, deterioration of the processing ability due to fluctuation of pH of the developer is restrained, and improvement in safety can be achieved. Further, since the aqueous solution is circulated between a developing tank and an external tank so as to keep constant a liquid level of the aqueous solution in the developing tank holding the aqueous solution for processing a lithographic printing plate precursor, it is possible to perform stable processing.

Moreover, according to the invention, when the aqueous solution for processing a lithographic printing plate precursor contains a water-soluble resin, it is possible to perform a one-solution processing with the aqueous solution. The term "one-solution processing" as used herein means a processing wherein development processing and gumming processing which are bare essentials of a standard processing are conducted by one solution. By the one-solution processing, the processing steps can be simplified without accompanying damage to performances of the lithographic printing plate obtained and the amount of waste liquid can be reduced.

### BRIEF DESCRIPTION OF THE DRAWINGS

Fig. 1 is a constitutional view of an example of an automatic developing apparatus for practicing a method of preparing a lithographic printing plate.
Fig. 2 is a constitutional view of another example of an automatic developing apparatus for practicing a method of preparing a lithographic printing plate.
Fig. 3A is a constitutional view of showing the automatic developing apparatus shown in Fig. 2, and Fig. 3B is a constitutional view showin a conventional automatic developing apparatus similar to the automatic developing apparatus shown in Fig. 2.

### [Description of reference numerals and signs]

- 2, 2':: Automatic developing apparatus
- 4:: PS plate
- 6;: Developing unit
- 10:: Drying unit
- 12:: Side plate
- 14:: Insertion slot
- 16:: Transport roller (canying-in roller)
- 18:: Rubber blade
- 20:: Developing tank
- 24:: Brush roller (rubbing member)
- 26:: Squeeze roller (carrying-out roller)
- 27:: Plate detection sensor
- 36:: Guide roller
- 38:: Skewer roller
- 40:: Discharge slot
- 46:: Passage
- 50:: Control device
- 51:: Control ROM and RAM
- 52:: Timekeeper
- 55:: External tank
- 55':: Developer storage tank
- 58:: Developer
- 60:: Shielding cover
- 62:: Rubber blade
- 71:: Developer circulation pump
- 73:: Conductivity sensor
- 74:: Developer supply pump
- 80:: First circulation pipeline
- 90:: Second circulation pipeline
- 90': Developer replenish pipeline
- 98:: Display device
- 99:: Alarm device

### DETAILED DESCRIPTION OF THE INVENTION

### [Lithographic printing plate precursor]

With the lithographic printing plate precursor for use in the invention, the construction thereof will be described in turn below.

### [Support]

At the beginning, a support for the lithographic printing plate precursor used in the invention is described.

Although any support having a hydrophilic surface may be used, a dimensionally stable plate-like material is preferably used for the support. Examples of the support include paper, paper laminated with plastic (for example, polyethylene, polypropylene or polystyrene), a plate of metal (for example, aluminum, zinc or copper) or its alloy (for example, aluminum alloy with silicon, copper, manganese, magnesium, chromium, zinc, lead, bismuth or nickel), a plastic film (for example, cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate or polyvinyl acetal) and paper or a plastic film having laminated with or vapor-deposited thereon the metal or alloy as described above. Of he supports, an aluminum plate is particularly preferred, because it has extremely dimensional stability and is inexpensive. Also, a composite sheet comprising a polyethylene terephthalate film having bonded thereon an aluminum sheet described in JP-B-48-18327 (the term "JP-B" as used herein means an "examined Japanese patent publication") is preferred. Ordinarily, the thickness of the support is approximately from 0.05 to 1 mm.

In case of using a support having a metal surface, particularly, an aluminum surface, the support is preferably subjected to a surface treatment, for example, a graining treatment, an immersion treatment in an aqueous solution, for example, of sodium silicate, potassium fluorozirconate or a phosphate, or anodizing treatment described below.

### [Graining treatment]

As a method for the graining treatment, an electrochemical graining method wherein surface graining is electrochemically conducted in an electrolytic solution of hydrochloric acid or nitric acid or a mechanical graining method, for example, a wire brush graining method wherein a surface of aluminum plate is scratched with a wire brush, a ball graining method wherein a surface of aluminum plate is grained with abrasive balls and an abrasive or a brush graining method wherein a surface of aluminum plate is grained with a nylon brush and an abrasive can be employed. The graining methods may be used individually or in combination of two or more thereof For instance, a method of conducting mechanical graining, chemical etching and electrolytic graining is described in JP-A-56-28893.

Specifically, a method of forming useful surface roughness is an electrochemical graining method wherein surface graining is electrochemically conducted in an electrolytic solution of hydrochloric acid or nitric acid and suitable current density is in a range from 100 to 400 Coulomb/dm². More specifically, it is preferred to perform electrolysis in an electrolytic solution containing from 0.1 to 50% by weight of hydrochloric acid or nitric acid under the conditions of temperature from 20 to 100°C, time from one second to 30 minutes and current density from 100 to 400 Coulomb/dm².

The aluminum support subjected to the graining treatment is then chemically etched with an acid or an alkali. The method of using an acid as an etching agent takes time for destroying fine structures. Such a problem may be resolved by using an alkali as the etching agent.

Examples of the alkali agent preferably used include sodium hydroxide, sodium carbonate, sodium aluminate, sodium metasilicate, sodium phosphate, potassium hydroxide and lithium hydroxide. Preferable ranges of the concentration and temperature are form 1 to 50% and 20 to 100°C, respectively. The conditions for providing a dissolution amount of aluminum in a range from 5 to 20 g/m³ are preferable.

After the etching procedure, the aluminum support is subjected to washing with an acid for removing stain (smut) remaining on the surface thereof Examples of the acid for use in the acid-washing step include nitric acid, sulfuric acid, phosphoric acid, chromic acid, hydrofluoric acid and hydrofluoroboric acid. As the method for removing smut after the electrochemical graining treatment, a method of bringing the aluminum support into contact with a 15 to 65% by weight aqueous sulfuric acid solution having a temperature of 50 to 90°C as described in JP-A-53-12739 and a method of performing alkali etching as described in JP-B-48-28123 are preferred.

Surface roughness (Ra) of the aluminum support is preferably from 0.3 to 0.7 µm.

### [Anodizing treatment]

The aluminum support subjected to the graining treatment described above may further be subjected to anodizing treatment. The anodizing treatment can be conducted in a manner conventionally used in the field of art.

Specifically, it is performed by applying direct current or alternating current to the aluminum support in an aqueous solution or non-aqueous solution containing sulfuric acid, phosphoric acid, chromic acid, oxalic acid, sulfamic acid, benzenesulfonic acid, or a combination of two or more thereof to form an anodic oxide film on the surface of aluminum support.

The conditions of anodizing treatment cannot be determined generally, since they vary widely depending on the electrolytic solution to be used. However, it is ordinarily suitable that a concentration of the electrolytic solution is in a range from I to 80%, a temperature of the electrolytic solution is in a range from 5 to 70°C, a current density is in a range from 0.5 to 60 Ampere/dm², a voltage is in a range from 1 to 100 V, and a period of electrolysis is in a range from 10 to 100 seconds.

Of the anodizing treatments, a method of anodizing in a sulfuric acid solution with a high current density described in British Patent 1,412,768 and a method of anodizing using phosphoric acid as an electrolytic bath described in U.S. Patent 3,511,661 are preferably used.

The amount of anodic oxide film is preferably from 1 to 10 g/m². When the amount is less than 1 g/m², the printing plate is apt to be scratched. When the amount exceeds 10 g/m², a large quantity of electric power is necessary and thus it is economically disadvantageous. The amount of anodic oxide film is more preferably from 1,5 to 7 g/m², and still more preferably from 2 to 5 g/m².

The aluminum support may further be subjected to a sealing treatment of the anodic oxide film after the graining treatment and anodizing treatment. The sealing treatment is performed by immersing the aluminum support in hot water or a hot aqueous solution containing an inorganic salt or an organic salt, or transporting the aluminum support in a water vapor bath. Moreover, the aluminum support may be subjected to a surface treatment, for example, silicate treatment with an alkali metal silicate or immersion treatment in an aqueous solution, for example, of potassium fluorozirconate or a phosphate.

On a support (in case of aluminum support, the aluminum support appropriately subjected to the surface treatment as described above is preferable), for example, an image-recording layer comprising a photopolymerizable photosensitive composition is coated and, if desired, a protective layer is coated on the image-recording layer to prepare a lithographic printing plate precursor. In advance of the coating of image-recording layer, an organic or inorganic undercoat layer may be provided on the support, if desired. A sol-gel treatment where a functional group capable of initiating an addition reaction upon a radical is covalently bonded on the surface of support as described in JP-A-7-159983 may be performed.

As a substance for forming the organic undercoat layer, for instance, a water-soluble resin, for example, polyvinylphosphonic acid, a polymer or copolymer having a sulfonic acid group in its side chain or polyacrylic acid, a yellow dye or an amine salt is exemplified.

Specifically, examples of the organic compound used in the organic undercoat layer include carboxymethyl cellulose, dextrin, gum arabic, a phosphonic acid having an amino group, for example, 2-aminoethylphosphonic acid, an organic phosphonic acid, for example, phenylphosphonic acid, naphthylphosphonic acid, alkylphosphonic acid, glycerophosphonic acid, polyvinylphosphonic acid, methylenediphosphonic acid or ethylenediphosphonic acid, each of which may have a substituent, an organic phosphoric acid, for example, phenylphosphoric acid, naphthylphosphoric acid, alkylphosphoric acid or glycerophosphoric acid, each of which may have a substituent, an organic phosphinic acid, for example, phenylphosphinic acid, naphthylphosphinic acid, alkylphosphinic acid or glycerophosphinic acid, each of which may have a substituent, an amino acid, for example, glycine or β-alanine, and a hydrochloride of amine having a hydroxy group, for example, triethanolamine hydrochloride. The organic compounds may be used as a mixture of two or more thereof.

The organic undercoat layer can be provided by the following methods. Specifically, there are a method of dissolving the organic compound described above in water, an organic solvent, for example, methanol, ethanol or methyl ethyl ketone, or a mixed solvent thereof, coating the resulting solution on a support and drying it to provide the organic undercoat layer, and a method of dissolving the organic compound described above in water, an organic solvent, for example, methanol, ethanol or methyl ethyl ketone, or a mixed solvent thereof, immersing a support in the resulting solution to adsorb the organic compound, washing the support, for example, with water, and drying it to provide the organic undercoat layer. In the former method, the solution containing the organic compound in a concentration of 0.005 to 10% by weight can be coated by various methods. Any method including, for example, bar coater coating, spin coating, spray coating or curtain coating may be used. In the latter method, the concentration of the organic compound in the solution is from 0.01 to 20% by weight, preferably from 0.05 to 5% by weight, the immersion temperature is from 20 to 90°C, preferably from 25 to 50°C, and the immersion time is from 0.1 second to 20 minutes, preferably from 2 seconds to 1 minute.

The solution used may also be used by adjusting its pH to a range from I to 12 with a basic substance, for example, ammonia, triethylamine or potassium hydroxide or an acidic substance, for example, hydrochloric acid or phosphoric acid. Moreover, a yellow dye may also be added to the solution in order to improve the tone reproducibility of the lithographic printing plate precursor.

The coverage of the organic undercoat layer after drying is suitably from 2 to 200 mg/m², and preferably from 5 to 100 mg/m². When the coverage of the organic undercoat layer is less than 2 mg/m², sufficient printing durability may not be obtained in some cases. When the coverage thereof is more than 200 mg/m², the same problem may also arise.

Examples of the substance used in the inorganic undercoat layer include an inorganic salt, for example, cobalt acetate, nickel acetate or potassium fluorotitanate. The method of providing the inorganic undercoat layer is similar to that of the organic undercoat layer described above.

From the standpoint of increase in printing durability, the undercoat layer preferably contains a polymer or copolymer having any one of a phosphonic acid group, a phosphoric acid group and a sulfonic acid group in its side chain. In case of the copolymer, it contains a polymerization component having such a group preferably from 10 to 90% by mole, and more preferably from 20 to 50% by mole. Further, the copolymer preferably contains an ethylenically unsaturated bond in its side chain. The copolymer contains a polymerization component having the ethylenically unsaturated bond preferably from 10 to 90% by mole, and more preferably from 15 to 40% by mole.

### [Image-recording layer]

The image-recording layer (hereinafter, also referred to as a photosensitive layer) of the lithographic printing plate precursor for use in the invention contains as the essential components, (i) a sensitizing dye, (ii) a polymerization initiator, (iii) an addition polymerizable compound having an ethylenically unsaturated double bond and (iv) a binder polymer.

### [Sensitizing dye]

The sensitizing dye for use in the invention is a dye capable of transmitting the energy oflaser beam absorbed to a polymerization initiator with energy transfer or electron transfer.

An absorption wavelength of the sensitizing dye is not particularly restricted as long as the sensitizing dye has the above-described function. The sensitizing dye is appropriately selected depending on a wavelength of laser used for the exposure. In the invention, particularly, a sensitizing dye having an absorption maximum in a wavelength range of 350 to 450 nm is preferably used. Such sensitizing dyes include, for example, merocyanine dyes represented by formula (2) shown below, benzopyrans or coumarins represented by formula (3) shown below, aromatic ketones represented by formula (4) shown below and anthracenes represented by formula (5) shown below.

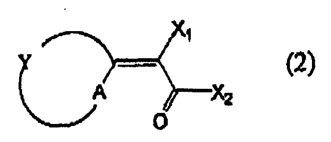

In formula (2), A represents a sulfur atom or NR₆, R₆ represents a monovalent non-metallic atomic group, Y represents a non-metallic atomic group necessary for forming a basic nucleus of the dye together with adjacent A and the adjacent carbon atom, and X₁ and X₂ each independently represents a monovalent non-metallic atomic group or X₁ and X₂ may be combined with each other to form an acidic nucleus of the dye.

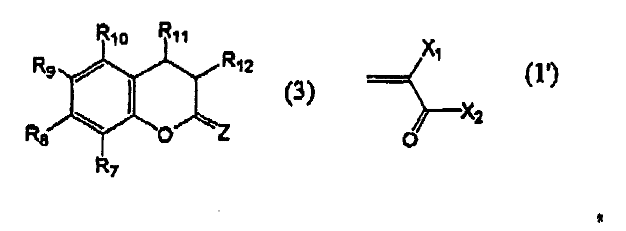

In formulae (3), =Z represents an oxo group, a thioxo group, an imino group or an alkylydene group represented by the partial structural formula (I') described above, X₁ and X₂ have the same meanings as defined in formula (2) respectively, and R₇ to R₁₂ each independently represents a monovalent non-metallic atomic group.

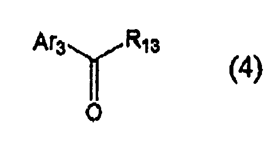

In formula (4), Ar₃ represents an aromatic group which may have a substituent or a heteroaromatic group which may have a substituent, and R₁₃ represents a monovalent non-metallic atomic group. R₁₃ preferably represents an aromatic group or a heteroaromatic group. Ar₃ and R₁₃ may be combined with each other to form a ring.

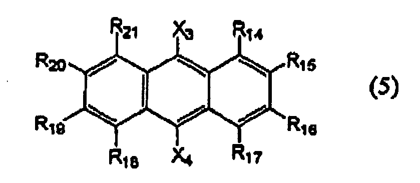

In formula (5), X₃, X₄ and R₁₄ to R₂₁ each independently represents a monovalent non-metallic atomic group. Preferably, X₃ and X₄ each independently represents an electron-donating group having a negative Hammett substituent constant.

In formulae (2) to (5), preferable examples of the monovalent non-metallic atomic group represented by any one of X₁ to X₄ and R₆ to R₂₁ include a hydrogen atom, an alkyl group (for example, a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eucosyl group, an isopropyl group, an isobutyl group, a sec-butyl group, a tert-butyl group, an isopentyl group, a neopentyl group, a 1-methylbutyl group, an isohexyl group, a 2-ethylhexyl group, a 2-methylhexyl group, a cyclohexyl group, a cyclopentyl group, a 2-norbornyl group, a chloromethyl group, a bromomethyl group, a 2-chloroethyl group, a trifluoromethyl group, a methoxymethyl group, a methoxyethoxyethyl group, an allyloxymethyl group, a phenoxymethyl group, a methylthiomethyl group, a tolylthiomethyl group, an ethylaminoethyl group, a diethylaminopropyl group, a morpholinopropyl group, an acetyloxymethyl group, a benzoyloxymethyl group, an N-cyclohexylcarbamoyloxyethyl group, an N-phenylarbamoyloxyethyl group, an acetylaminoethyl group, an N-methylbenzoylaminopropyl group, a 2-oxoethyl group, a 2-oxopropyl group, a carboxypropyl group, a methoxycarbonylethyl group, an allyloxycarbonylbutyl group, a chlorophenoxycarbonylmethyl group, a carbamoylmethyl group, an N-methylcarbamoylethyl group, an N,N-dipropylcarbamoylmethyl group, an N-(methoxyphenyl)carbamoylemyl group, an N-methyl-N-(sulfophenyl)-carbamoylmethyl group, a sulfobutyl group, a sulfonatobutyl group, a sulfamoylbutyl group, an N-ethylsulfamoylmethyl group, an N,N-dipropylsulfamoylpropyl group, an N-tolylsulfamoylpropyl group, an N-methyl-N-(phosphonophenyl)sufamoyloctyl group, a phosphonobutyl group, a phosphonatohexyl group, a diethylphosphonobutyl group, a diphenylphosphonopropyl group, a methylphosphonobutyl group, a methylphosphonatobutyl group, a tolylphosphonohexyl group, a tolylphosphonatohexyl group, a phosphonooxypropyl group, a phosphonatooxybutyl group, a benzyl group, a phenethyl group, an α-methylbenzyl group, a 1-methyl-1-phenylethyl group, a p-methylbenzyl group, a cinnamyl group, an allyl group, a 1-propenylmethyl group, a 2-butenyl group, a 2-methylallyl group, a 2-methylpropenylmethyl group, a 2-propynyl group, a 2-butynyl group or a 3-butynyl group), an aryl group (for example, a phenyl group, a biphenyl group, a naphthyl group, a tolyl group, a xylyl group, a mesityl group, a cumenyl group, a chlorophenyl group, a bromophenyl group, a chloromethylphenyl group, a hydroxyphenyl group, a methoxyphenyl group, an ethoxyphenyl group, a phenoxyphenyl group, an acetoxyphenyl group, a benzoyloxyphenyl group, a methylthiophenyl group, a phenylthiophenyl group, a methylaminophenyl group, a dimethylaminophenyl group, an acetylaminophenyl group, a carboxyphenyl group, a methoxycarbonylphenyl group, an ethoxycarbonylphenyl group, a phenoxycarbonylphenyl group, an N-phenylcarbamoylphenyl group, a nitrophenyl group, a cyanophenyl group, a sulfophenyl group, a sulfonatophenyl group, a phosphonophenyl group or a phosphonatophenyl group), a heteroaryl group (for example, a group derived from a heteroaryl ring, for examples, thiophene, thiathrene, furan, pyran, isobenzofuran, chromene, xanthene, phenoxazine, pyrrole, pyrazole, isothiazole, isoxazole, pyrazine, pyrimidine, pyridazine, indolizine, isoindolizine, indole, indazole, purine, quinolizine, isoquinoline, phthalazine, naphthylidine, quinazoline, cinnoline, pteridine, carbazole, carboline, phenanthrine, acridine, perimidine, phenanthroline, phthalazine, phenarsazine, phenoxazine, furazane or phenoxazine), an alkenyl group (for example, a vinyl group, a 1-propenyl group, a 1-butenyl group, a cinnamyl group or a 2-chloro-1-ethenyl group), an alkynyl group (for example, an ethynyl group, a 1-propynyl group, a 1-butynyl group or a trimethylsilylethynyl group), a halogen atom (for example, -F, -Br, -Cl or -I), a hydroxy group, an alkoxy group, an aryloxy group, a mercapto group, an alkylthio group, an arylthio group, an alkyldithio group, an aryldithio group, an amino group, an N-alkylamino groups, an N,N-dialkylamino group, an N-arylamino group, an N,N-diarylarmino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyloxy group, an alkylsulfoxy group, an arylsulfoxy group, an acylthio group, an acylamino group, an N-alkylacylamino group, an N-arylacylamino group, a ureido group, an N'-alkylureido group, an N',N'-dialkylureido group, an N'-arylureido group, an N',N'-diarylureido group, an N'-alkyl-N'-arylureido group, an N-alkylureido group, an N-arylureido group, an N'-alkyl-N-alkylureido group, an N'-alkyl-N-arylureido group, an N',N'-dialkyl-N-alkylureido group, an N',N'-dialkyl-N-arylureido group, an N'-aryl-N-alkylureido group, an N'-aryl-N-arylureido group, an N'N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group, an N-aryl-N-aryloxycarbonylamino group, a formal group, an acyl group, a carboxyl group, an alkoxycarbonyl group, an aryloxycarbonyl group, a carbamoyl group, an N-alkylcarbamoyl group, an N,N-diallrylearbamoyl group, an N-arylcarbamoyl group, an N,N-diarylcarbamoyl group, an N-alkyl-N-arylcarbamoyl group, an alkylsulfinyl group, an arylsulfinyl group, an alkylsulfonyl group, an arylsulfonyl group, a sulfo group (-SO₃H) and its conjugated base group (hereinafter referred to as a "sulfonato group"), an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfnamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, a phosphono group (-PO₃H₂) and its conjugated base group (hereinafter referred to as a "phosphonato group"), a dialkylphosphono group (-PO₃(alkyl)₂), a diarylphosphono group (-PO₃(aryl)₂), an alkylarylphosphono group (-PO₃(alkyl)(aryl)), a monoalkylphosphono group (-PO₃H(alkyl)) and its conjugated base group (hereinafter referred to as an "alkylphosphonato group"), a monoarylphosphono group (-PO₃H(aryl)) and its conjugated base group (hereinafter referred to as an "arylphosphonato group"), a phosphonooxy group (-OPO₃H₂) and its conjugated base group (hereinafter referred to as a "phosphonatooxy group"), a dialkylphosphonooxy group (-OPO₃(alkyl)₂), a diarylphosphonooxy group (-PPO₃(aryl)₂), an alkylarylphosphonooxy group (-OPO₃(alkyl)(aryl)), a manoalkylphosphonooxy group (-OPO₃H(alkyl)) and its conjugated base group (hereinafter referred to as an "alkylphosphonatooxy group"), a monoarylphosphonooxy group (-OPO₃H(aryl)) and its conjugated base group (hereinafter referred to as an "arylphosphonatooxy group"), a cyano group and a nitro group. Among the above-described monovalent non-metallic atomic groups, a hydrogen atom, an alkyl group, an aryl group, a halogen atom, an alkoxy group and an acyl group are particularly preferred.

The basic nucleus of the dye formed by Y together with the adjacent A and the adjacent carbon atom in formula (2) includes, for example, a 5-membered, 6-membered or 7-membered, nitrogen-containing or sulfur-containing heterocyclic ring, and is preferably a 5-membered or 6-membered heterocyclic ring,

As the nitrogen-containing heterocyclic ring, those which are known to constitute basic nuclei in merocyanine dyes described in L.G. Brooker et al, J. Am. Chem. Soc., Vol. 73, pp. 5326 to 5358 (1951) and references cited therein can be preferably used. Specific examples thereof include thiazoles (for example, thiazole, 4-methylthiazole, 4-phenylthiazole, 5-methylthiazole, 5-phenylthiazole, 4,5-dimethylthiazole, 4,5-diphenylthiazole, 4,5-di(p-methoxyphenyl)thiazole or 4-(2-thienyl)thiazole); benzothiazoles (for example, benzothiazole, 4-chlorobenzothiazole, 5-chlorobenzothiazole, 6-chlorobenzothiazole, 7-chlorobenzothiazole, 4-methylbenzothiazole, 5-methylbenzothiazole, 6-methylbenzothiazole, 5-bromobenzothiazole, 4-phenylbenwthiazole, 5-phenylbenzothiazole, 4-methoxybenzothiazole, 5-methoxybenzathiazole, 6-methoxybenzothiazole, 5-iodobenzothiazole, 6-iodobenzothiazole, 4-ethoxybenzothiazole, 5-ethoxybenzothiazole, tetrahydrobenzothiazole, 5,5-dimethoxybenzothiazole, 5,6-dioxymethylenebenzothiazole, 5-hydroxybenzothiazole, 6-hydroxybenzothiazole, 6-dimethylaminobenzothiazole or 5-ethoxycarbonylbenzothiazole); naphthothiazoles (for example, naphtho[1,2]thiazole, naphtho[2,1]thiazole, 5-methoxynaphtho[2,1]thiazole, 5-ethoxynaphtho[2,1]thiazole, 8-methoxynaphtho[1,2]thiazole or 7-methoxynaphtho[1,2]thiazole); thianaphtheno-7',6',4,5-thiazoles (for example, 4'-methoxythianaphtheno-7',6',4,5-thiazole); oxazoles (for example, 4-methyloxazole, 5-methyloxazole, 4-phenyloxazole, 4,5-diphenyloxazole, 4-ethyloxazole, 4,5-dimethyloxazole or 5-phenyloxazole); benzoxazoles (for example, benzoxazole, 5-chlorobenzoxazole, 5-methylbenzoxazole, 5-phenylbenzoxazale, 6-methylbenzoxazole, 5,6-dimethylbenzoxazole, 4,6-dimethylbenzoxazole, 6-methoxybenzoxazole, 5-methoxybenzoxazole, 4-ethoxybenzoxazole, 5-chlorobenzoxazole, 6-methoxybenzoxazole, 5-hydroxybenzoxzole or 6-hydroxybenzoxazole); naphthoxazoles (for example, naphth[1,2]oxazole or naphth[2,I]oxazole); selenazoles (for example, 4-methylselenazole or 4-phenylselenazole); benzoselenazoles (for example, benzoselenazole, 5-chlorobenzoselenazole, 5-methoxybenzoselenazole, 5-hydroxybenzoselenazole or tetrahydrobenzoselenazole); naphthoselenazoles (for example, naphtho[1,2]selenazole or naphtho[2,1]selenazole); thiazolines (for example, thiazoline or 4-methylthiazoline); quinolines (for example, quinoline, 3-methylquinoline, 5-methylquinoline, 7-methylquinoline, 8-methylquinoline, 6-chloroquinoline, 8-choroquinoline, 6-methoxyquinoline, 6-ethoxyquinoline, 6-hydroxyquinoline or 8-hydroxyquinoline); isoquinolines (for example, isoquinoline or 3,4-dihydroisoquinoline); benzimidazoles (for example, 1,3-diethylbenzimidazole or 1-ethyl-3-phenylbenzimidazole); 3,3-dialkylindolenines (for example, 3,3-dimethylindoleoine, 3,3,5-trimethylindolenine or 3,3,7-trimethylindolenine); and pyridines (for example, pyridine or 5-methylpyridine).

Examples of the sulfur-containing heterocyclic ring include dithiol partial structures in dyes described in JP-A-3-296759.

Specific examples thereof include benzodithiols (for example, benzodithiol, 5-tert-butylbenzodithiol or 5-methylbenzodithiol); naphthadithiols (for example, naphtho[1,2]dithiol or naphtho[2,1]dithiol); and dithiols (for example, 4,5-dimethyldithiol, 4-phenyldithiol, 4-methoxycarbonyldithiol, 4,5-dimethoxycarbonyldithiol, 4,5-ditrifluoromethyldithiol, 4,5-dicyanodithiol, 4-methoxycarbonylmethyldithiol or 4-carboxymethyldithiol).

In the description with respect to the heterocyclic ring above, for convenience and by convention, the names of heterocyclic mother skeletons are used. In the case of constituting the basic nucleus partial structure in the sensitizing dye, the heterocyclic ring is introduced in the form of a substituent of alkylydene type where a degree of unsaturation is decreased one step. For example, a benzothiazole skeleton is introduced as a 3-substituted-2(3H)-benzothiazolilydene group.

Of the sensitizing dyes having an absorption maximum in a wavelength range of 350 to 450 nm, dyes represented by formula (1) shown below are more preferable in view of high sensitivity.

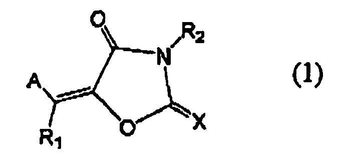

In formula (1), A represents an aromatic cyclic group which may have a substituent or a heterocyclic group which may have a substituent, X represents an oxygen atom, a sulfur atom or =N(R₃), and R₁, R₂ and R₃ each independently represents a monovalent non-metallic atomic group, or A and R₁ or R₂ and R₃ may be combined with each other to form an aliphatic or aromatic ring.

The formula (1) will be described in more detail below. R₁, R₂ and R₃ each independently represents a monovalent non-metallic atomic group, preferably a substituted or unsubstituted alkyl group, a substituted or unsubstituted alkenyl group, a substituted or unsubstituted aryl group, a substituted or unsubstituted aromatic heterocyclic residue, a substituted or unsubstituted alkoxy group, a substituted or substituted alkylthio group, a hydroxy group or a halogen atom.

Preferable examples of R₁, R₂ and R₃ will be specifically described below. Preferably examples of the alkyl group include a straight chain, branched or cyclic alkyl group having from I to 20 carbon atoms. Specific examples thereof include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eucosyl group, an isopropyl group, an isobutyl group, a sec-butyl group, a tert-butyl group, an isopentyl group, a neopentyl group, a 1-methylbutyl group, an isohexyl group, a 2-ethylhexyl group, a 2-methylhexyl group, a cyclohexyl group, a cyclopentyl group and a 2-norbomyl group. Among them, a straight chain alkyl group having from 1 to 12 carbon atoms, a branched alkyl group having from 3 to 12 carbon atoms and a cyclic alkyl group having from 5 to 10 carbon atoms are more preferable.

As the substituent for the substituted alkyl group, a monovalent non-metallic atomic group exclusive of a hydrogen atom is used. Preferable examples thereof include a halogen atom (for example, -F, -Br, -Cl or -I), a hydroxy group, an alkoxy group, an aryloxy group, a mercapto group, an alkylthio group, an arylthio group, an alkyldithio group, an aryldithio group, an amino group, an N-alkylamino group, an NN-dialkylamino group, an N-arylamino group, an N,N-diarylamina group, an N-akyl-N-aylamino group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyloxy group, an alkylsulfoxy group, an arylsulfoxy group, an acylthio group, an acylamino group, an N-alkylacylamino group, an N-arylacylamino group, a ureido group, an N-alkylureido group, an N',N'-dialkylureido group, an N'-arylureido group, an N',N'-diarylureido group, an N'-alkyl-N'-arylureido group, an N-alkylureido group, an N-arylureido group, an N'-alkyl-N-alkylureido group, an N'-alkyl-N-arylureido group, an N',N'-dialkyl-N-alkylureido group, an N',N'-dialkyl-N-arylureido group, an N'-aryl-N-alkylureido group, an N'-aryl-N-aryluraido group, an N'N'-diwyl-N-alylureido group, an N',N'-diaryl-N-arylureido group, an N'-alkyl-N'-aryl-N-alkyluceido group, an N'-alkyl-N'-aryl-N-arylureido group, an alkoxycarbanylamino goup, an aryloxycarbonylamino group, an N-alkyl-N-alkoxycarbonylamino group, an N-alkyl-N-aryloxycarbonylamina group, an N-aryl-N-alkoxycarbonylamino group, an N-aryl-N-aryloxycarbonylamino group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-arylcarbamoyl group, an alkylsulfinyl group, an arylsulfinyl group, an alkylsulfonyl group, an arylsulfonyl group, a sulfo group (-SO₃H) and its conjugated base group (hereinafter referred to as a "sulfonato group"), an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, a phosphono group (-PO₃H₂) and its conjugated base group (hereinafter referred to as a "phosphonato group"), a dialkylphosphono group (-PO₃(alkyl)₂), a diarylphosphono group (-PO₃(aryl)₂), an alkylarylphosphono group (-PO₃(alkyl)(aryl)), a monoalkylphosphono group (-PO₃)H(alkyl)) and its conjugated base group (hereinafter refereed to as an "alkylphosphonato group"), a monoarylphosphono group (-PO₃H(aryl)) and its conjugated base group (hereinafter referred to as an "arylphosphonato group"), a phosphonooxy group (-OPO₃H₂) and its conjugated base group (hereinafter referred to as a "phosphonatooxy group"), a dialkylphosphonooxy group (-OPO₃(alkyl)₂), a diarylphosphonooxy group (-OPO₃(aryl)₂), an alkylarylphosphonooxy group (-OPO₃(alkyl)(aryl)), a monoalkylphosphonooxy group (-OPO₃H(alkyl)) and its conjugated base group (hereinafter referred to as an "alkylphosphonatooxy group"), a monoarylphosphonooxy group (-OPO₃H(aryl)) and its conjugated base group (hereinafter referred to as an "arylphosphonatooxy group"), a cyano group, a nitro group, an aryl group, a heteroaryl group, an alkenyl group and an alkynyl group.

In the substituents, specific examples of the alkyl group include those described for the alkyl group above. Specific examples of the aryl group include a phenyl group, a biphenyl group, a naphthyl group, a tolyl group, a xylyl group, a mesityl group, a cumenyl group, a chlorophenyl group, a bromophenyl group, a chloromethylphenyl group, a hydroxyphenyl group, a methoxyphenyl group, an ethoxyphenyl group, a phenoxyphenyl group, an acetoxyphenyl group, a benzoyloxyphenyl group, a methylthiophenyl group, a phenylthiopheenyl group, a methylaminophenyl group, a dimethylaminophenyl group, an acetylaminophenyl group, a carboxyphenyl group, a methoxycarbonylphenyl group, an ethoxycarbonylphenyl group, a phenoxycarbonylphenyl group, an N-phenylcarbamoylphenyl group, a nitrophenyl group, a cyanophenyl group, a sulfophenyl group, a sulfonatophenyl group, a phosphonophenyl group and a phosphonatophenyl group.

Examples of the heteroaryl group include a monocyclic or polycyclic aromatic cyclic group containing at least one of a nitrogen atom, an oxygen atom and a sulfur atom. Examples of especially preferable heteroaryl group include a group derived from a heteroaryl ring, for example, thiophene, thiathrene, furan, pyran, isobenzofuran, chromene, xanthene, phenoxazine, pyrrole, pyrazole, isothiazole, isoxazole, pyrazine, pyrimidine, pyridazine, indolizine, isoindolizine, indole, indazole, purine, quinolizine, isoquinoline, phthalazine, naphthylidine, quinazoline, cinnoline, pteridine, carbazole, carboline, phenanthrene, acridine, perimidine, phenanthroline, phthalazine, phenarsazine, phenoxazine, furazane or phenoxazine. These groups may be benzo-fused or may have a substituent.

Examples of the alkenyl group include a vinyl group, a 1-propenyl group, a 1-butenyl group, a cinnamyl group and a 2-chloro-1-ethenyl group. Examples of the alkynyl group include an ethynyl group, a 1-propynyl group, a 1-butynyl group and a trimethylsilylethynyl group. Examples of G₁ in the acyl group (G₁CO-) include a hydrogen atom and the above-described alkyl group and aryl group. Of the substituents, a halogen atom (for example, -F, -Br, -Cl or -I), an alkoxy group, an aryloxy group, an alkylthio group, an arylthio group, an N-alkylamino group, an N,N-dialkylamino group, an acyloxy group, an N-alkylcarbamoyloxy group, an N-arylcarbamoyloxy group, an acylamino group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N-alkyl-N-arylcarbamoyl group, a sulfo group, a sulfonato group, a sulfamoyl group, an N-alkylsulfmoyl group, an N,N-dialkylsulfamoyl group, an N-arylsulfamoyl group, an N-alkyl-N-arylsulfamoyl group, a phosphono group, a phosphonato group, a dialkylphosphono group, a diarylphosphono group, a monoalkylphosphono group, an alkylphosphonato group, a monoarylphosphono group, an arylphosphonato group, a phosphonooxy group, a phosphonatooxy group, an aryl group and an alkenyl group are more preferable.

On the other hand, as an alkylene group in the substituted alkyl group, a divalent organic residue resulting from elimination of any one of hydrogen atoms on the above-described alkyl group having from 1 to 20 carbon atoms can be enumerated. Examples of preferable alkylene group include a straight chain alkylene group having from 1 to 12 carbon atoms, a branched alkylene group having from 3 to 12 carbon atoms and a cyclic alkylene group having from 5 to 10 carbon atoms.

Specific examples of the preferable substituted alkyl group represented by any one of R₁, R₂ and R₃, which is obtained by combining the above-described substituent with the alkylene group, include a chloromethyl group, a bromomethyl group, a 2-chloroethyl group, a trifluoromethyl group, a methoxymethyl group, a methoxyethoxyethyl group, an allyloxymethyl group, a phenoxymethyl group, a methylthiomethyl group, a tolylthiomethyl group, an ethylaminoethyl group, a diethylaminopropyl group, a morpholinopropyl group, an acetyloxymethyl group, a benzoyloxymethyl group, an N-cyclohexylcarbamoyloxyethyl group, an N-phenylcarbamoyloxyethyl group, an acetylaminoethyl group, an N-methylbenzoylaminopropyl group, a 2-oxoethyl group, a 2-oxopropyl group, a carboxypropyl group, a methoxycarbonylethyl group, an allyloxycarbonylbutyl group, a chlorophenoxycarbonylmethyl group, a carbamoylmethyl group, an N-methylcarbamoylethyl group, an N,N-dipropylcarbamoylmethyl group, an N-(methoxyphenyl)carbamoylethyl group, an N-methyl-N-(sulfophenyl)carbamoylmethyl group, a sulfobutyl group, a sulfonatobutyl group, a sulfamoylbutyl group, an N-ethylsulfamoylmethyl group, an N,N-dipropylsufamoylpropyl group, an N-tolylsulfamoylpropyl group, an N-methyl-N-(phosphonophenyl)sulfamoyloctyl group, a phosphonobutyl group, a phosphonatohexyl group, a diethylphosphonobutyl group, a diphenylphosphonopropyl group, a methylphosphonobutyl group, a methylphosphonatobutyl group, a tolylphosphonohexyl group, a tolylphosphonatohexyl group, a phosphonooxypropyl group, a phosphonatooxybutyl group, a benzyl group, a phenethyl group, an α-methylbenzyl group, a 1-methyl-1-phenylethyl group, a p-methylbenzyl group, a cinnamyl group, an allyl group, a 1-propenylmethyl group, a 2-butenyl group, a 2-methylallyl group, a 2-methylpropenylmethyl group, a 2-propynyl group, a 2-butynyl group and a 3-butynyl group.

Preferable examples of the aryl group represented by any one of R₁, R₂ and R₃ include a fused ring formed from one to three benzene rings and a fused ring formed from a benzene ring and a 5-membered unsaturated ring. Specific examples thereof include a phenyl group, a naphthyl group, an anthryl group, a phenanthryl group, an indenyl group, an acenaphthenyl group and a fluorenyl group. Among them, a phenyl group and a naphthyl group are more preferable.

Specific examples of the preferable substituted aryl group represented by any one of R₁, R₂ and R₃ include aryl groups having a monovalent non-metallic atomic group exclusive of a hydrogen atom as a substituent on the ring-forming carbon atom of the above-described aryl group. Preferable examples of the substituent include the above-described alkyl groups and substituted alkyl groups, and the substituents described for the above-described substituted alkyl group. Specific examples of the preferable substituted aryl group include a biphenyl group, a tolyl group, a xylyl group, a mesityl group, a cumenyl group, a chlorophenyl group, a bromophenyl group, a fluorophenyl group, a chloromethylphenyl group, a trifluoromethylphenyl group, a hydroxyphenyl group, a methoxyphenyl group, a methoxyethoxyphenyl group, an allyloxyphenyl group, a phenoxyphenyl group, a methylthiophenyl group, a tolylthiophenyl group, an ethylaminophenyl group, a diethylaminophenyl group, a morpholinophenyl group, an acetyloxyphenyl group, a benzoyloxyphenyl group, an N-cyclohexylcarbamoyloxyphenyl group, an N-phenylcarbamoyloxyphenyl group, an acetylaminophenyl group, an N-methylbenzoylaminophenyl group, a carboxyphenyl group, a methoxycarbonylphenyl group, an allyloxycarbonylphenyl group, a chlorophenoxycarbonylphenyl group, a carbamoylphenyl group, an N-methylcarbamoylphenyl group, an N,N-dipropylcarbamoylphenyl group, an N-(methoxyphenyl)carbamoylphenyl group, an N-methyl-N-(sulfophenyl)carbamoylphenyl group, a sulfophenyl group, a sulfonatophenyl group, a sulfamoylphenyl group, an N-ethylsulfamoylphenyl group, an N,N-dipropylsulfamoylphenyl group, an N-tolylsulfamoylphenyl group, an N-methyl-N-(phosphonophenyl)sulfamoylphenyl group, a phosphonophenyl group, a phosphonatophenyl group, a diethylphosphonophenyl group, a diphenylphosphonophenyl group, a methylphosphonophenyl group, a methylphosphonatophenyl group, a tolylphosphonophenyl group, a tolylphosphonatophenyl group, an allylphenyl group, a 1-propenylmethylphenyl group, a 2-butenylphenyl group, a 2-methylallylphenyl group, a 2-methylpropenylphenyl group, a 2-propynylphenyl group, a 2-butynylphenyl group and a 3-butynylphenyl group.

Examples of the preferable substituted or unsubstituted alkenyl group and the preferable substituted or unsubstituted aromatic heterocyclic residue represented by any one of R₁, R₂ and R₃ include those described with respect to the alkenyl group and heteroaryl group above, respectively,

Next, A in formula (1) will be described below. A represents an aromatic cyclic group which may have a substituent or heterocyclic group which may have a substituent. Specific examples of the aromatic cyclic group which may have a substituent and heterocyclic group which may have a substituent include those described with respect to the aryl group and heteroaryl group for any one of R₁, R₂ and R₃ in formula (1).

The sensitizing dye represented by formula (1) is obtained by a condensation reaction of the above-described acidic nucleus or an active methylene group-containing acidic nucleus with a substituted or unsubstituted, aromatic ring or hetero ring. Specifically, it can be synthesized with reference to the description of JP-B-59-28329.

Preferable specific examples (D1) to (D42) of the compound represented by formula (1) are set forth below. Further, when isomers with respect to a double bond connecting an acidic nucleus and a basic nucleus are present in each of the compounds, the invention should not be construed as being limited to any one of the isomers.

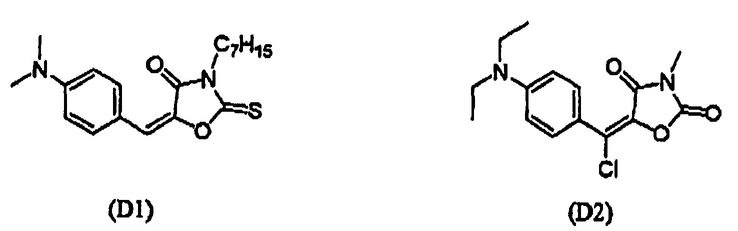

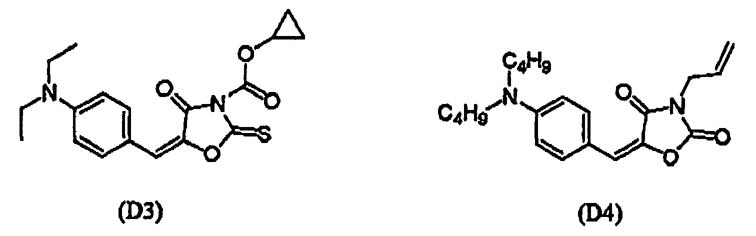

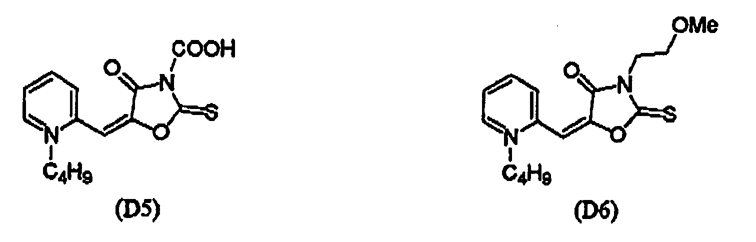

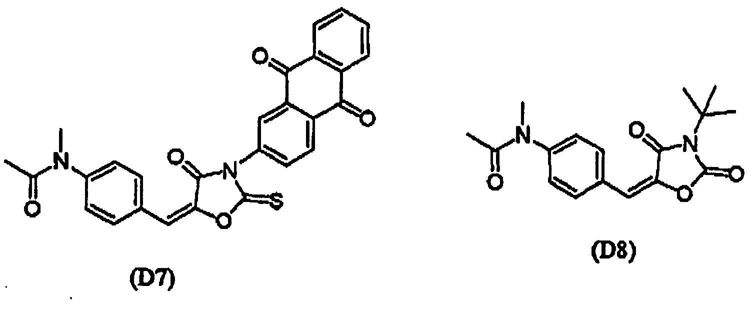

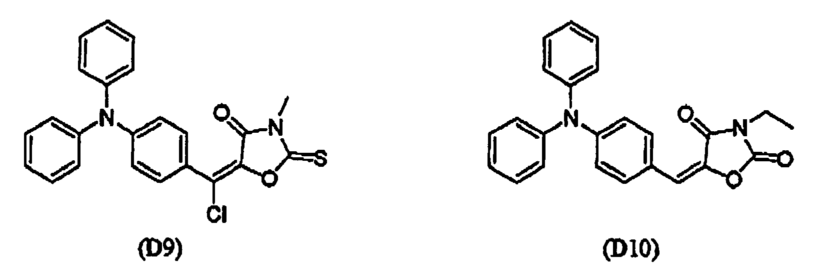

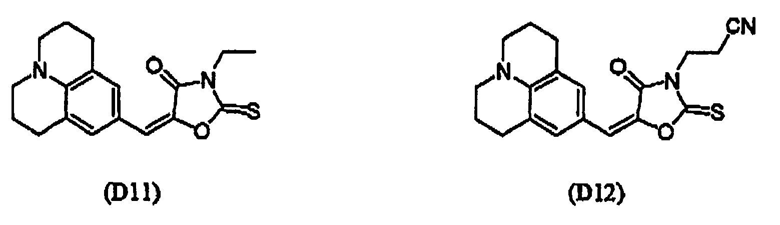

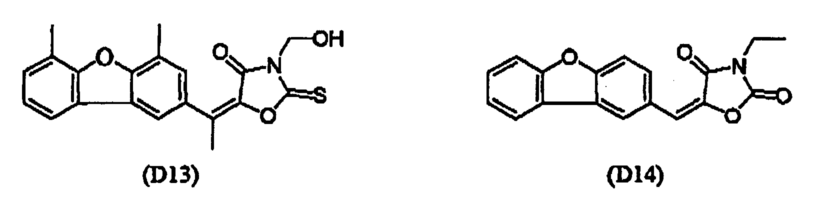

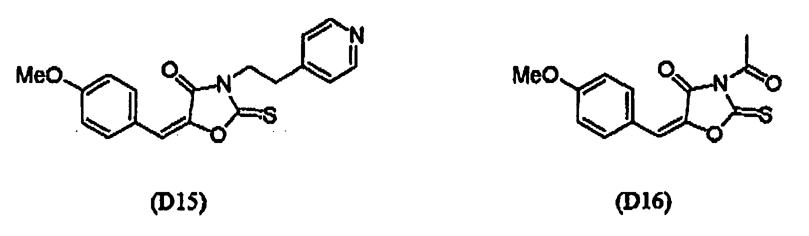

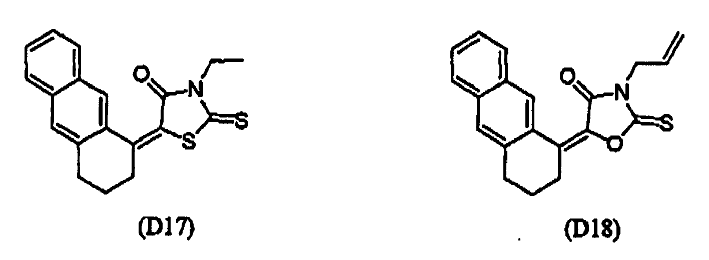

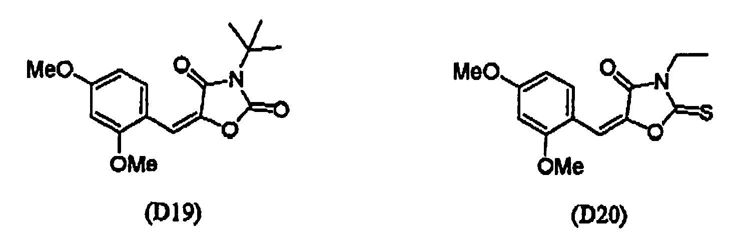

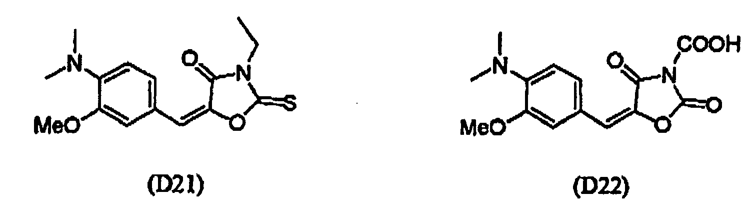

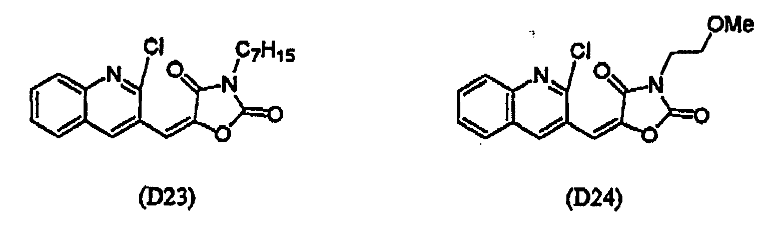

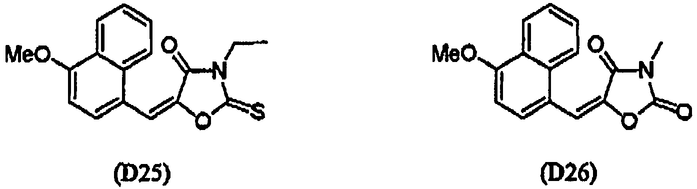

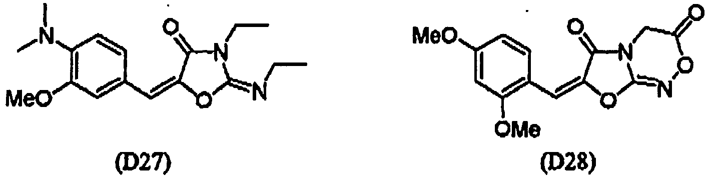

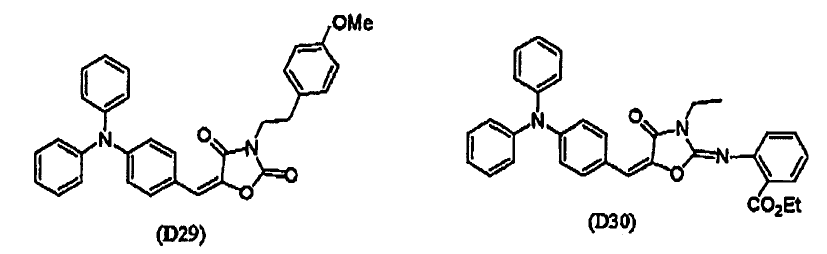

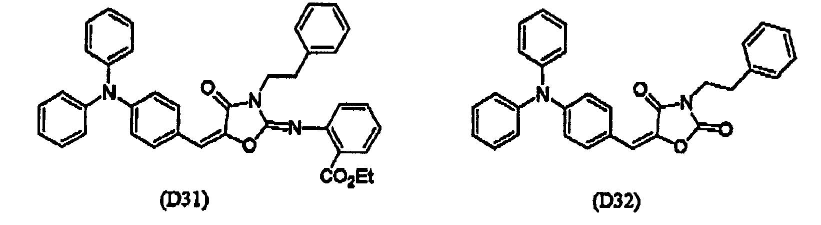

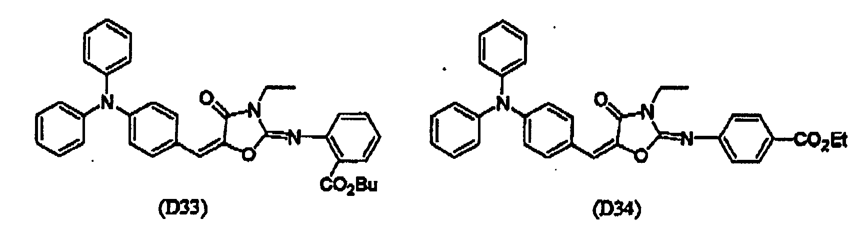

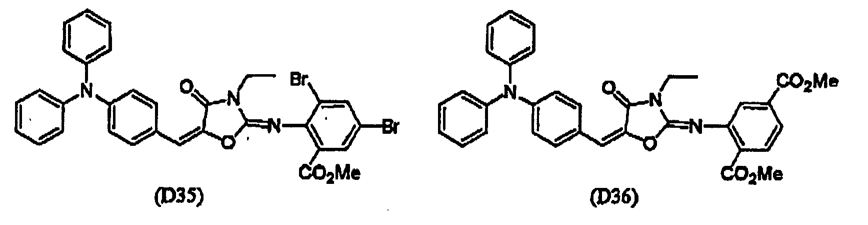

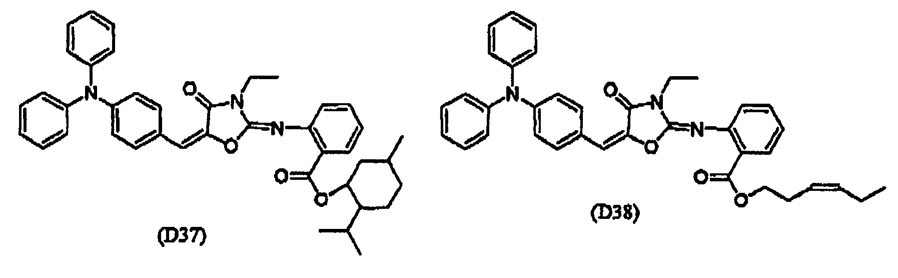

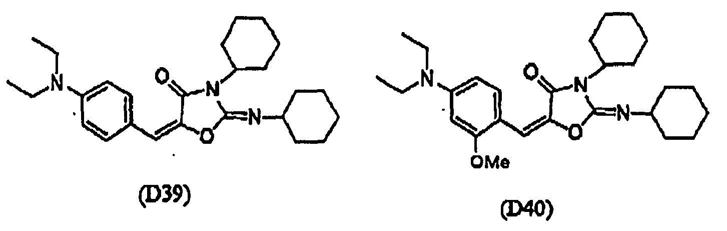

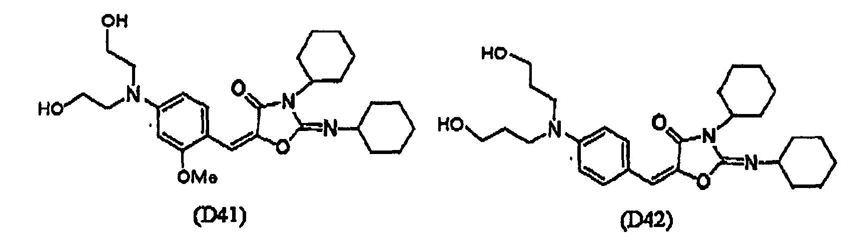

Further, sensitizing dyes having a structure represented by formulae (I) or (II) shown below as described in JP-A-2007-316582 can also be preferably used.

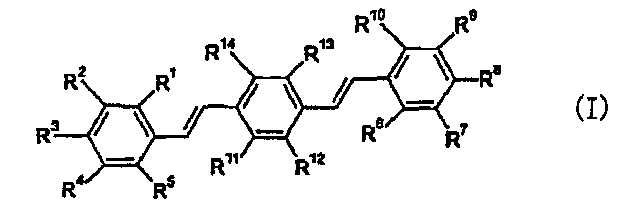

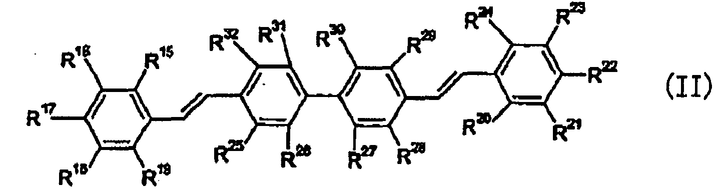

In formulate (I) and (II), R¹ to R¹⁴ each independently represents a hydrogen atom, an alkyl group, an alkoxy group, a cyano group or a halogen atom, provided that at least one of R¹ to R¹⁰ represents an alkoxy group having 2 or more carbon atoms.

R¹⁵ to R³² each independently represents a hydrogen atom, an alkyl group, an alkoxy group, a cyano group or a halogen atom, provided that at least one of R¹⁵ to R²⁴ represents an alkoxy group having 2 or more carbon atoms.

Moreover, sensitizing dyes represented by formula shown below described in JP-A-2007-171406 can also be preferably used.

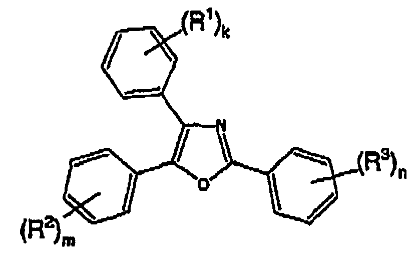

In formula above, R¹, R² and R³ each independently represents a halogen atom, an alkyl group which may have a substituent, an aryl group which may have a substituent, an aralkyl group which may have a substituent, an -NR⁴R⁵ group or an -OR⁶ group, R⁴, R⁵ and R⁶ each independently represents a hydrogen atom, an alkyl group which may have a substituent, an aryl group which may have a substituent or an aralkyl group which may have a substituent, and k, m and n each represents an integer of 0 to 5.

Since the sensitizing dye has a different extinction coefficient depending on the structure thereof, the amount of the sensitizing dye added is varied according to the structure thereof. The amount thereof is suitably an amount in that absorbance of the photosensitive layer at a laser emitting wavelength is 0.6 or less, preferably in a range from 0.05 to 0.55, more preferably in a range from 0.1 to 0.45, and still more preferably in a range form 0.1 to 0.3.

### [polymerization initiator]

The polymerization initiator for use in the invention can be appropriately selected from various kinds of known photopolymerization initiators or combination systems of two or more photopolymerization initiators (photopolymerization initiation system) described in patents and literature. In the invention, the photopolymerization initiator individually used and the combination system of two or more photopolymerization initiators are also collectively referred to as a photopolymerization initiator,

For instance, in case of using light having a wavelength of around 400 nm as the light source, benzyl, benzoyl ether, Michler's ketone, anthraquinone, thioxantone, acridine, phenazine, benzophenone and a hexaarylbisimidazole compound are broadly used.

In case of using visible light having a wavelength of 400 nm or more as the light source, various photopolymerization initiators have also been proposed. For instance, a certain kind of photo-reducing dyes, for example, Rose Bengal, Eosin or erythrosine, described in U.S. Patent 2,850,445, and a combination system comprising a dye and a photopolymerization initiator, for example, a composite initiator system comprising a dye and an amine described in JP-B-44-20189, a combination system of a hexaarylbiimidazole, a radical generator and a dye described in JP-B-45-37377, a combination system of a hexaarylbiimidazole and a p-dialkylaminobenzylidene kotone described in JP-B-47-2528 and JP-A-54-155292, a combination system of a cyclic cis-α-dicarbonyl compound and a dye described in JP-A-48-84183, a combination system of a cyclic triazine and a merocyanine dye described in JP-A-54-151024, a combination system of a 3-ketocoumarin and an activator described in JP-A-52-112681 and JP-A-58-15503, a combination system of a biimidazole, a styrene derivative and a thiol described in JP-A-59-140203, a combination system of an organic peroxide and a dye described in JP-A-59-1504, JP-A-59-140203, JP-A-59-189340, JP-A-62-174203, JP-B-62-1641 and U.S. Patent 4,766,055, a combination system of a dye and an active halogen compound described in JP-A-63-178105, JP-A-63-258903 and JP-A-2-63054, a combination system of a dye and a borate compound described in JP-A-62-143044, JP-A-62-150242, JP-A-64-13140, JP-A-64-13141, JP-A-64-13142, JP-A-64-13143, JP-A-64-13144, JP-A-64-17048, JP-A-1-229003, JP-A-1-298348 and JP-A-1-138204, and a combination system of a dye having a rhodanine ring and a radical generator described in JP-A-2-179643 and JP-A-2-244050 are exemplified. As a preferable photopolymerization initiator, the hexaarylbisimidazole compound is exemplified.

As the hexaarylbisimidazole compound, various compounds described, for example, in European Patents 24,629 and 107,792, U.S. Patent 4,410,621, European Patent 215,453 and German Patent 3,211,312 can be used. Preferable examples of the hexaarylbisimidazole compound include 2,4,5,2',4',5'-hexaphenylbisimidazole, 2,2'-bis(2-chlorophenyl)-4,5, 4',5'-tetraphenylbisimidazole, 2,2'-bis(2-bromophenyl)-4, 5, 4',5'-tetraphenylbisimidazole, 2,2'-bis(2,4-dihlorophenyl)-4,4',5,5'-tetraphenylbisimidazole, 2,2'-bis(2-chlorophenyl)-4,5,4',5'-tetrakis(3-methoxyphenyl)bisimidazole, 2,5,2',5'-tetrakis(2-chlorophenyl)-4,4'-bis(3,4-dimethoxyphenyl)bisimidazole, 2,2'-bis(2,6-dichlorophenyl)-4,5,4',5'-tetraphenylbisimidazole, 2,2'-bis(2-nitrophenyl)-4,5,4',5'-tetraphenylbisimidazole, 2,2'-di-o-tolyl-4,5,4',5'-tetraphenylbisimidazole, 2,2'-bis(2-ethoxyphenyl)-4,5,4',5'-tetraphenylbisimidazole and 2,2'-bis(2,6-difluorophenyl)-4,5,4',5'-tetraphenylbisimidazole. The hexaarylbisimidazole compounds may be used as a mixture of two or more thereof.

The amount of the hexaarylbisimidazole compound used is ordinarily in a range from 0.05 to 50 parts by weight, preferably from 0.2 to 30 parts by weight, based on 100 parts by weight of the total amount of the addition polymerizable compound described hereinafter. Other phatopolymerization initiator may be used together with the hexaarylbisimidazole compound.

It is known that a photo-initiation ability is further enhanced by using the photopolymerization initiator together with a hydrogen donating compound, for example, a thiol compound (e.g., 2-mercaptobenzothiazole, 2-mercaptobenzimidazole or 2-mercaptobenzoxazole) or an amine compound (e.g., N-phenylglycine or N,N-dialkylamino aromatic alkyl ester), if desired. As the hydrogen donating compound having a particularly, high photo-initiation ability suitable for the invention, a mercapto group-containing compound is exemplified. Particularly, a combination of the mercapto group-containing compound with the hexaarylbisimidazole compound is effective.

More preferable examples of the hydrogen donating compound include sulfur-containing compounds (mercapto group-containing heterocyclic compounds) represented by formula (2) or (3) shown below. In formulae (2) and (3), the structures of tautomers are indicated respectively.

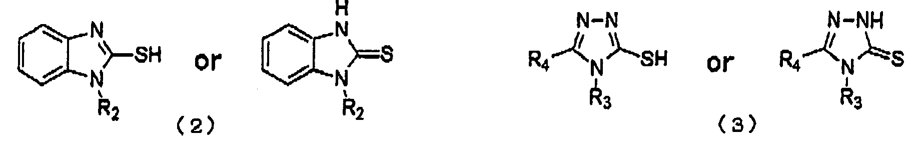

In formulae (2) and (3), R₂, R₃ and R₄, each independently represents a hydrogen atom, a substituted or unsubstituted, straight-chain or branched alkyl group having from 1 to 18 carbon atoms, a substituted or unsubstituted cyclic alkyl group having from 5 to 20 carbon atoms or an aromatic group. Examples of the substituent include a halogen atom, a hydroxy group, an amino group, a thiol group, an acetyl group and a carboxyl group.

Preferable specific examples (SH1) to (SH20) of the compound represented by formula (2) or (3) are set forth below, but the invention should not be construed as being limited thereto. The structures shown below are indicated by the -SH group-containing structure of the tautomers.

Specific examples of the compound represented by formula (2):

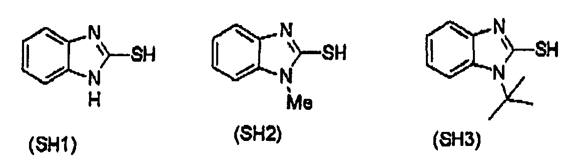

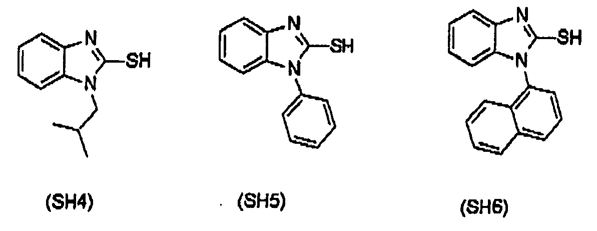

Specific example of the compound represented by formula (3):

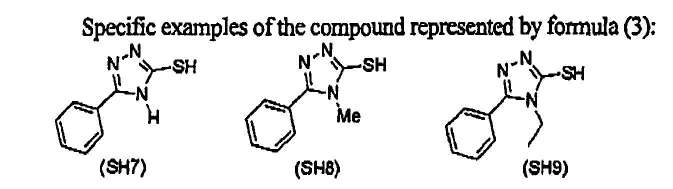

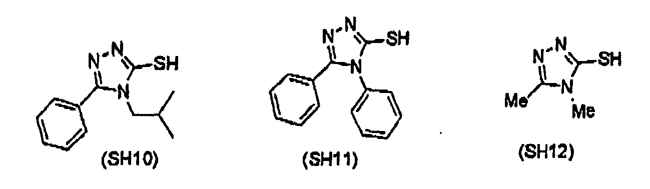

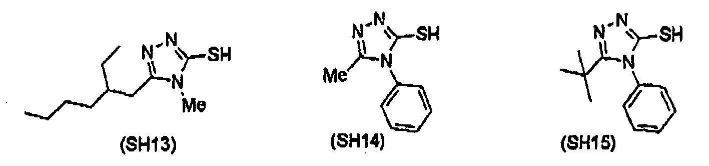

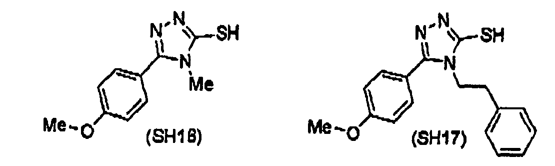

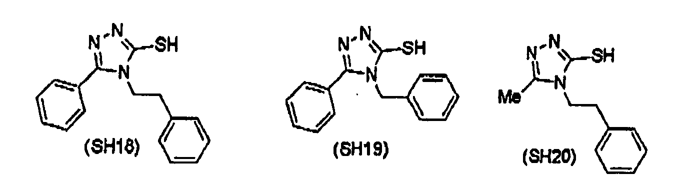

The mercapto group-containing heterocyclic compound is used preferably at a ratio of 0.2 to 10.0 moles, more preferably at a ratio of 0.5 to 6.0 moles, still more preferably at a ratio of 0.5 to 4.0 moles, per mole of the hexaarylbisimidazole compound.

### [Addition polymerizable compound having ethylenically unsaturated double bond]

The addition polymerizable compound having an ethylenically unsaturated double bond for use in the invention can be appropriately selected from compounds having at least one, preferably two or more ethylenically unsaturated double bond groups. The compound has a chemical form, for example, a monomer, a prepolymer, specifically, a dimmer, a trimer or an oligomer, a copolymers thereof or a mixture thereof Examples of the monomer include an ester between an unsaturated carboxylic acid (for example, acrylic acid, methacrylic acid, itaconic acid, crotonic acid, isocrotonic acid or maleic acid) and an aliphatic polyhydric alcohol compound and an amide between an unsaturated carboxylic acid and an aliphatic polyvalent amine compound.

Specific examples of the monomer of the ester between an aliphatic polyhydric alcohol compound and an unsaturated carboxylic acid include as an acrylate, for example, ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol pentaacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate and polyester acrylate oligomer.

As a methacrylate, for example, tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, dipentaerythritol pentamethacrylate, sorbitol trimethacrylate, sorbitol tetramethacrylate, bis[p-(3-methacryloxy-2 hydroxpropoxy)phenyl]dimethylmethane and bis-[p-(methacryloxyethoxy)phenyl]dimethylmethane are exemplified.

As an itaconate, for example, ethylene glydcol diitaconate, propylene glycol diitaconate, 1,3-butanediol diitaconate, 1,4-butanediol diitaconate, tetramethylene glycol diitaconate, pentaerythritol diitaconate and sorbitol tetraitaconate are exemplified.

As a crotonatate, for example, ethylene glycol dicrotonate, tetramethylene glycol dicrotonate, pentaerythritol dicrotonate and sorbitol tetracrotonate are exemplified.

As an isocrotonate, for example, ethylene glycol diisocrotonate, pentaerythritol diisocrotonate and sorbitol tetraisocrotonate are exemplified.

As a maleate, for example, ethylene glycol dimaleate, triethylene glycol dimaleate, pentaerythritol dimaleate or sorbitol tetramaleate are exemplified.

Also, specific examples of the monomer of the amide between an aliphatic polyvalent amine compound and an unsaturated carboxylic acid include methylenebisacrylamide, methylenebismethacrylamide, 1,6-hexamethylenebisacrylamide, 1,6-hexamethylenebismethacrylamide, diethylenetriaminetrisacrylamide, xylylenebisacrylamide and xylylenebismethacrylamide.

Also, urethane (meth)acrylates as described in JP-A-51-37193, polyester acrylates as described in JP-A-48-64183, JP-B-49-43191 and JP-B-52-30490, and polyfunctional acrylates or methacrylates, for example, epoxy acrylates obtained by reacting an epoxy resin with (meth)acrylic acid are exemplified. Further, photo-curable monomers and oligomers described in Nippon Secchaku Kyokaishi (Journal of Japan Adhesion Society), Vol. 20, No. 7, pages 300 to 308 (1984) can also be used.

Specific examples of the urethane (meth)acrylate include NK OLIGO U-4HA, NK OLIGO U-4H, NK OLIGO U-6HA, NK OLIGO U-6ELH, NK OLIGO U-108A, NK OLIGO U-1084A, NK OLIGO U-200AX, NK OLIGO U-122A, NK OLIGO U-340A, NK OLIGO UA-324A and NK OLIGO UA-100 (produced by Shin-Nakamura Chemical Co., Ltd.), UA-306H, AI-600, UA-101T, UA-101I, UA-306T and UA-306I (produced by Kyoeisha Chemical Co., Ltd.), ART RESIN UN-9200A, ART RESIN UN-3320HA, ART RESIN UN-3320HB, ART RESIN UN-3320HC, ART RESIN SH-380G, ART RESIN SH-500 and ART RESIN SH-9832 (produced by Negami Chemical Industrial Co., Ltd.) and PLEX 6661-0 (produced by Degussa AG, Germany).

The amount of the addition polymerizable compound having an ethylenically unsaturated double bond used is preferably in a range of 5 to 90% by weight, more preferably in a range of 20 to 75% by weight, based on the total solid content of the photosensitive layer.

### [Binder polymer]

The binder polymer for use in the invention has an acid group, and an organic polymer having a carboxylic acid is preferable. Examples of such an organic polymer include addition polymers having a carboxylic acid group in their side chains, for example, polymers described in JP-A-59-44615, JP-B-54-34327, JP-B-58-12577, JP-B-54-25957, JP-A-54-92723, JP-A-59-53836 and JP-A-59-71048, specifically, methacrylic acid copolymers, acrylic acid copolymers, itaconic acid copolymers, crotonic acid copolymers, maleic acid copolymers and partially esterified maleic acid copolymers.

Also, an acidic cellulose derivative having a carboxylic acid group in its side chain and a product obtained by adding a cyclic acid anhydride to an addition polymer having a hydroxy group are exemplified.

Further, polyurethane resins described in JP-B-7-120040, JP-B-7-120041, JP-B-7-120042, JP-B-8-12424, JP-A-63-287944, JP-A-63-287947, JP-A-1-271741 and JP-A-11-352691 are also useful as a binder polymer soluble or swellable in an aqueous weak alkali solution.

As the binder polymer, an acrylic resin, a methacrylic resin or a urethane resin is preferably used.

One preferable example of the binder polymer for use in the invention is a copolymer having (a) a repeating unit containing a carboxylic acid and (b) a repeating unit imparting a radical crosslinking property.

Specific examples of the repeating unit (a) containing a carboxylic acid (hereinafter, also referred to as repeating unit (a)) include the structures represented by (a-1) to (a-13) set forth below, but the invention should not be construed as being limited thereto.

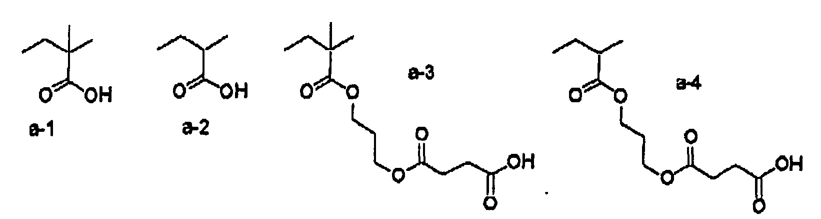

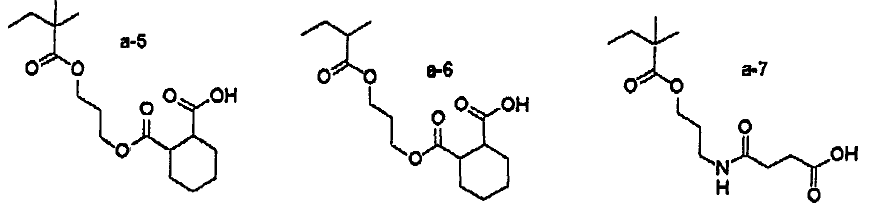

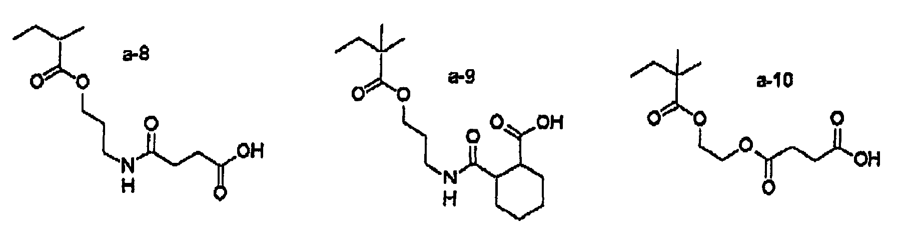

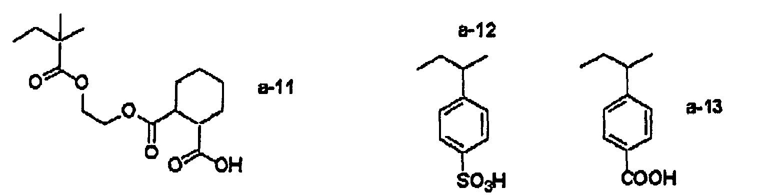

The content of the repeating unit (a) is ordinarily from 5 to 50, preferably from 5 to 25, more preferably from 5 to 15, taking the number of the total repeating units as 100.

Specific examples of the repeating unit (b) imparting a radical crosslinking property (hereinafter, also referred to as repeating unit (b)) include the structures represented by (b-1) to (b-11) set forth below, but the invention should not be construed as being limited thereto.

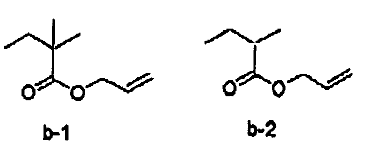

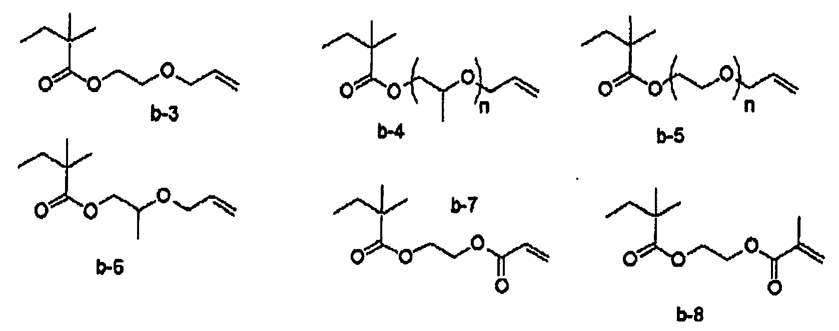

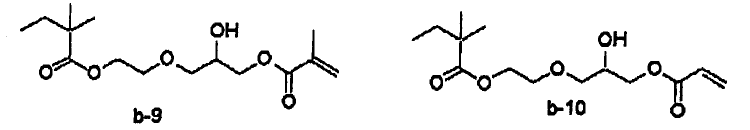

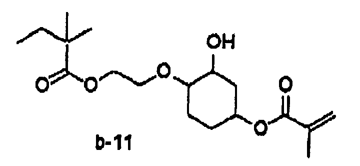

The content of the repeating unit (b) is ordinarily from 5 to 90, preferably from 20 to 85, more preferably from 40 to 80, taking the number of the total repeating units as 100.

The binder polymer for use in the invention may have a repeating unit (hereinafter, also referred to as repeating unit (1)) represented by formula (1) shown below.

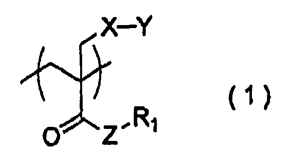

In formula (1), X represents an oxygen atom, a sulfur atom or a -NH- group, Y represents a hydrogen atom, an alkyl group having from 1 to 12 carbon atoms, a cyclic alkyl group having from 5 to 12 carbon atoms or a group including an aromatic ring having from 6 to 20 carbon atoms, Z represents an oxygen atom, a sulfur atom or a -NH- group, and R₁ represents an alkyl group having from 1 to 18 carbon atoms, an alkyl group including an alicyclic structure having from 5 to 20 carbon atoms or a group containing an aromatic ring having from 6 to 20 carbon atoms.

Specific examples of the repeating unit (I) include the structures represented by (1-1) to (1-9) set forth below, but the invention should not be construed as being limited thereto.

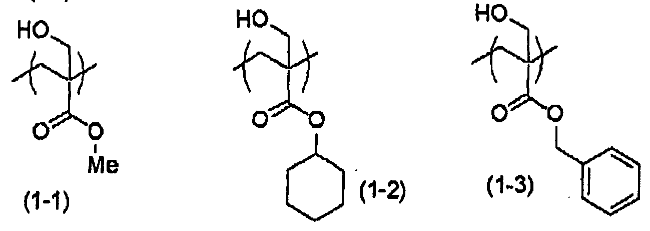

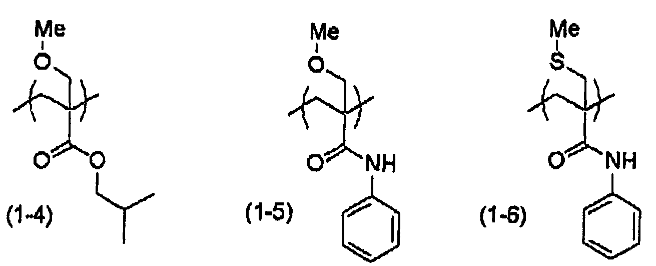

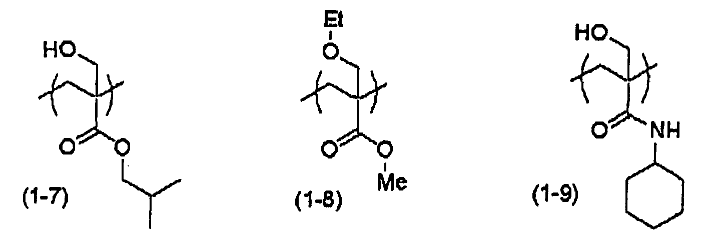

The content of the repeating unit (1) is ordinarily from 1 to 40, preferably from 3 to 25, more preferably from 5 to 15, taking the number of the total repeating units as 100.

Specific examples of preferable combination of the repeating units (a), (b) and (I) include Combinations (PP-1) to (PP-11) shown in Table 1 below, but the invention should not be construed as being limited thereto. As for the acid value of the acrylic resin, the content of carboxylic group is ordinarily from 0.2 to 4.0 meq/g, preferably from 0.3 to 3.0 meq/g, more preferably from 0.4 to 2.0 meq/g, particularly preferably from 0.5 to 1.5 meq/g, and most preferably from 0.6 to 1.2 meq/g.

**TABLE 1**

| No. | Repeating Unit (1) | Repeating Unit (a) | Repeating Unit (b) |
|---|---|---|---|
| PP-1 | 1-3 | a-1 | b-1 |
| PP-2 | 1-3 | a-1 | b-8 |
| PP-3 | 1-2 | a-1 | b-1 |
| PP-4 | 1-2 | a-1 | b-8 |
| PP-5 | 1-2 | a-1 | b-11 |
| PP-6 | 1-9 | a-5 | b-1 |
| PP-7 | 1-5 | a-3 | b-1 |
| PP-8 | 1-5 | a-3 | b-8 |
| PP-9 | 1-1 | a-3 | b-1 |
| PP-10 | 1-1 | a-5 | b-8 |
| PP-11 | 1-9 | a-3 | b-1 |

Example of copolymerization molar ratio of repeating units (a), (b) and (1) is 14/76/10.

It is preferred that a urethane resin used as the binder polymer in the invention contains a crosslinkable group. The term "crosslinkable group" as used herein means a group capable of crosslinking the binder polymer in the process of a radical polymerization reaction which is caused in the image-recording layer, when the lithographic printing plate precursor is exposed to light. The crosslinkable group is not particularly restricted as long as it has such a function and includes, for example, an ethylenically unsaturated bonding group, an amino group or an epoxy group as a functional group capable of undergoing an addition polymerization reaction. Also, a functional group capable of forming a radical upon irradiation with light may be used and such a crosslinkable group includes, for example, a thiol group, a halogen atom and an onium salt structure. Among them, the ethylenically unsaturated bonding group is preferable, and functional groups represented by formulae (1A) to (3A) shown below are particularly preferable.

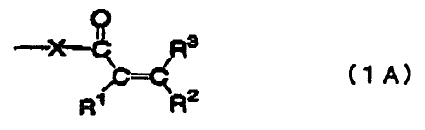

In formula (1A), R¹ to R³ each independently represents a hydrogen atom or a monovalent organic group. R¹ preferably includes, for example, a hydrogen atom or an alkyl group which may have a substituent. Among them, a hydrogen atom or a methyl group is preferable because of high radical reactivity.

R² and R³ each independently preferably includes, for example, a hydrogen atom, a halogen atom, an amino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent an alkylamino group which may have a substituent, an arylamino group which may have a substituent, an alkylsulfonyl group which may have a substituent and an arylsulfonyl group which may have a substituent. Among them, a hydrogen atom, a carboxyl group, an alkoxycarbonyl group, an alkyl group which may have a substituent or an aryl group which may have a substituent is preferable because of high radical reactivity.

X represents an oxygen atom, a sulfur atom or -N(R¹²)-, and R¹² represents a hydrogen atom or a monovalent organic group. The monovalent organic group represented by R¹² includes, for example, an alkyl group which may have a substituent. Among them, R¹² is preferably a hydrogen atom, a methyl group, an ethyl group or an isopropyl group because of high radical reactivity.

Examples of the substituent which can be introduced include an alkyl group, an alkenyl group, an alkynyl group, an aryl group, an alkoxy group, an aryloxy group, a halogen atom, an amino group, an alkylamino group, an arylamino group, a carboxyl group, an alkoxycarbonyl group, a sulfo group, a nitro group, a cyano group, an amido group, an alkylsulfonyl group and an arylsulfonyl group.

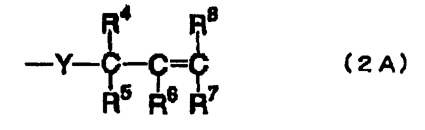

In formula (2A), R⁴ to R⁸ each independently represents a hydrogen atom or a monovalent organic group, R⁴ to R⁸ each independently preferably includes, for example, a hydrogen atom, a halogen atom, an amino group, a dialkylamino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent and an arylsulfonyl group which may have a substituent. Among them, a hydrogen atom, a carboxyl group, an alkoxycarbonyl group, an alkyl group which may have a substituent or an aryl group which may have a substituent is preferable.

Examples of the substituent which can be introduced include those described in formula (1A). Y represents an oxygen atom, a sulfur atom or -N(R¹²)-, and R¹² has the same meaning as R¹² defined in formula (1A). Preferable examples for R¹² are also same as those described in formula (1A).

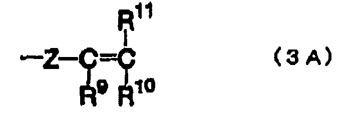

In formula (3A), R⁹ to R¹¹ each independently represents a hydrogen atom or a monovalent organic group. R⁹ is preferably a hydrogen atom or an alkyl group which may have a substituent. Among them, a hydrogen atom or a methyl group is preferable because of high radical reactivity. R¹⁰ and R¹¹ each independently represents, for example, a hydrogen atom, a halogen atom, an amino group, a dialkylamino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent and an arylsulfonyl group which may have a substituent. Among them, a hydrogen atom, a carboxyl group, an alkoxycarbonyl group, an alkyl group which may have a substituent or an aryl group which may have a substituent is preferable because of high radical reactivity.

Examples of the substituent introduced include those described in Formula (1A). Z represents an oxygen atom, a sulfur atom, -N(R¹²)- or a phenylene group which may have a substituent. R¹² has the same meaning as R¹² defined in formula (1A). Preferable examples for R¹² are also same as those described in formula (1A).

The polyurethane resin for use in the invention preferably contains in its side chain an aqueous week alkali-soluble group, for example, a carboxyl group as well as the crosslinkable group. The polyurethane resin is preferable in view of satisfying both good stain resistance and high printing durability because the development damage in the exposed area can be prevented without accompanying with deterioration of the developing property in the unexposed area, even when the acid value of the image-recording layer is low.

The polyurethane resin preferably used in the invention is a resin obtained by a polyaddition reaction of (i) a diisocyanate compound, (ii) a diol compound having a carboxyl group, (iii) a diisocyanate compound having a crosslinkable group and, if desired, (iv) a diol compound containing no carboxyl group.

The diisocyanate compound and diol compound which are starting materials of the polyurethane resin will be described in more detail below.

### (i) Diisocyanate compound

Examples of the diisocyanate compound include diisocyanate compounds represented by the following formula (4):

OCN-L-NCO (4)

In formula (4), L represents a single bond or a divalent aliphatic or aromatic hydrocarbon group which may have a substituent. If desired, L may contain other functional group which does not react with the isocyanate group, for example, a carbonyl group, an ester group, a urethane group, an amido group or a ureido group. More specifically, L represents a single bond or a divalent aliphatic or aromatic hydrocarbon group which may have a substituent (preferably, for example, an alkyl group, an aralkyl group, an aryl group, an alkoxy group or a halogen atom), preferably an alkylene group having from 1 to 20 carbon atoms or an arylene group having from 6 to 15 carbon atoms, more preferably an alkylene group having from I to 8 carbon atoms. Also, if desired, L may contain other functional group which does not react with the isocyanate group, for example, a carbonyl group, an ester group, a urethane group, an amido group, a ureido group or an ether group.

Specific examples of the diisocyanate compound represented by formula (4) include the following compounds. Specifically, an aromatic diisocyanate compound, for example, 2,4-tolylene diisocyanate, dimer of 2,4-tolylene diisocyanate, 2,6-tolylene diisocyanate, p-xylylene diisocyante, m-xylylene diisocyanate, 4,4'-diphenylmethane diisocyanate, 1,5-naphthalene diisocyanate or 3,3'-dimethylbiphenyl-4,4'-diisocyanate; an aliphatic diisocyanate compound, for example, hexamethylene diisocyanate, trimethylhexamethylene diisocyanate, lysine diisocyanate or dimeric acid diisocyanate; an alicyclic diisocyanate compound, for example, isophorone diisocyanate, 4,4'-methylenebis(cyclohexyl isocyanate), methylcyclohexane-2,4(or 2,6)-diisocyanate or 1,3-(isocyanatomethyl)cyclohexane; and a diisocyanate compound obtained by a reaction of diol with diisocyanate, for example, an adduct of 1 mole of 1,3-butylene glycol with 2 moles of tolylene diisocyanate are exemplified.

The diisocyanate compounds may be used individually or in combination of two or more thereof In view of the balance between printing durability and stain resistance, it is preferred to use two or more of the diisocyanate compounds in combination, and it is particularly preferred to use at least one of the aromatic diisocyanate compounds (L represents an aromatic group) and at least one of the aliphatic diisocyanate compounds (L represents an aliphatic group).

With respect to the amount of the diisocyanate compound used, a molar ration of the diisocyanate compound to the diol compound is preferably from 0.8 to 1.2, more preferably from 0.9 to 1.1. In the case where an isocyanate group remains at a polymer terminal because of using an excess amount of the diisocyanate compound to the diol compound, it is preferred to treat the compound after the urethanization reaction with an alcohol or an amine to finally synthesize a compound having no residual isocyanate group at the terminal.

### (ii) Diol compound having at least one carboxyl group

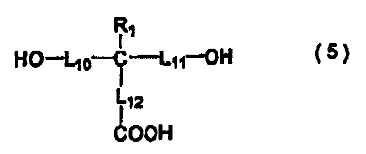

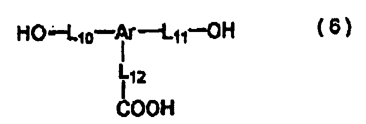

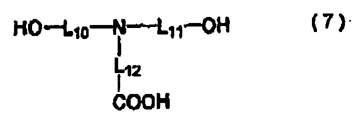

The diol compound having at least one carboxyl group includes diol compounds represented by formulae (5), (6) and (7) shown below and/or a compound obtained by ring opening of a tetracarboxylic acid dianhydride with a diol compound. The diol compound used for the purpose of ring opening of the tetracarboxylic acid dianhydride can be used.

In formulae (5) to (7), R₁ represents a hydrogen atom, an alkyl group, an aralkyl group, an aryl group, an alkoxy group or an aryloxy group, each of which may have a substituent (for example, a cyano group, a nitro group, a halogen atom (e.g., -F, -Cl, -Br or -I), -CONH₂, -COOR₁₁₃, -OR₁₁₃, -NHCONHR₁₁₃, -NHCOOR₁₁₃, -NHCOR₁₁₃ or -OCONHR₁₁₃ (wherein R₁₁₃ represents an alkyl group having from I to 10 carbon atoms or an aralkyl group having from 7 to 15 carbon atoms)), preferably a hydrogen atom, an alkyl group having from 1 to 8 carbon atoms or an aryl group having from 6 to 15 carbon atoms. L₁₀, L₁₁ and L₁₂, which may be the same or different, each represents a single bond or a divalent aliphatic or aromatic hydrocarbon group which may have a substituent (preferably, for example, an alkyl group, an aralkyl group, an aryl group, an alkoxy group or a halogen atom), preferably an alkylene group having from 1 to 20 carbon atoms or an arylene group having from 6 to 15 carbon atoms, more preferably an alkylene group having from 1 to 8 carbon atoms. Also, if desired, L₁₀, L₁₁ and L₁₂ each may contain other functional group which does not react with the isocyanate group, for example, a carbonyl group, an ester group, a urethane group, an amido group, a ureido group or an ether group. Further, two or three of R₁, L₁₀, L₁₁ and L₁₂ may be taken together to form a ring. Ar represents a trivalent aromatic hydrocarbon group which may have substituent, preferably an aromatic group having from 6 to 15 carbon atoms.

Specific examples of the diol compound having a carboxyl group represented by formula (5), (6) or (7) include the following compounds.

Specifically, 3,5-dihydroxybenzoic acid, 2,2-bis(hydroxymethyl)propionic acid, 2,2-bis(2-hydroxyethyl)propionic acid, 2,2-bis(3-hydroxypropyl)propionic acid, bis(hydroxymethyl) acetic acid, bis(4-hydroxyphenyl)acetic acid, 2,2-bis(hydroxymethyl)butyric acid, 4,4-bis(4-hydroxyphenyl)pentanoic acid, tartaric acid, N,N-dihydroxyethylglycine and NN-bis(2-hydroxyethyl)-3-carboxypropionamide are exemplified.

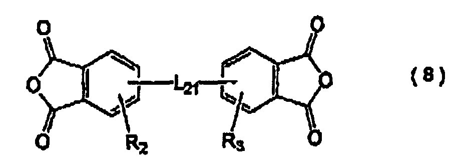

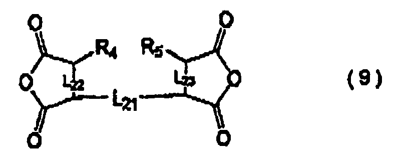

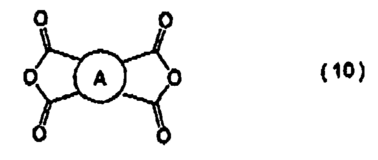

Preferable examples of the tetracarboxylic acid dihydrate, which is used in the preparation of the diol compound having at least one carboxy group, include compounds represented by formulae (8), (9) and (10) shown below.

In formulae (8) to (10), L₂₁ represents a single bond, a divalent aliphatic or aromatic hydrocarbon group which may have a substituent (preferably, for example, an alkyl group, an aralkyl group, an aryl group, an alkoxy group, a halogen atom, an ester group or an amido group), -CO-, -SO-, -SO₂-, -O- or -S-, preferably a single bond, a divalent aliphatic hydrocarbon group having from I to 15 carbon atoms, -CO-, -SO₂-, -O- or -S-. R₂ and R₃, which may be the same or different, each represents a hydrogen atom, an alkyl group, an aralkyl group, an aryl group, an alkoxy group or a halogen atom, preferably a hydrogen atom, an alkyl group having from 1 to 8 carbon atoms, an aryl group having from 6 to 15 carbon atoms, an alkoxy group having from 1 to 8 carbon atoms or a halogen atom. Alternatively, two of L₂₁, R₂ and R₃ may be combined with each other to form a ring. R₄ and R₅, which may be the same or different, each represents a hydrogen atom, an alkyl group, an aralkyl group, an aryl group or a halogen atom, preferably a hydrogen atom, an alkyl group having from 1 to 8 carbon atoms or an aryl group having from 6 to 15 carbon atoms. Alternatively, two of L₂₁, R₄ and R₅ may be combined with each other to form a ring. L₂₂ and L₂₃, which may be the same or different, each represents a single bond, a double bond or a divalent aliphatic hydrocarbon group, preferably a single bond, a double bond or a methylene group. A represents a monocyclic or polycyclic aromatic ring, preferably an aromatic ring having from 6 to 18 carbon atoms.

Specific examples of the compound represented by formula (8), (9) or (10) include the following compounds.

Specifically, an aromatic tetracarboxylic acid dihydride, for example, pyromellitic acid dihydride, 3,3',4,4'-benzophenonetetracarboxylic acid dihydride, 3,3',4,4'-diphenyltetracarboxylic acid dihydride, 2,3,6,7-naphthalenetetracarboxylic acid dihydride, 1,4,5,8-naphthalenetetcacarboxylic acid dihydride, 4,4'-sulfonyldiphthalic acid dihydride, 2,2-bis(3,4-dicarboxyphenyl)propane dihydride, bis(3,4-dicarboxyphenyl)ether dihydride, 4,4'-[3,3'-(alkylphosphoryldiphenylene)-bis(iminocarbonyl)]diphthalic acid dihydride, adduct of hydroquinonediacetate and trimellitic acid anhydride or adduct of diacetyldiamine and trimellitic acid anhydride; an alicyclic tetracarboxylic acid dihydride, for example, 5-(2,5-dioxotetrahydrofuryl)-3-methyl-3-cyclohexene-1,2-dicarboxytic acid dihydride (Epicron B-4400, produced by Dainippon Ink & Chemicals, Inc.), 1 ,13,4-cyclopentanetetracarboxylic acid dihydride, 1,2,4,5-cyclohexanetetracarboxylic acid dihydride or tetrahydrofurantetracarboxylic acid dihydride; and an aliphatic tetracarboxylic acid dihydride, for example, 1,2,3,4-butanetetracarboxylic acid dihydride or 1,2,4,5-pentanetetracarboxylic acid dihydride are exemplified.

By ring-opening of the tetracarboxylic acid dianhydride with a diol compound, (ii) the diol compound having at least one carboxyl group can be synthesized. It is also possible that a reaction between the diol compound and (i) the diisocyanate compound is initially conducted and the resulting reaction product is reacted with the tetracarboxylic acid dianhydride to synthesize the polyurethane resin according to the invention. This method is also included in the concept of the invention. Specifically, the method of introducing a structural unit resulting from the tetracarboxylic acid dianhydride and the diol compound into the polyurethane resin includes the following methods:
a) Method wherein an alcohol-terminated compound obtained by ring-opening of the tetracarboxylic acid dianhydride with a diol compound is reacted with the diisocyanate compound and
b) Method wherein an alcohol-terminated urethane compound obtained by reacting the diisocyanate compound under excess of the diol compound is reacted with the tetracarboxylic acid dianhydride.

Of the diol compounds having at least one carboxyl group, the compounds represented by formula (5) are more preferable because of high solvent solubility and ease of synthesis. The diol compound having at least one carboxyl group is introduced into the polyurethane resin binder in an amount so that the polyurethane resin binder contains ordinarily from 0.2 to 4.0 meq/g, preferably from 0.3 to 3.0 meq/g, more preferably from 0.4 to 2.0 meq/g, particularly preferably from 0.5 to 1.5 meq/g, most preferably from 0.6 to 1.2 meq/g, of the carboxyl group. Therefore, although the content of the structure derived from the diol compound having at least one carboxylic group in the polyurethane resin binder can be appropriately determined after considering a number of the carboxyl group in the diol compound, other diol compound used in combination, an acid value or a molecular weight of the resulting polyurethane resin binder, a composition or pH of developer and the like, it is, for example, ordinarily from 5 to 45% by mole, preferably from 10 to 40% by mole, more preferably from 15 to 35% by mole.

### (iii) Diisocyanate compound having crosslinkable group

The diisocyanate compound having a crosslinkable group includes, for example, a reaction product obtained by an addition reaction of a triisocyanate compound with one equivalent of a monofunctional alcohol or monofunctional amine compound having a crosslinkable group.

Examples of the triisocyanate compound are set forth below, but the invention should not be construed as being limited thereto.

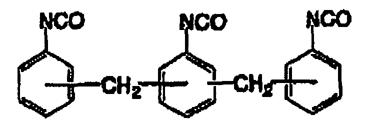

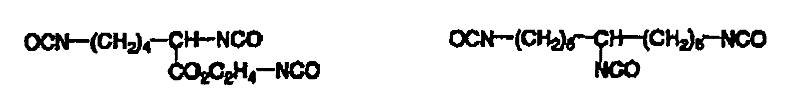

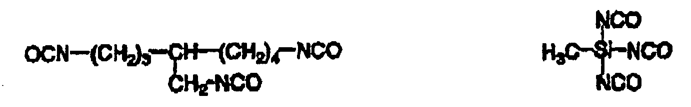

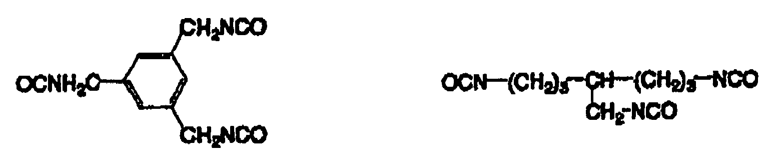

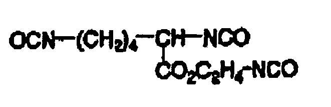

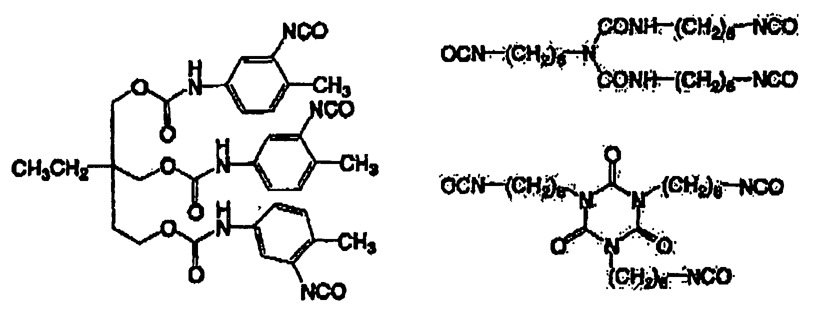

Examples of the monofunctional alcohol or monofunctional amine compound having a crosslinkable group are set forth below, but the invention should not be construed as being limited thereto. 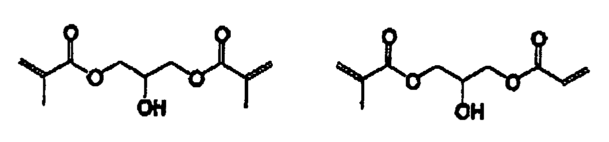 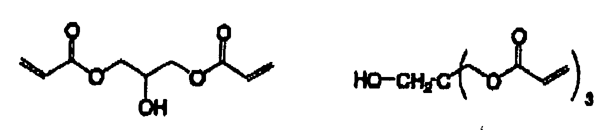 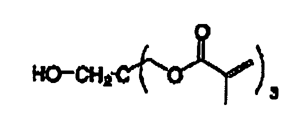 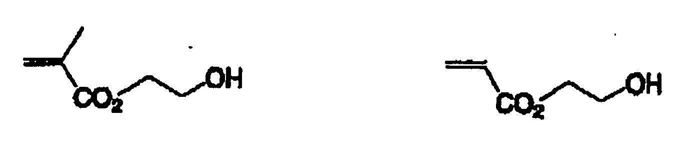 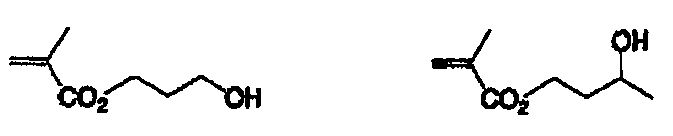 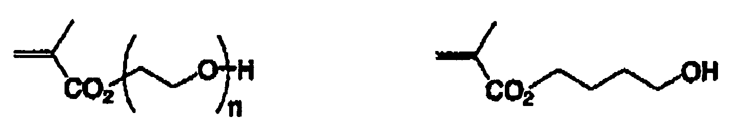 n is an integer of 2 to 10.

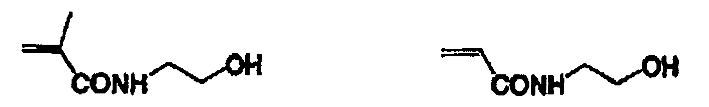

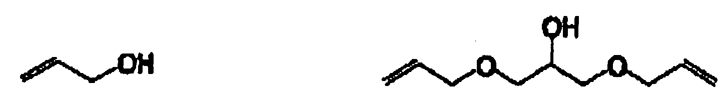

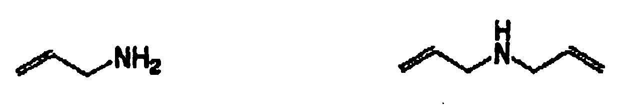

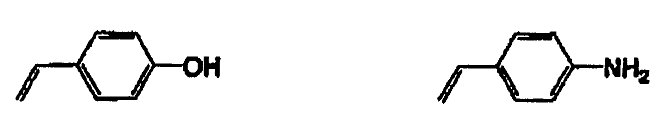

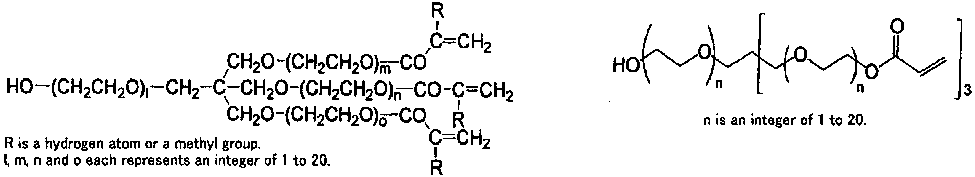

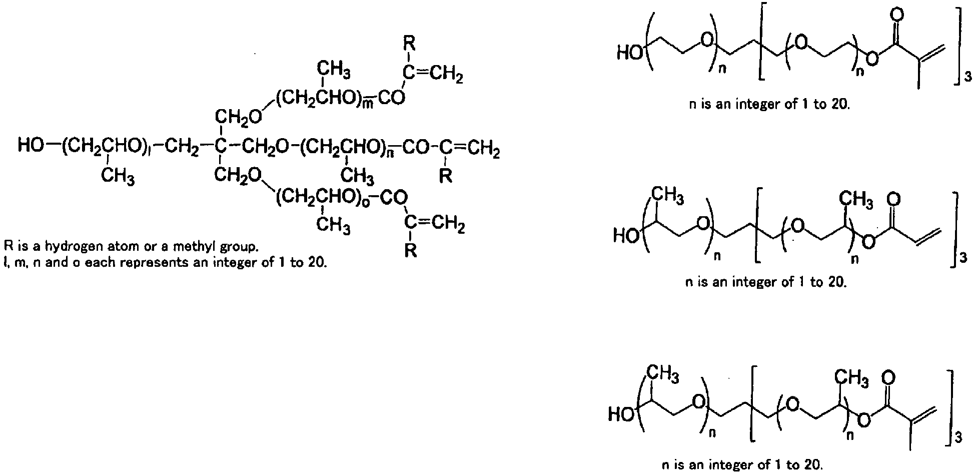

In order to introduce a crosslinkable group into the side chain of the polyurethane resin, a method of using as a raw material for the production of polyurethane resin, the diisocyanate compound having the crosslinkable group in its side chain is preferable. Specific examples of the diisocyanate compound having a crosslinkable group in its side chain obtained by an addition reaction of a triisocyanate compound with one equivalent of a monofunctional alcohol or monofunctional amine compound having the crosslinkable group are set forth below, but the invention should not be construed as being limited thereto.

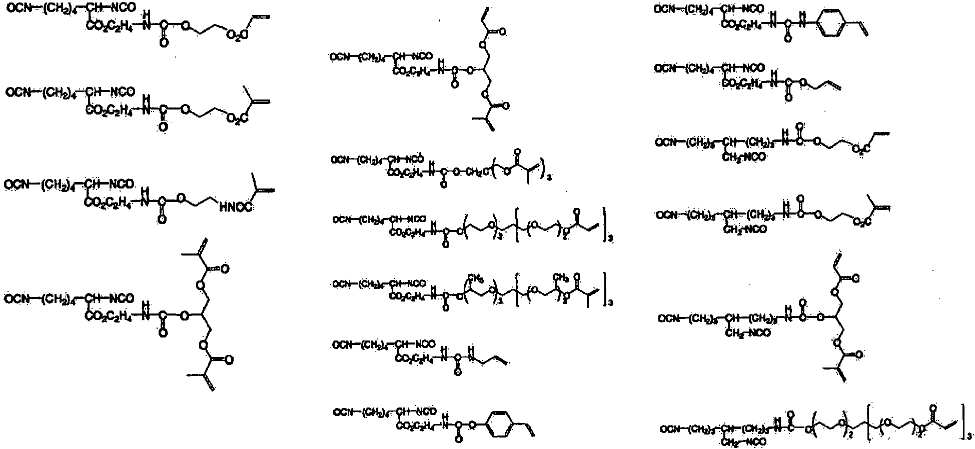

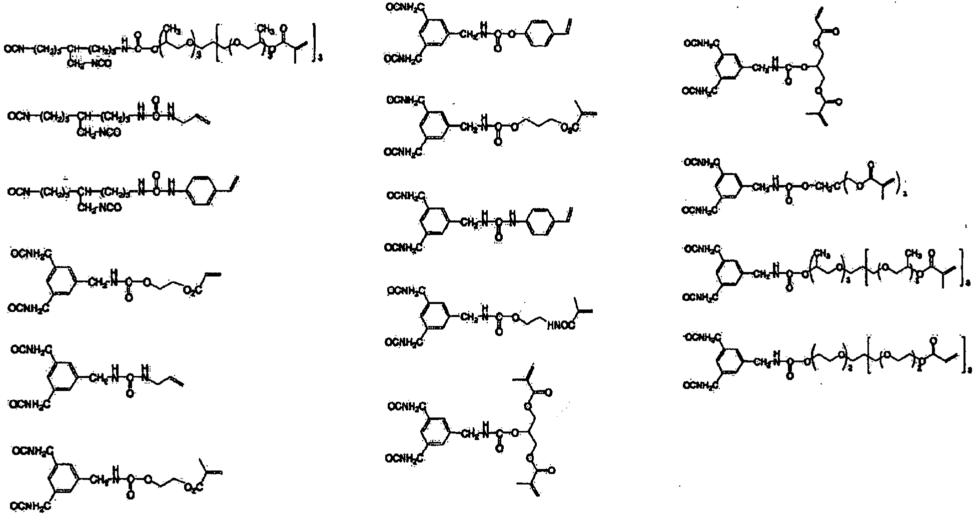

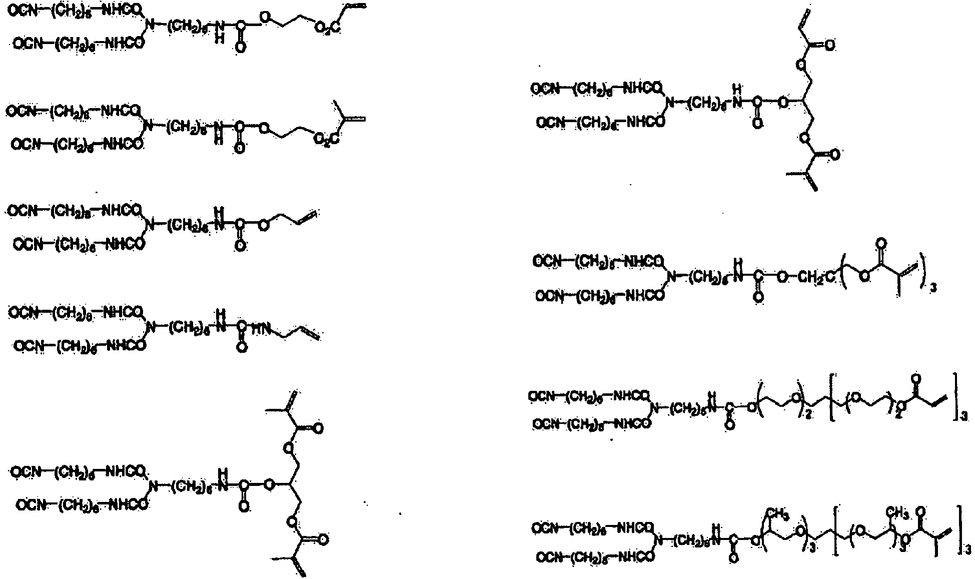

### (iv) Other diol compound

A method of using a diol compound having a crosslinkable group in its side chain as a raw material for the production of polyurethane resin is preferable as well as the method described above for the purpose of introducing the crosslinkable group into the side chain of the polyurethane resin. Such a diol compound may be a commercially available compound, for example, trimethylolpropane monoallyl ether or a compound easily produced by a reaction of a halogenated diol compound, a triol compound or an aminodiol compound with a carboxylic acid, acid chloride, isocyanate, alcohol, amine, thiol or halogenated alkyl compound having a crosslinkable group. Specific examples of the diol compound having a crosslinkable group are set forth below, but the invention should not be construed as being limited thereto. 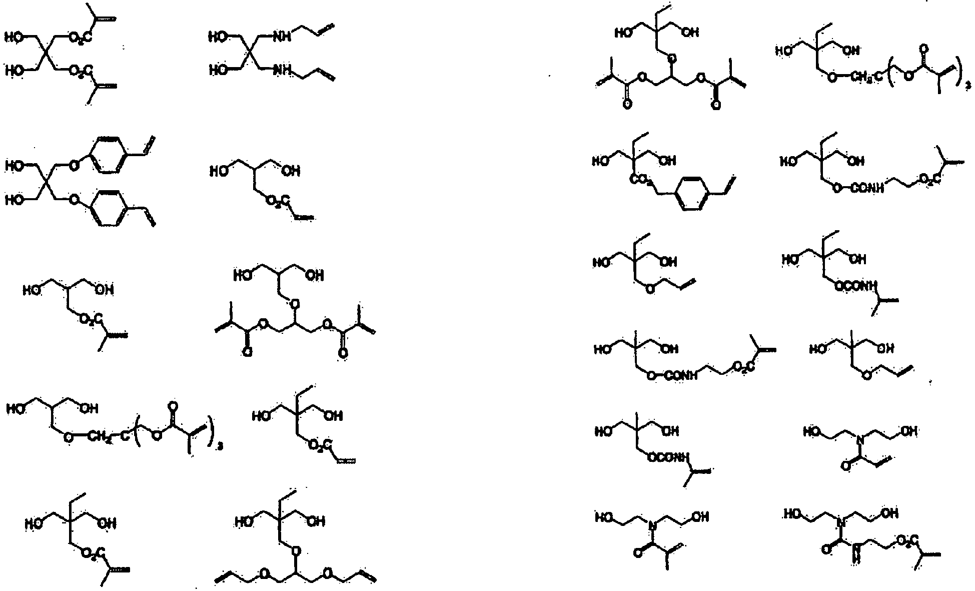 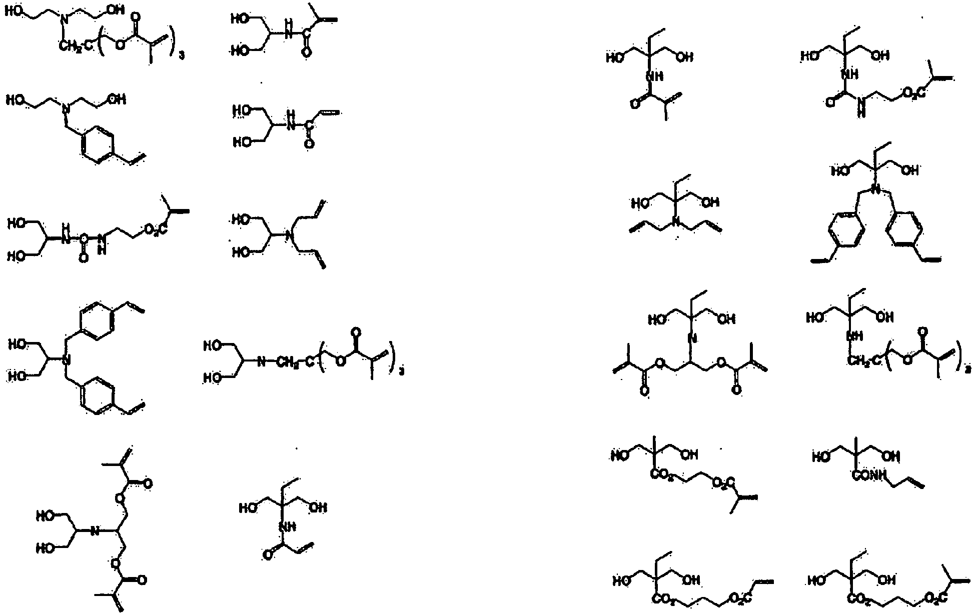 set forth below, but the invention should not be construed as being limited thereto.

Other examples of the other diol compound include ethylene glycol compounds represented by the following formula (A'):

HO-(CH₂CH₂O)ₙ-H (A')

In formula (A'), n represents an integer of 1 or more.

Also, random copolymers and block copolymers between ethylene oxide and propylene oxide having hydroxy groups at the terminals are exemplified.

Further, an ethylene oxide adduct of bisphenol A (addition number of the ethylene oxide is from 27 to 100), an ethylene oxide adduct of bisphenol F (addition number of the ethylene oxide is from 22 to 100), an ethylene oxide adduct of hydrogenated bisphenol A (addition number of the ethylene oxide is from 23 to 100) and an ethylene oxide adduct of hydrogenated bisphenol F (addition number of the ethylene oxide is from 18 to 100) are also used. More specifically, the ethylene glycol compounds represented by formula (A') are preferable in view of the stain resistance. The ethylene glycol compounds represented by formula (A') wherein n is form 2 to 50 are more preferable, those wherein n is form 3 to 30 are still more preferable, and those wherein n is form 4 to 10 are particularly preferable.

Specific examples thereof include 1,2-propylene glycol, di-1,2-propylene glycol, tri-1,2-propylene glycol, tetra-1,2-propylene glycol, hexa-1,2-propylene glycol, 1,3-propylene glycol, di-1,3-propylene glycol, tri-1,3-propylene glycol, tetra-1,3-propylene glycol, 1,3-butylene glycol, di-1,3-butylene glycol, tri-1,3-butylene glycol, hexa-1,3-butylene glycol, polypropylene glycol having an average molecular weight of 400, polypropylene glycol having an average molecular weight of 700, polypropylene glycol having an average molecular weight of 1,000, polypropylene glycol having an average molecular weight of 2,000, polypropylene glycol having an average molecular weight of 3,000, polypropylene glycol having an average molecular weight of 4,000, neopentyl glycol, 2-butene-1,4-diol, 2,2,4-trimethyl-1,3-pentanediol, 1,4-bis-β-hydroxyethoxycyclohexane, 1,4-butanediol, 1,5-pentanediol, 1,6-hexanediol, 1,7-heptanediol, 1,8-octanediol, cyclohexanedimethanol, tricyclodecanedimethanol, hydrogenated bisphenol A, hydrogenated bisphenol F, an ethylene oxide adduct of bisphenol A (addition number of the ethylene oxide is 26 or less), an ethylene oxide adduct of bisphenol F (addition number of the ethylene oxide is 21 or less), an ethylene oxide adduct of hydrogenated bisphenol A (addition number of the ethylene oxide is 22 or less), an ethylene oxide adduct of hydrogenated bisphenol F (addition number of the ethylene oxide is 17 or less), a propylene oxide adduct of bisphenol A, a propylene oxide adduct of bisphenol F, a propylene oxide adduct of hydrogenated bisphenol A, a propylene oxide adduct of hydrogenated bisphenol F, hydroquinone dihydroxy ethyl ether, p-xylylene glycol, dihydroxyethylsulfone, bis(2-hydroxyethyl)-2,4-tolylenedicarbamate, 2,4-tolylene-bis(2-hydroxyethylcarbamide), bis(2-hydroxyethyl)-m-xylylenedicarbamate and bis(2-hydroxyethyl)isophthalate.

Further, polyether diol compounds of compounds represented by the following formulae (a), (b), (c), (d) and (e) are preferably used.

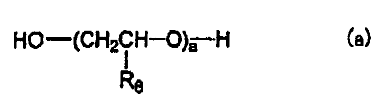

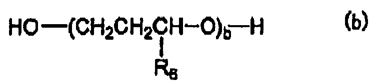

HO-(CH₂CH₂CH₂CH₂-O)_{c}-H (c)

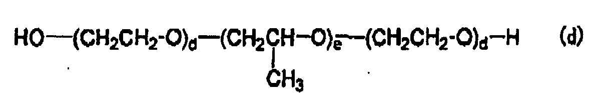

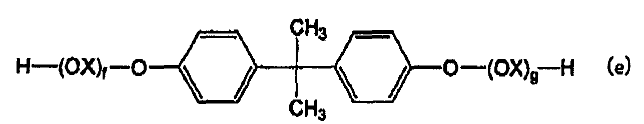

In formulae (a) to (e), R₆ represents a hydrogen atom or a methyl group, provided that R₆ in formula (a) represents a methyl group. X represents a group shown below.

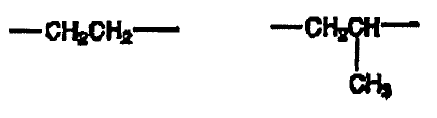

a, b, c, d, e, f and g each represents an integer of 2 or more, and preferably an integer of 2 to 100.

Polyester diol compounds represented by formulae (11) and (12) shown below are also enumerated as specific examples.

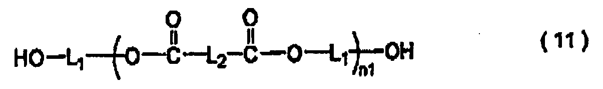

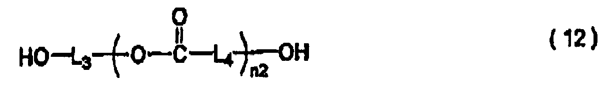

In formulae (11) and (12), L₁, L₂ and L₃, which may be the same or different, each represents a divalent aliphatic or aromatic hydrocarbon group, and L₄ represents a divalent aliphatic hydrocarbon group. Preferably, L₁, L₂ and L₃ each represents an alkylene group, an alkenylene group, an alkynylene group or an arylene group, and L₄ represents an alkylene group. Also, L₁, L₂, L₃ and L₄ each may have other functional group which does not react with the isocyanate group, for example, an ether group, a carbonyl group, an ester group, a cyano group, an olefin group, a urethane group, an amido group, a ureido group or a halogen atom. n1 and n2 each represents an integer of 2 or more, preferably an integer of 2 to 100.

Polycarbonate diol compounds represented by formula (13) shown below are also enumerated as specific examples.

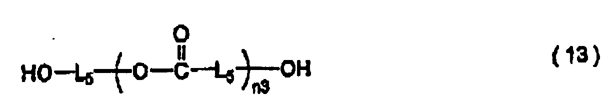

In the formula (13), L₅, which may be the same or different, each represents a divalent aliphatic or aromatic hydrocarbon group. Preferably, L₅ represents an alkylene group, an alkenylene group, an alkynylene group or an arylene group. Also, L₅ may have other functional group which does not react with the isocyanate group, for example, an ether group, a carbonyl group, an ester group, a cyano group, an olefin group, a urethane group, an amido group, a ureido group or a halogen atom. n3 represents an integer of 2 or more, preferably an integer of 2 to 100.

Specific examples of the diol compound represented by formula (11), (12) or (13) include those shown below. In the specific examples, n represents an integer of 2 or more.

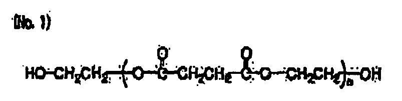

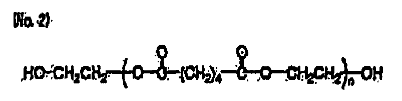

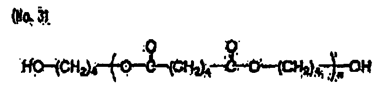

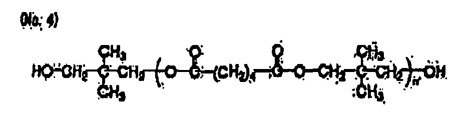

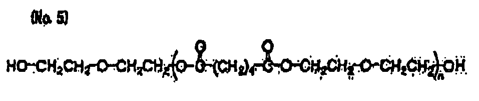

Further, diol compounds shown below are also preferably used.

| | | | |
|---|---|---|---|
| (No.101) | (No.109) | (No.115) | |
| 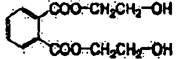 | 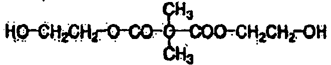 | 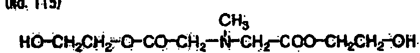 | |
| (No.102) | (No. 110) | (No. 116) | |
| 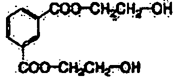 | HO-CH₂CH₂-O-CO-O-O-COO-CH₂CH₂-OH | 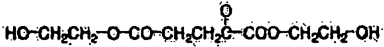 | |
| (No. 103) | (No. 111) | (No. 117) | |
| 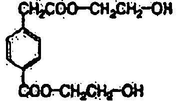 | 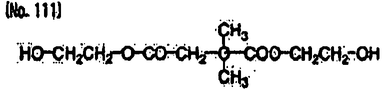 | 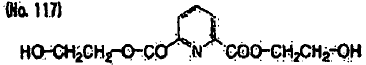 | |
| (No. 104) | (No. 112) | (No. 118) | (No. 119) |
| 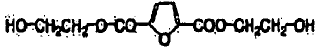 | 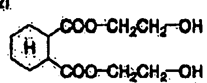 | 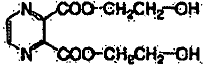 | 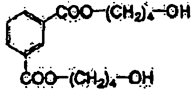 |
| (No. 105) | (No. 113) | (No. 120) | (No. 121) |
| HO-CH₂CH₂-O-CO-CH=CH-COO-CH₂CH₂-OH | HO-CH₂CH₂-O-CO-CH₂-O-CH₂-COO-CH₂CH₂-OH | 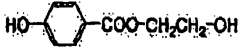 | 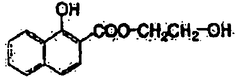 |
| (No. 106) | (No. 114) | (No. 122) | |
| HO-CH₂CH₂-O-COC₁₁H₂₂COO-CH₂CH₂-OH | 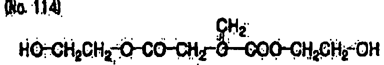 | | |
| (No. 107) | | 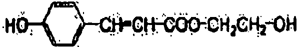 | |
| HO-CH₂CH₂-O-COC₁₂H₂₄COO-CH₂CH₂-OH | | (No. 123) | |
| (No. 108) | | HO-CH₂CH₂-COO-CH₂CH₂-OH | |
| HO-CH₂CH₂-O-COC₁₄H₂₈COO-CH₂CH₂-OH | | | |
| (No. 124) | | | |
| 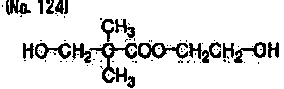 | | | |
| (No. 125) | | | |
| 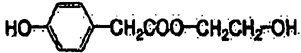 | | | |
| (No. 126) | | | |
| 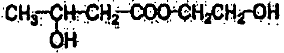 | | | |
| (No. 127) | | | |
| 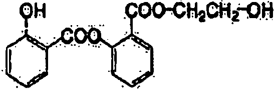 | | | |
| (No. 128) | | | |
| 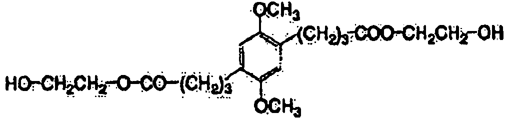 | | | |

>

Moreover, diol compounds shown below are also preferably used.

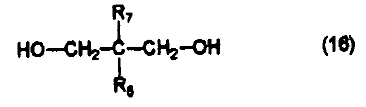

HO-CH₂-C≡C-CH₂-OH (17)

HO-CH₂-CH=CH-CH₂-OH (18)

In the formula (16), R₇ and R₈, which may be the same or different, each represents an alkyl group which may have a substituent, preferably an alkyl group having from I to 10 carbon atoms which may have a substituent (for example, a cyano group, a nitro group, a halogen atom (e.g., -F, -Cl, -Br or -I), -CONH₂, -COOR or -OR (wherein R, which may be the same or different, each represents an alkyl group having from I to 10 carbon atoms, an aryl group having from 7 to 15 carbon atoms or an aralkyl group)).

Specific examples of the diol compound represented by formula (16) include those shown below.

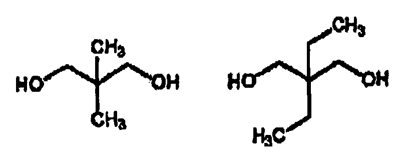

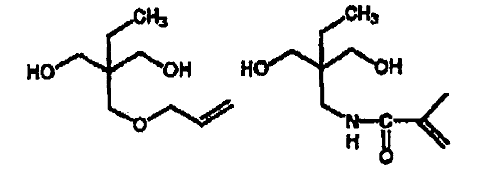

Example of the diol compound represented by formula (17) includes 2-butyne-1,4-diol. Examples of the diol compound represented by formula (18) include cis-2-butene-1,4-diol and trans-2-butene-1,4-diol.

Furthermore, diol compounds represented by formulae (19) and (20) shown below are also preferably used.

HO-L₈-NH-CO-L₉-CO-NH-L₈-OH (19)

HO-L₉-CO-NH-L₈-OH (20)

In formulae (19) and (20), L₈ and L₉, which may be the same or different, each represents a divalent aliphatic hydrocarbon group, aromatic hydrocarbon group or heterocyclic group, each of which may have a substituent (for example, an alkyl group, an aralkyl group, an aryl group, an alkoxy group, an aryloxy group or a halogen atom (e.g., -F, -Cl, -Br or -I)). L₈ and L₉ each may have other functional group which does not react with the isocyanate group, for example, a carbonyl group, an ester group, a urethane group, an amido group or a ureido group, if desired. Alternatively, L₈ and L₉ may be combined with each other to form a ring.

Specific examples of the diol compound represented by formula (19) or (20) include those shown below.

| | | | |
|---|---|---|---|
| (No. 201) | (No. 202) | (No. 211) | (No. 212) |
| 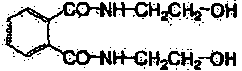 | 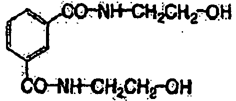 | 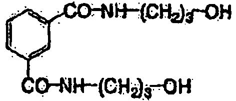 | 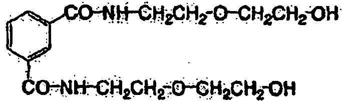 |
| (No. 203) | | | |
| HO-CH₂CH₂-NH-CO-CH=CH-CO-NH-CH₂-CH₂-OH | | (No. 213) | |
| (No. 204) | | HO-(CH₂)₃-NH-(CH₂)₃-NH-CO-(CH₂)₂-CO-NH-(CH₂)₃-OH | |
| HO-CH₂CH₂-NH-CO-C=C-CO-NH-CH₂CH₂-OH | | (No. 214) | |
| (No. 205) | | HO-CH₂CH₂-O-CH₂CH₂-NH-CO-(CH₂)₄-CO-NH-CH₂CH₂-O-CH₂CH₂-OH | |
| HO-CH₂CH₂-NH-CO-(CH₂)₂-CO-NH-CH₂CH₂-OH | | (No. 215) | |
| (No. 206) | | HO-CH₂CH₂-NH-CO-CH₂-O-CH₂-CO-NH-CH₂CH₂-OH | |
| HO-CH₂-CH₂-NH-CO-(CH₂)₃-CO-NH-CH₂CH₂-OH | | (No. 216) | |
| (No. 207) | | 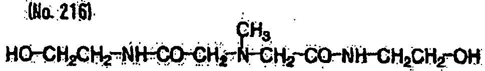 | |
| HO-CH₂CH₂-NH-CO-(CH₂)₅-CO-NH-CH₂CH₂-OH | | (No. 217) | |
| | | 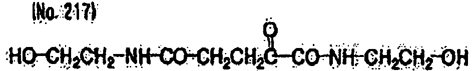 | |
| (No. 208) | | (No. 218) | |
| HO-CH₂CH₂-NH-CO-(CH₂)₈-CO-NH-CH₂CH₂-OH | | HO-CH₂CH₂-NH-CO-CH₂-S-CH₂-CO-NH-CH₂CH₂-OH | |
| (No. 209) | | (No. 219) | |
| 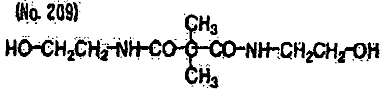 | | 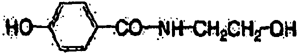 | |
| (No. 210) | | | |
| 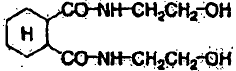 | | (No. 220) | |
| | | 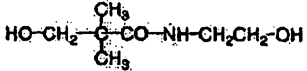 | |

Furthermore, diol compounds represented by formulae (21) and (22) shown below are also preferably used.

HO-Ar₂-(L₁₆-Ar₃)ₙ-OH (21)

HO-Ar₂-L₁₆-OH (22)

In formulae (21) and (22), L₁₆ represents a divalent aliphatic hydrocarbon group which may have a substituent (for example, an alkyl group, an aralkyl group, an aryl group, an alkoxy group, an aryloxy group or a halogen atom). L₁₆ may have other functional group which does not react with the isocyanate group, for example, an ester group, a urethane group, an amido group or a ureido group, if desired.

Ar₂ and Ar₃, which may be the same or different, each represents a divalent aromatic hydrocarbon group which may have a substituent, preferably an aromatic group having from 6 to 15 carbon atoms. n represents an integer of 0 to 10.

Specific examples of the diol compound represented by formula (21) or (22) include those shown below.

Specifically, catechol, resorcine, hydroquinone, 4-methylcatechol, 4-tert-butylcatechol, 4-acetylcatechol, 3-methoxycatechol, 4-phenylcatechol, 4-methylresorcine, 4-ethylresorcine, 4-tert-butylresorcine, 4-hexylresorcine, 4-chlororesorcine, 4-benzylresorcine, 4-acetylresorcine, 4-carbomethoxyresorcine, 2-methylresorcine, 5-methylresorcine, tert-butylhydroquinone, 2,5-di-tert-butylhydroquinone, 2,5-di-tert-amylhydroquinone, tetramethylhydroquinone, tetrachlorohydroquinone, methylcarboaminohydroquinone, methylureidohydroquinone, methylthiohydroquinone, benzonorbornene-3,6-diol, bisphenol A, bisphenol S, 3,3'-dichlorobisphenol S, 4,4'-dihydroxybenzophenone, 4,4'-dihydroxybiphenyl, 4,4'-thiodiphenol, 2,2'-dihydroxydiphenylmethane, 3,4-bis(p-hydroxyphenyl)hexane, 1,4-bis(2-p-hydroxyphenyl)propyl)benzene, bis(4-hydroxyphenyl)methylamine, 1,3-dihydroxynaphthalene, 1,4-dihydroxynaphthalene, 1,5-dihydroxynaphthalene, 2,6-dihydroxynaphthalene, 1,5-dihydroxyanthraquinone, 2-hydroxybezyl alcohol, 4-hydroxybezyl alcohol, 2-hydroxy-3,5-di-tert-butylbezyl alcohol, 4-hydroxy-3,5-di-tert-butylbezyl alcohol, 4-hydroxyphenethyl alcohol, 2-hydroxyethyl-4-hydroxybenzoate, 2-hydroxyethyl-4-hydroxyphenylacetate and resorcine mono-2-hydroxyethyl ether are exemplified. Diol compounds shown below are also preferably used.

### (v) Other amino group-containing compound

In the polyurethane resin binder according to the invention, an amino group-containing compound represented by formula (31) or (32) shown below may be used together to react with the diisocyanate compound, thereby forming a urea structure to incorporate into the polyurethane resin.

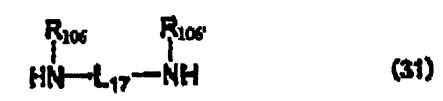

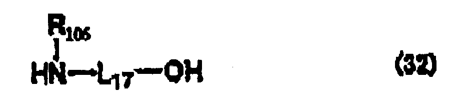

In formulae (31) and (32), R₁₀₆ and R₁₀₆, which may be the same or different, each represents a hydrogen atom, an alkyl group, an aralkyl group or an aryl group, each of which may have a substituent (for example, an alkoxy group, a halogen atom (e.g., -F, -Cl, -Br or -I), an ester group or a carboxyl group), preferably a hydrogen atom, an alkyl group having from 1 to 8 carbon atoms or an aryl group having from 6 to 15 carbon atoms, each of which may have a carboxyl group as a substituent. L₁₇ represents a divalent aliphatic hydrocarbon group, aromatic hydrocarbon group or heterocyclic group, each of which may have a substituent (for example, an alkyl group, an aralkyl group, an aryl group, an alkoxy group, an aryloxy group, a halogen atom (e.g., -F, -Cl, -Br or -I) or a carboxyl group). L₁₇ may have other functional group which does not react with the isocyanate group, for example, a carbonyl group, an ester group, a urethane group or an amido group, if desired. Alternatively, two of R₁₀₆, L₁₇ and R₁₀₆ may be combined with each other to form a ring.

Specific examples of the compound represented by formula (31) or (32) include the following compounds.

Specifically, aliphatic diamine compounds, for example, ethylenediamine, propylenediamine, tetramethylenediamine, pentamethylenediamine, hexamethylenediamine, heptamethylenediamine, octamethylenediamine, dodecamethylenediamine, propane-1,2-diamine, bis(3-aminopropyl)methylamine, 1,3-bis(3-aminopropyl)tetramethylsiloxane, piperazine, 2,5-dimethylpiperazine, N-(2-aminoethyl)piperazine, 4-amino-2,2,6,6-tetramethylpiperidine, N,N-dimethylethylenediamine, lysine, L-cystine or isophorondiamine; aromatic diamine compounds, for example, o-phenylenediamine, m-phenylenediamine, p-phenylenediamine, 2,4-tolylenediamine, benzidine, o-ditoluidine, o-dianisidine, 4-nitro-m-phenylenediamine, 2,5-dimethoxy-p-phenylenediamine, bis(4-aminophenyl)sulfone, 4-carboxy-o-phenylenediamine, 3-carboxy-m-phenylenediamine, 4,4'-diaminophenyl ether or 1,8-naphthalenediamine; heterocyclic amine compounds, for example, 2-aminoimidazole, 3-aminotriazole, 5-amino-1H-tetrazole, 4-aminopyrazole, 2-aminobenzimidazole, 2-amino-5-carboxytriazole, 2,4-diamono-6-methyl-S-triazine, 2,6-diaminopyridine, L-hystidine, DL-tryplophan or adenine; and aminoalcohol or aminophenol compounds, for example, ethanolamine, N-methylethanolamine, N-ethylethanolamine, 1-amino-2-propanol, 1-amino-3-propanol, 2-aminoethoxyethanol, 2-aminothioethoxyethanol, 2-amino-2-methyl-1-propanol, p-aminophenol, m-aminophenol, o-aminophenol, 4-methyl-2-aminophenol, 2-chloro-4-aminophenol, 4-methoxy-3-aminophenol, 4-hydroxybenzylamine, 4-amino-1-naphthol, 4-aminosalicylic acid, 4-hydroxy-N-phenylglycine, 2-aminobenzyl alcohol, 4-aminophenethyl alcohol, 2-carboxy-5-amino-1-naphthol or L-tyrosine are enumerated.

A polyurethane resin obtained by introducing a crosslinkable group into polyurethane having a carboxyl group by a polymer reaction as described in JP-A-2003-270775 may also be used as the binder polymer according to the invention as well as the above-described polyurethane resin obtained by introducing a crosslinkable group into a side chain at the synthesis of polyurethane.

According to the invention, a combination of a monomer having a melting point of 45°C or more with the urethane resin containing a crosslinkable group described above is particularly preferably used. Specific example of the urethane resin is set forth below, but the invention should not be construed as being limited thereto.

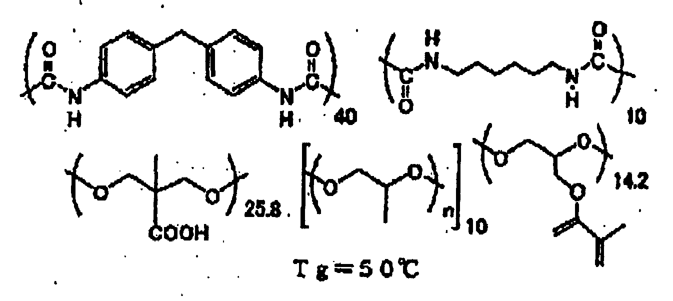

The binder polymer for use in the invention preferably has an appropriate molecular weight in order to maintain the developing property of the photosensitive layer. The weight average molecular weight thereof is preferably in a range of 5,000 to 300,000, and more preferably in a range of 20,000 to 150,000.

Although the binder polymer can be incorporated into the photosensitive layer in an appropriate amount, when the amount of the binder polymer exceeds 90% by weight of the photosensitive layer, a preferable result may not be obtained in view of image strength or the like in some cases. It is preferably from 10 to 90% by weight, and more preferably from 30 to 80% by weight.

Into the photosensitive layer for use in the invention, other components may be incorporated in addition to the essential components described above, if desired. For instance, the photosensitive layer may contain a dye or pigment capable of absorbing light having a wavelength of a laser emission wavelength for use in the image exposure ± 50 nm. However, such a dye or pigment is different from the sensitizing dye and does not have the function for transmitting energy to the polymerization initiator.

The above-described dye or pigment is not particularly restricted as long as it is a dye or pigment which is capable of absorbing light having a wavelength range of a laser emission wavelength ± 50 nm. It is preferably a dye or pigment having an absorption maximum in a wavelength range of a laser emission wavelength ± 50 nm, more preferably a dye or pigment having an absorption maximum in a wavelength range of a laser emission wavelength ± 20 nm, and still more preferably a dye or pigment having an absorption maximum at a wavelength same as a laser emission wavelength.

The exposure by a blue or violet region laser emitting light having a wavelength range of 350 to 450 nm is particularly desirable according to the invention, and as the dye or pigment corresponding to the laser, a yellow dye or pigment is preferably added.

Examples of the yellow dye include yellow acid dyes. Specific examples of the yellow dye include acid dyes described in Senryo Binran (Dye Handbook) and a group of C.I. Acid Yellow. Particularly preferable examples thereof include C.I. Acid Yellow 17, C.I. Acid Yellow 19, C.I. Acid Yellow 23, C.I. Acid Yellow 38, C.I. Acid Yellow 42, C.I. Acid Yellow 61, C.I. Acid Yellow 72 and C.I. Acid Yellow 141.

The dyes set forth below are also preferably used.

| | | | | |
|---|---|---|---|---|
| 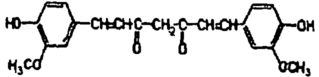 | | 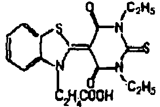 | 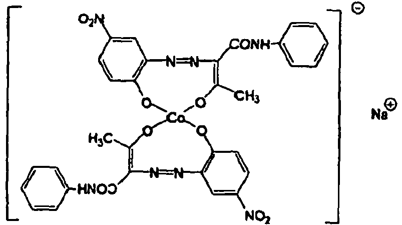 | |
| 1347F | | PM1659K | | |
| 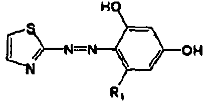 | R₁=H | TAR | | |
| | R₁=CH₃ | 5-Methyl-4-(2-thiazolylazo)resorcinol | ASY-3RH | |
| 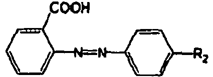 | R₂=OH | 4-Hydroxyazobenzene-2'-carboxylic Acid | 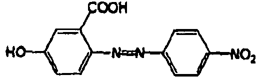 | Alizarin Yellow GG |
| | R₂=NEt₂ | Ethyl Red | | |
| 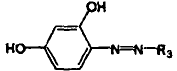 | 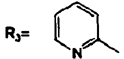 | PAR | 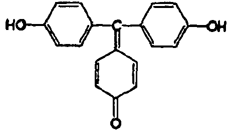 | Aurin |
| | 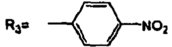 | 4-(4-Nitrophenylazo)catechol | | |
| | 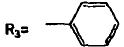 | Sudan Orange G | | |
| 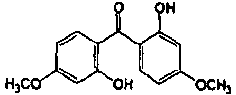 | 2,2'-Dihydroxy-4,4'-dimethoxy-benzophenone | | 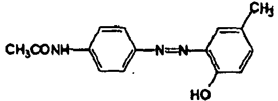 | Disperse Yellow 3 |
| 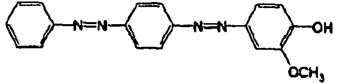 | | Disperse Yellow 7 | | |

Examples of the yellow pigment include Novopern Yellow H2G, Seikafast Yellow 2200, Seikafast Yellow 2300, Seikafast Yellow, HOSTACOPY Y501, Yellow master batch, PV Fast Yellow HG, Novoperm Yellow P-HG and Novoperm Yellow M2R.

By using the above-described dye or pigment, the effect for preventing plugging in the shadow area due to reflected light or scattered light of the laser is achieved and a lithographic printing plate can be provided, which is suitable for high definition AM screen printing or FM screen printing, and particularly, which provides good printed materials without unevenness of halftone dots in the halftone area even in case of exposure using the FM screen.

The amount of the dye or pigment added to the photosensitive layer is preferably 0.01 % by weight or more, more preferably 0.05% by weight or more, based on the weight of the photosensitive layer. Also, from the standpoint of maintaining the amount of light reaching the photosensitive layer and keeping the sensitivity in a preferable range, the amount of the dye or pigment added is preferably 10% by weight or less, more preferably 5% by weight or less.

It is desirable to add a small amount of a thermal polymerization inhibitor to the photosensitive layer for use in the invention in order to prevent the addition polymerizable compound having an ethylenically unsaturated double bond from undergoing undesirable thermal polymerization during the production or preservation of the composition (photopolymerization type photosensitive composition) for forming the photosensitive layer. Examples of suitable thermal polymerization inhibitor include hydroquinone, p-methoxyphenol, di-tert-butyl-p-cresol, pyrogallol, tert-butylcatechol, benzoquinone, 4,4'-thiobis(3-methyl-6-tert-butylphenol), 2,2'-methylenebis(4-methyl-6-tert-butylphenol), N-nitrosophenylhydroxyamine cerium(III) salt and N-nitrosophenylhydroxyamine aluminum salt. The amount of the thermal polymerization inhibitor added is preferably from about 0.01 to about 5% by weight based on the total components of the composition. If desired, in order to prevent polymerization inhibition due to oxygen, a higher fatty acid derivative, for example, behenic acid or behenic acid amide may be added and allowed to localize on the surface of the photosensitive layer during a drying step after the coating. The amount of the higher fatty acid derivative added is preferably from about 0.5 to about 10% by weight based on the total components of the photopolymerization type photosensitive composition.

A coloring agent may be added for the purpose of coloring the photosensitive layer. The coloring agent includes pigments, for example, phthalocyanine-base pigment (e.g., C.I. Pigment Blue 15:3, C.I. Pigment Blue 15:4 or C.I. Pigment Blue 15:6), azo-base pigment, carbon black and titanium oxide, and dyes, for example, Ethyl Violet, Crystal Violet, azo dye, anthraquinone-base dye and cyanine-base dye. The amount of the coloring agent added is preferably from about 0.5 to about 5% by weight based on the total components of the photopolymerization type photosensitive composition.

In order to improve physical properties of the cured layer, an additive, for example, inorganic filler or a plasticizer, e.g., dioctyl phthalate, dimethyl phthalate or tricresyl phosphate, The amount of the additive is preferably 10% by weight or less based on the total components of the photopolymerization type photosensitive composition.

To the composition for forming the photosensitive layer can be added a surfactant for improving surface quality of the coating. Preferable examples of the surfactant include a fluorine-based nonionic surfactant.

According to the invention, the composition for photosensitive layer is coated on the support described hereinbefore to form a photosensitive layer. In case of coating the composition for photosensitive layer on the support the photosensitive composition is dissolved in an organic solvent to prepare a coating solution. Examples of the solvent capable of being used include acetone, methyl ethyl ketone, cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 3-methoxypropanol, methoxymethoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxypropyl acetate, N,N-dimethylformamide, dimethyl sulfoxide, γ -butyrolactone, methyl lactate and ethyl lactate. The solvents may be used individually or as a mixture thereof. The concentration of solid content in the coating solution is appropriately from 1 to 50% by weight.

The coating amount of the photosensitive layer of the lithographic printing plate precursor according to the invention is preferably in a range of about 0.1 to about 10 g/m², more preferably in a range of 0.3 to 5 g/m², still more preferably in a range of 0.5 to 3 g/m², in terms of weight after drying.

### [Protective layer]

On the photosensitive layer described above, an oxygen blocking protective layer (overcoat layer) is preferably provided in order to avoid polymerization inhibiting function of oxygen.

The coating amount of the protective layer is preferably in a range of 0.5 to 3.0 g/m². When the coating amount is less than 0.5 g/m², the sensitivity may decrease in some cases, whereas when it exceeds 3.0 g/m², the burden on treatment process may increase in some cases. The coating amount is preferably in a range of 0.7 to 2.5 g/m², and more preferably in a range of 1.0 to 2.0 g/m².

The protective layer preferably contains a water-soluble polymer. The water-soluble polymer specifically includes, for example, polyvinyl alcohol, a partial ester, ether or acetal thereof and a copolymer thereof containing a substantial amount of an unsubstituted vinyl alcohol unit necessary for providing the water-solubility. The polyvinyl alcohol preferably has a hydrolysis degree of 71 to 100% and a polymerization degree of 300 to 2,400. Specifically, PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8, produced by Kuraray Co., Ltd., are exemplified. Further, polyvinyl acetate chloroacetate or propionate, polyvinyl formal and polyvinyl acetal each hydrolyzed to an extent of 88 to less than 100% are exemplified. Other useful water-soluble polymers include, for example, polyvinyl pyrrolidone, gelatin and gum arabic. The water-soluble polymers may be used individually or in combination.

In order to obtain the particularly preferable results according to the invention, it is desired to use polyvinyl alcohol having a hydrolysis degree of 95% or more.

In the protective layer, a modified polyvinyl alcohol may also be used. In particular, an acid-modified polyvinyl alcohol is preferably used. The occurrence of scum in the processing solution according to the invention is avoided.

### (Acid-modified polyvinyl alcohol)

The acid-modified polyvinyl alcohol is not particularly restricted as long as it is a vinyl alcohol polymer containing an appropriate amount of an acid group. Particularly, a vinyl alcohol polymer including appropriate amount of a sulfonic acid group or a carboxyl group is preferably used. The former is preferred to as a sulfonic acid-modified polyvinyl alcohol and the latter is referred to as a carboxylic acid-modified polyvinyl alcohol.

The acid-modified polyvinyl alcohol is preferably synthesized by a method wherein a monomer having an acid group is copolymerized with vinyl acetate and then the vinyl acetate is partially or wholly saponified to change to vinyl alcohol. However, it is also possible to synthesize by connecting a compound having an acid group to a hydroxy group of polyvinyl alcohol.

Examples of the monomer having a sulfonic acid group include ethylenesulfonic acid, allylsulfonic acid, methallylsulfonic acid, 2-acrylamido-2-methylpropanesulfonic acid and salts thereof. Examples of the compound having a sulfonic acid group include an aldehyde derivative having a sulfonic acid group, for example, p-sulfonic acid benzaldehyde and salts thereof. The compound can be introduced by a conventionally known acetalization reaction.

Examples of the monomer having a carboxyl group include fumaric acid, maleic acid, itaconic acid, maleic anhydride, phthalic anhydride, trimellitic anhydride, acrylic acid and salts thereof, an acrylic acid ester, for example, methyl acrylate, and a methacrylic acid ester, for example, methyl methacrylate. Examples of the compound having a carboxyl group include a monomer, for example, acrylic acid. The compound can be introduced according to a conventionally known Michael addition reaction.

The acid-modified polyvinyl alcohol may be a compound appropriately synthesized or a commercially available compound.

The acid-modified polyvinyl alcohol can avoid degradation of the removability of photosensitive layer by development Particularly, the acid-modified polyvinyl alcohol having a saponification degree of 91 % by mole or more is preferable.

Specific examples of the acid-modified polyvinyl alcohol having such a high saponification degree include as the carboxy-modified polyvinyl alcohol, KL-118 (saponification degree: 97% by mole, average polymerization degree: 1,800), KM-618 (saponification degree: 94% by mole, average polymerization degree: 1,800), KM-118 (saponification degree: 97% by mole, average polymerization degree: 1,800) and KM-106 (saponification degree: 98.5% by mole, average polymerization degree: 600) produced by Kuraray Co., Ltd., Gosenal T-330H (saponification degree: 99% by mole, average polymerization degree: 1,700), Gosenal T-330 (saponification degree: 96.5% by mole, average polymerization degree: 1,700), Gosenal T-350 (saponification degree: 94% by mole, average polymerization degree: 1,700), Gosenal T-230 (saponification degree: 96.5% by mole, average polymerization degree: 1,500), Gosenal T-215 (saponification degree: 96.5% by mole, average polymerization degree: 1,300) and Gosenal T-HS-1 (saponification degree: 99% by mole, average polymerization degree: 1,300) produced by Nippon Synthetic Chemical Industry Co., Ltd., and AF-17 (saponification degree: 96.5% by mole, average polymerization degree: 1,700) and AT-17 (saponification degree: 93.5% by mole, average polymerization degree: 1,700) produced by Japan VAM & Poval Co., Ltd.

Specific examples of the sulfonic acid-modified polyvinyl alcohol include SK-5102 (saponification degree: 98% by mole, average polymerization degree: 200) produced by Kuraray Co., Ltd. and Goseran CKS-50 (saponification degree: 99% by mole, average polymerization degree: 300) produced by Nippon Synthetic Chemical Industry Co., Ltd.

In view of preventing more effectively the degradation of the removability of photosensitive layer by development, it is particularly preferable to use the acid-modified polyvinyl alcohol having an average polymerization degree of vinyl alcohol unit of 100 to 800. By using the acid-modified polyvinyl alcohol having such a low polymerization degree and a high saponification degree, a protective layer which is effectively preventing the degradation of the removability of photosensitive layer by development while maintaining the excellent characteristic of oxygen-blocking property can be obtained.

As the acid-modified polyvinyl alcohol having a low polymerization degree and a high saponification degree as described above, a carboxy-modified polyvinyl alcohol modified with itaconic acid or maleic acid or sulfonic acid-modified polyvinyl alcohol having a saponification degree of 91% by mole or more and an average polymerization degree of vinyl alcohol unit of 100 to 800 is preferable.

The modification degree of the acid-modified polyvinyl alcohol means a molar ratio of unit having an acid group contained in a copolymer of the acid-modified polyvinyl alcohol. The modification degree of the acid-modified polyvinyl alcohol is preferably from 0.1 to 20% by mole, and more preferably from 0.2 to 5% by mole.

Further, it is preferred to incorporate a stratiform compound into the protective layer. The stratiform compound is a particle having a thin tabular shape and includes, for instance, mica, for example, natural mica represented by the following formula: A (B, C)₂₋₅ D₄ O₁₀ (OH, F, O)₂, (wherein A represents any of Li, K, Na Ga, Mg and an organic cation, B and C each represents any of Fe (II), Fe(III), Mn, Al, Mg and V, and D represents Si or Al) or synthetic mica, talc represented by the following formula: 3MgO-4SiO-H₂O, teniolite, montmorillonite, saponite, hectoliter and zirconium phosphate.

Examples of the natural mica include muscovite, paragonite, phlogopite, biotite and lepidolite. Examples of the synthetic mica include non-swellable mica, for example, fluorphlogopite KMg₃(AlSi₃O₁₀)F₂ or potassium tetrasilic mica KMg_{2.5}(Si₄O₁₀)F₂, and swellable mica, for example, Na tetrasilic mica NaMg_{2.5}(Si₄O₁₀)F₂, Na or Li teniolite (Na, Li)Mg₂Li(Si₄O₁₀)F₂, or montmorillonite based Na or Li hectolite (Na, Li)_{1/8}Mg_{2/5}Li_{1/8}(Si₄O₁₀)F₂. Synthetic smectite is also useful.

Of the stratiform compounds, fluorine based swellable mica, which is a synthetic stratiform compound, is particularly useful, Specifically, mica and an swellable clay mineral, for example, montmorillonite, saponite, hectolite or bentonite have a stratiform structure comprising a unit crystal lattice layer having thickness of approximately 10 to 15 angstroms, and metallic atom substitution in the lattices thereof is remarkably large in comparison with other clay minerals. As a result, the lattice layer results in lack of positive charge and in order to compensate it, a cation, for example, Li⁺, Na⁺, Ca²⁺, Mg²⁺ or an organic cation, e.g., an amine salt, a quaternary ammonium salt, a phosphonium salt or a sulfonium salt is adsorbed between the lattice layers. These stratiform compounds swell upon contact with water. When share is applied under such conditions, the stratiform compound is easily cleaved to form a stable sol in water. The bentnite and swellable synthetic mica have strongly such tendency.

With respect to the shape of the stratiform compound, the thinner the thickness or the larger the plain size, as long as smoothness of coated surface and transmission of actinic radiation are not damaged, the better from the standpoint of control of diffusion. Therefore, an aspect ratio of the inorganic stratiform compound is ordinarily 20 or more, preferably 100 or more, particularly preferably 200 or more. The aspect ratio is a ratio of major axis to thickness of particle and can be determined, for example, from a projection drawing of particle by a microphotography. The larger the aspect ratio, the greater the effect obtained.

As for the particle size of the stratiform compound, an average diameter is ordinarily from 1 to 20 µm, preferably from I to 10 µm, particularly preferably from 2 to 5 µm. When the particle size is smaller than 1 µm, the inhibition of permeation of oxygen or moisture becomes insufficient and the effects can not be sufficiently achieved. When the particle size is larger than 20 µm, dispersion stability in a coating solution becomes insufficient and a problem in that the coating can not be stably performed may arises. An average thickness of the particle is ordinarily 0.1 µm or less, preferably 0.05 µm or less, particularly preferably 0.01 µm or less. For example, in the swellable synthetic mica that is the representative compound of the inorganic stratiform compounds, thickness is from 1 to 50 nm and plain size is from 1 to 20 µm.

When such an inorganic stratiform compound particle having a large aspect ratio is incorporated into the protective layer, strength of coated layer increases and penetration of oxygen or moisture can be effectively inhibited. As a result, the protective layer can be prevented from deterioration due to deformation and even when the lithographic printing plate precursor is preserved for a long period of time under a high humidity condition, it is prevented from decrease in the image-forming property thereof due to the change of humidity and exhibits excellent preservation stability.

The content of the inorganic stratiform compound in the protective layer is preferably from 5/1 to 1/100, more preferably from 2/1 to 1/5, in terms of weight ratio to the amount of binder used in the protective layer. When a plurality of inorganic stratiform compounds is used in combination, it is also preferred that the total amount of the inorganic stratiform compounds fulfills the above-described weight ratio.

As a solvent used for preparing a coating solution for protective layer, although pure water is preferable, a mixture of pure water with an alcohol, for example, methanol or ethanol or a ketone, for example, acetone or methyl ethyl ketone may be used. The concentration of the solid content in the coating solution is appropriately from 1 to 20% by weight. To the protective layer may be added known additives, for example, a surfactant for improving coating property or a water-soluble plasticizer for improving physical property of the coated layer. Examples of the water-soluble plasticizer include propionamide, cyclohexanediol, glycerin and sorbitol. Also, a water-soluble (meth)acrylic polymer may be added. The coating amount of the protective layer is preferably in a range of about 0.1 to about 15 g/m², more preferably in a range of 1.0 to about 5.0 g/m², in terms of weight after drying.

### [Method of preparing lithographic printing plate]

A method of preparing a lithographic printing plate using the lithographic printing plate precursor described above will be described with reference to drawings below.

The method of preparing a lithographic printing plate described below comprises after image exposure (exposure step) of the lithographic printing plate precursor, processing (development step) the exposed lithographic printing plate precursor with an aqueous solution having pH of 8.5 to 10.8 and containing a low molecular weight hydroxycarboxylate ion, a pH buffer and a surfactant. A step of exposing to light and/or heating the entire surface of lithographic printing plate precursor may be provided between the exposure step and the development step and/or after the development step, if desired.

The image exposure of the lithographic printing plate precursor is performed by a method of exposing through a transparent original having a line image, a halftone dot image or the like or a method of scanning of laser beam based on digital data. The desirable wavelength of the light source is from 350 to 450 nm.

As for the available laser light source emitting light of 350 to 450 nm, the followings can be used. A gas laser, for example, Ar ion laser (364 nm, 351 nm, 10 mW to I W), Kr ion laser (356 nm, 351 nm, 10 mW to 1 W) and He-Cd laser (441 nm, 325 nm, 1 mW to 100 mW); a solid laser, for example, a combination of Nd:YAG (YVO₄) with SHG crystals×twice (355 nm, 5 mW to 1 W) and a combination of Cr:LiSAF with SHG crystal (430 nm, 10 mW); a semiconductor laser system, for example, a KNbO₃ ring resonator (430 nm, 30 mW), a combination of a waveguide-type wavelength conversion element with an AlGaAs or InGaAs semiconductor (380 nm to 450 nm, 5 mW to 100 mW), a combination of a waveguide-type wavelength conversion element with an AlGaInP or AlGaAs semiconductor (300 nm to 350 nm, 5 mW to 100 mW), and AlCaInN (350 nm to 450 nm, 5 mW to 30 mW); a pulse laser, for example, N₂ laser (337 nm, pulse 0.1 to 10 mJ) and XeF (351 nm, pulse 10 to 250 mJ) can be used. Among the light sources, the AlGaInN semiconductor laser (commercially available InGaN semiconductor laser, 400 to 410 nm, 5 to 30 mW) is particularly preferable in view of the wavelength characteristics and cost.

As for the exposure apparatus for the lithographic printing plate precursor of scanning exposure system, the exposure mechanism may be any of an internal drum system, an external drum system and a flat bed system. As the light source, among the light sources described above, those capable of conducting continuous oscillation can be preferably utilized.

Other examples of the exposure light source include an ultra-high pressure mercury lamp, a high pressure mercury lamp, a medium pressure mercury lamp, a low pressure mercury lamp, a chemical lamp, a carbon arc lamp, a xenon lamp, a metal halide lamp, various visible or ultraviolet laser lamps, a fluorescent lamp, a tungsten lamp and sunlight.

### [Aqueous solution having pH of 8.5 to 10.8 and containing low molecular weight hydroxycarboxylate ion, pH buffer and surfactant]

The low molecular weight hydroxycarboxylate ion for use in the aqueous solution (hereinafter, also referred to as a "processing solution" or a "developer") for processing the lithographic printing plate precursor is a low molecular weight compound having a molecular weight of 500 or less. In order for the low molecular weight hydroxycarboxylate ion to be present in a developer, a low molecular weight hydroxycarboxylic acid may be added to the developer and then adjusting the pH or a low molecular weight hydroxycarboxylate may be added to the developer. In case of a low molecular weight hydroxycarboxylic acid having two or more carboxylic acids, at least one of the carboxylic acids should be in the form of an ion in the aqueous solution.

The low molecular weight hydroxycarboxylic acid which serves as a source of the low molecular weight hydroxycarboxylate ion specifically includes, for example, gluconic acid, glycolic acid, lactic acid, tartronic acid, hydroxybutyric acid, 2-hydroxybutyric acid, 3-hydroxybutyric acid, γ-hydroxybutyric acid, malic acid, tartaric acid, citramalic acid, citric acid, isocitric acid, leucine acid, mevalonic acid, pantoic acid, ricinoleic acid, ricinelaidic acid, cerebronic acid, quinic acid, shikiminic acid, a monohydroxybenzoic acid derivative, e.g., salicylic acid, creosotic acid (homosalicylic acid or hydroxy(methyl)benzoic acid), venillic acid or syringic acid, a dihydroxybenzoic acid derivative, e.g., pyrocatechuic acid, resorcylic acid, protocatechuic acid, gentisic acid or orsellinic acid, a trihydroxybenzoic acid derivative, e.g., gallic acid, a phenylacetic acid derivative, e.g., mandelic acid, benzilic acid, atrolactic acid, cinnamic acid, and a hydrocinnamic acid derivative, e.g., melilotic acid, phloretic acd, coumaric acid, umbellic acid, caffeic acid, ferulic acid or sinapic acid. Of these compounds, the low molecular weight hydroxycarboxylic acids having two or more carboxylic acids are preferable, citric acid, malic acid and tartaric acid are more preferable, and citric acid is most preferable.

The low molecular weight hydroxycarboxylate used is not particularly restricted and it is preferably an alkali metal salt. Examples of the alkali metal include lithium, sodium and potassium and sodium is particularly preferable. The low molecular weight hydroxycarboxylates may be used individually or in combination of two or more thereof.

The amount of the low molecular weight hydroxycarboxylate ion in the developer is preferably from 0.05 to 5 mole/l, more preferably from 0.2 to 2 mole/l, and most preferably from 0.25 to 0.75 mole/l. When the amount thereof is 0.05 mole/l or more, sufficient effect of preventing fingerprint stain is obtained. On the other hand, when the amount is 5 mole/l or less, precipitates and crystals hardly generate and since gelation at neutralization of waste liquid of the developer hardly occur, treatment of the waste liquid can be carried out without trouble.

The developer further contains a pH buffer agent and a surfactant.

The pH buffer agent is an alkaline buffer agent and includes, for example, (a) a carbonate ion and a hydrogen carbonate ion, (b) a borate ion, (c) a water-soluble amine compound and an ion of the amine compound, and combinations thereof. Specifically, for example, (a) combination of a carbonate ion and a hydrogen carbonate ion, (b) a borate ion, or (c) combination of a water-soluble amine compound and an ion of the amine compound exhibits a pH buffer function in the developer and prevents fluctuation of the pH even when the developer is used for a long period of time. As a result, the deterioration of developing property resulting from the fluctuation of pH, the occurrence of development scum and the like are restrained. The combination of a carbonate ion and a hydrogen carbonate ion is particularly preferable.
(a) In order for a carbonate ion and a hydrogen carbonate ion to be present in a developer, a carbonate and a hydrogen carbonate may be added to the developer or a carbonate ion and a hydrogen carbonate ion may be generated by adding a carbonate or a hydrogen carbonate to a developer and then adjusting the pH. The carbonate or hydrogen carbonate used is not particularly restricted and it is preferably an alkali metal salt thereof. Examples of the alkali metal include lithium, sodium and potassium and sodium is particularly preferable. The alkali metals may be used individually or in combination of two or more thereof.
(b) In order for a borate ion to be present in a developer, a boric acid or a borate is added to a developer and then pH of the developer is adjusted using an alkali or an alkali and an acid to generate an appropriate amount of the borate ion.
   The boric acid or a borate used is not particularly restricted. The boric acid includes, for example, ortho boric acid, metha boric acid and tetra boric acid, and preferably ortho boric acid and tetra boric acid. The borate includes an alkali metal salt thereof and an alkaline earth metal salt thereof, specifically, an orthoborate, a diborate, a methaborate, a tetraborate, a pentaborate and an octaborate, preferably an orthoborate and a tetraborate, and particularly preferably an alkali metal salt of tetraborate. The alkali metal salt of tetraborate includes, for example, sodium tetraborate, potassium tetraborate and lithium tetraborate, and particularly preferably sodium tetraborate. The borates may be used individually or in combination of two or more thereof.
   As the boric acid and borate, ortho boric acid, tetra boric acid and sodium tetraborate are particularly preferable. The boric acid and borate may be used in combination in the developer.
(c) An ion of a water-soluble amine compound may be generated in an aqueous solution of the water-soluble amine compound. To the aqueous solution of water-soluble amine compound may be added an alkali or an acid. Alternatively, the ion of a water-soluble amine compound may be contained in an aqueous solution by adding a compound which is a salt of amine compound per se.

The water-soluble amine compound is not particularly restricted and preferably a water-soluble amine compound having a group capable of facilitating water-solubility. The group capable of facilitating water-solubility includes, for example, a carboxylic acid group, a sulfonic acid group, a sulfinic acid group, a phosphonic acid group and a hydroxy group. The water-soluble amine compound may have two or more groups capable of facilitating water-solubility.

In case where the water-solubility of the water-soluble amine compound is facilitated with a carboxylic acid group, a sulfonic acid group, a sulfinic acid group or a phosphonic acid group, the water-soluble amine compound corresponds to an amino acid. The amino acid is held in equilibrium in an aqueous solution and for example, when the acid group is a carboxylic acid group, the equilibrium state is indicated as below. In the invention, the amino acid means State B shown below and an amino acid ion means State C shown below. A counter ion in State C is preferably a sodium ion or a potassium ion.

### Equilibrium of amino acid (case wherein acid group is carboxylic acid group)

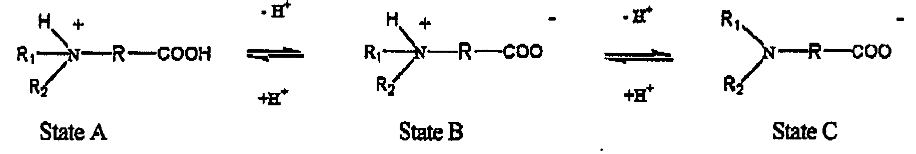

wherein, for example, R₁ and R₂ each independently represents a hydrogen atom, an alkyl group or an aryl group, and R represents a connecting group.

Specific examples of the water-soluble amine compound having a carboxylic acid group, a sulfonic acid group or a sulfinic acid group include an amino acid, for example, glycine, iminodiacatic acid, lysine, threonine, serine, asparaginic acid, parahydroxyphenyl glycine, dihydroxyethyl glycine, alanine, anthranilic acid or tryptophan, sulfamic acid, cyclohexylsulfamic acid, an aliphafiic amine sulfonic acid, for example, taurine, and an aliphatic amine sulfinic acid, for example, aminoethanesulfinic acid. Among them, glycine and iminodiacetic acid are preferable.

Specific examples of the water-soluble amine compound having a phosphonic acid group (including a phosphinic acid group) include 2-aminoethylphosphonic acid, 1-aminoethane-1,1-diphosphonic acid, 1-amino-1-phenylmethane-1,1-diphosphonic acid, 1-dimethylaminoethane-1,1-diphosphonic acid and ethylenediaminopentamethylenephosphonic acid. Particularly, 2-aminoethylphosphonic acid is preferable.

The water-soluble amine compound having a hydroxy group as the group capable of facilitating water-solubility means an alkylamine (State B shown below) having a hydroxy group in its alkyl group and its ion means an ammonium ion (State A shown below) of the amino group. 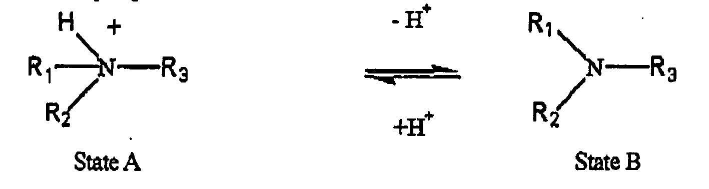
wherein, for example, R₁, R₂ and R₃ each independently represents a hydrogen atom, an alkyl group or an aryl group, provided that at least one of R₁, R₂ and R₃ represents an alkyl group having a hydroxy group.

Examples of the water-soluble amine compound having a hydroxy group include monoethanol amine, diethanol amine, trimethanol amine, triethanol amine, tripropanol amine and triisopropanol amine. Among them, triethanol amine and diethanol amine are preferable. A counter ion of the ammonium group is preferably a chloride ion.

The alkali for use in the adjustment of pH includes, for example, sodium hydroxide, potassium hydroxide, lithium hydroxide, sodium carbonate, potassium carbonate, ammonium carbonate, sodium hydrogen carbonate, potassium hydrogen carbonate, ammonium hydrogen carbonate, an organic alkali agent and combinations thereof. The acid for use in the adjustment of pH includes, for example, an inorganic acid, for example, hydrochloric acid, sulfuric acid or a nitric acid. By adding such an alkali or acid, the pH can be finely adjusted.

The pH of the developer is in a range of 8.5 to 10.8. When the pH is 8.5 or higher, the developing property in the non-image area is well maintained. On the other hand, when the pH is 10.8 or lower, the developer is hardly affected by carbon dioxide in the atmosphere and degradation of the processing ability due to the influence of carbon dioxide can be prevented. The pH of the developer is more preferably in a range of 8.8 to 10.2, and particularly preferably in a range of 9.0 to 10.0.

When the combination of (a) a carbonate ion and a hydrogen carbonate ion is adopted as the pH buffer agent, the total amount of the carbonate ion and hydrogen carbonate ion is preferably from 0.05 to 5 mole/l, more preferably from 0.1 to 2 mole/l, particularly preferably from 0.2 to 1 mole/l, based on the total weight of the aqueous solution. When the total amount is 0.05 mole/l or more, developing property and processing ability are not degraded. When the total amount is 5 mole/l or less, precipitates and crystals hardly generate and since gelation at neutralization of waste liquid of the developer hardly occur, treatment of the waste liquid can be carried out without trouble.

For the purpose of finely adjusting the alkali concentration or aiding dissolution of the photosensitive layer in the non-image area, an alkali agent, for example, an organic alkali agent may be supplementarily used together. Examples of the organic alkali agent include monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine and tetramethylammonium hydroxide. The supplementary alkali agents may be used individually or in combination of two or more thereof.

When (b) borate ion is adopted as the pH buffer agent, the total amount of the borate ion is preferably from 0.05 to 5 mole/l, more preferably from 0.1 to 2 mole/l, particularly preferably from 0.2 to 1 mole/l, based on the total weight of the aqueous solution. When the total amount of borate ion is 0.05 mole/l or more, developing property and processing ability are not degraded. On the other hand, when the total amount of borate ion is 5 mole/l or less, precipitates and crystals hardly generate and since gelation at neutralization of the waste liquid hardly occur, treatment of the waste liquid can be carried out without trouble.

When (c) a water-soluble amine compound and an ion of the amine compound is adopted as the pH buffer agent, the total amount of the water-soluble amine compound and ion of the amine compound is preferably from 0.01 to 1 mole/l based on the total weight of the aqueous solution. When the total amount of water-soluble amine compound and ion of the amine compound is in the range described above, developing property and processing ability are not degraded and treatment of the waste liquid can be easily carried out. The total amount thereof is more preferably in a range of 0.03 to 0.7 mole/l, and particularly preferably in a range of 0.05 to 0.5 mole/l.

The surfactant used in the developer may be any of anionic, nonionic, cationic and amphoteric surfactants.

Examples of the anionic surfactant include fatty acid salts, abietic acid salts, alkyldiphenoxydisulfonic acid salts, hydroxyalkanesulfonic acid salts, alkanesulfonic acid salts, dialkylsulfosuccinic acid salts, straight-chain alkylbenzenesulfonic acid salts, branched alkylbenzenesulfonic acid salts, alkylnaphthalenesulfonic acid salts, alkylphenoxy polyoxyethylene propylsulfonic acid salts, polyoxyethylene alkylsulfophenyl ether salts, N-methyl-N-oleyltaurine sodium salt, N-alkylsulfosuccinic acid monoamide disodium salts, petroleum sulfonic acid salts, sulfated castor oil, sulfated beef tallow oil, sulfate ester slats of fatty acid alkyl ester, alkyl sulfate ester salts, polyoxyethylene alkyl ether sulfate ester salts, fatty acid monoglyceride sulfate ester salts, polyoxyethylene alkyl phenyl ether sulfate ester salts, polyoxyethylene styryl phenyl ether sulfate ester salts, alkyl phosphate ester salts, polyoxyethylene alkyl ether phosphate ester salts, polyoxyethylene alkyl phenyl ether phosphate ester salts, partially saponified products of styrene-maleic anhydride copolymer, partially saponified products of olefin-maleic anhydride copolymer, naphthalene sulfonate formalin condensates, aromatic sulfonic acid salts and aromatic substituted polyoxyethylene sulfonic acid salts. Of the compounds, dialkylsulfosuccinic acid salts, alkyldiphenoxydisulfonic acid salts, alkyl sulfate ester salts and alkylnaphthalenesulfonic acid salts are particularly preferably used.

The cationic surfactant is not particularly limited and conventionally known cationic surfactants can be used. Examples of the cationic surfactant include alkylamine salts, quaternary ammonium salts, polyoxyethylene alkyl amine salts and polyethylene polyamine derivatives.

Examples of the nonionic surfactant include polyethylene glycol type higher alcohol ethylene oxide addacts, alkylphenol ethylene oxide addacts, polyethylene glycol adducts of aromatic compound, fatty acid ethylene oxide addacts, polyhydric alcohol fatty acid ester ethylene oxide addacts, higher alkylamine ethylene oxide addacts, fatty acid amide ethylene oxide addacts, ethylene oxide addacts of fat, polypropylene glycol ethylene oxide addacts, dimethylsiloxane-ethylene oxide block copolymers, dimethylsiloxane-(propylene oxide-ethylene oxide) block copolymers, fatty acid esters of polyhydric alcohol type glycerol, fatty acid esters of pentaerythritol, fatty acid esters of sorbitol and sorbitan, fatty acid esters of sucrose, alkyl ethers ofpolyhydric alcohols and fatty acid amides of alkanolamines.

In the invention, polyethylene glycol type higher alcohol ethylene oxide addacts, polyethylene glycol adducts of aromatic compound, ethylene oxide addacts of sorbitol and/or sorbitan fatty acid esters, polypropylene glycol ethylene oxide addacts, dimethylsiloxane-ethylene oxide block copolymers, dimethylsiloxane-(propylene oxide-ethylene oxide) block copolymers and fatty acid esters of polyhydric alcohols are more preferable.

Further, from the standpoint of stable solubility in water or opacity, with respect to the nonionic surfactant, the HLB (hydrophile-lipophile balance) value thereof is preferably 6 or more, and more preferably 8 or more. Furthermore, an oxyethylene adduct of acetylene glycol type or acetylene alcohol type or a surfactant, for example, of fluorine-based or silicon-based can also be used.

The surfactants may be used individually or in combination of two or more thereof. The content of the surfactant in the developer is preferably from 0.01 to 10% by weight, and more preferably from 0.01 to 5% by weight.

The amphoteric surfactant is a compound having an anionic site and a cationic site in its molecule as well known in the field of surfactant and includes, for example, amphoteric surfactants of amino acid type, betain type and amine oxide type. As the amphoteric surfactant used in the developer for use in the invention, a compound represented by formula <1> shown below or a compound represented by formula <2> shown below is preferable.

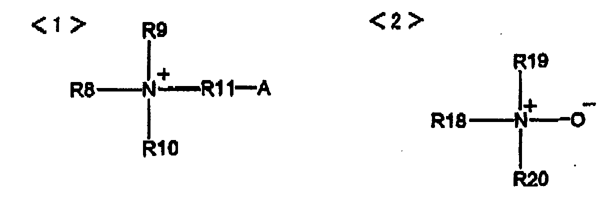

In formula <1>, R8 represents an alkyl group, R9 and R10 each represents a hydrogen atom or an alkyl group, R11 represents an alkylene group, and A represents a carboxylate ion or a sulfonate ion.

In formula <2>, R18, R19 and R20 each represents a hydrogen atom or an alkyl group, provided that all of R18, R19 and R20 are not hydrogen atoms at the same time.

In formula <1>, the alkyl group represented by R8, R9 or R10 or the alkylene group represented by R11 may be a straight chain or branched structure, may contain a connecting group in the chain thereof and may have a substituent. As the connecting group, a connecting group containing a hetero atom, for example, an ester bond, an amido bond or an ether bond is preferable. As the substituent, a hydroxy group, an ethylene oxide group, a phenyl group, an amido group or a halogen atom is preferable.

In the compound represented by formula <1>, as the total number of carbon atoms increases, the hydrophobic portion becomes large and dissolution of the compound in an aqueous developer becomes difficult. In such a case, the dissolution is improved by adding a dissolution auxiliary agent, for example, an organic solvent, e.g., an alcohol. However, when the total number of carbon atoms excessively increases, the surfactant can not be dissolved in the proper amount in some case, Therefore, the total number of carbon atoms included in R8 to R1 in formula <1> is preferably from 8 to 25, and more preferably from 11 to 21.

In formula <2>, the alkyl group represented by R18, R19 or R20 may be a straight chain or branched structure, may contain a connecting group in the chain thereof and may have a substituent. As the connecting group, a connecting group containing a hetero atom, for example, an ester bond, an amido bond or an ether bond is preferable. As the substituent, a hydroxy group, an ethylene oxide group, a phenyl group, an amido group or a halogen atom is preferable.

In the compound represented by formula <2>, as the total number of carbon atoms increases, the hydrophobic portion becomes large and dissolution of the compound in an aqueous developer becomes difficult. In such a case, the dissolution is improved by adding a dissolution auxiliary agent, for example, an organic solvent, e.g., an alcohol. However, when the total number of carbon atoms excessively increases, the surfactant can not be dissolved in the proper amount in some cases. Therefore, the total number of carbon atoms included in R18 to R20 in formula <2> is preferably from 8 to 22, and more preferably from 10 to 20.

The total number of carbon atoms in the amphoteric surfactant may be influenced depending on property of the material used in the photosensitive layer, especially, a binder polymer. When the binder polymer having high hydrophilicity is used, it tends to be preferable that the total number of carbon atoms is relatively small. On the other hand, when the binder having low hydrophilicity is used, it tends to be preferable that the total number of carbon atoms is relatively large.

Preferable specific examples of the amphoteric surfactant for use in the developer are set forth below, but the invention should not be construed as being limited thereto.

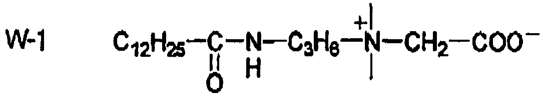

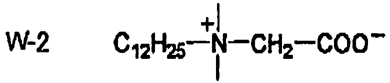

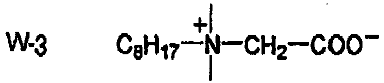

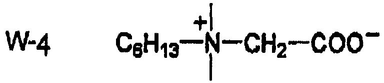

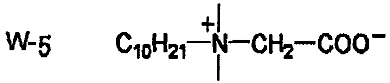

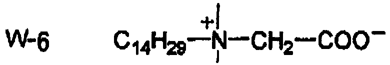

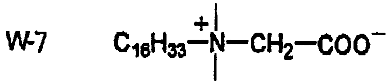

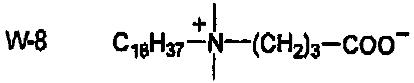

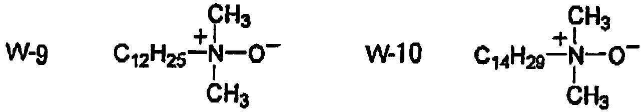

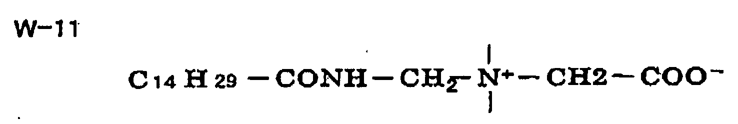

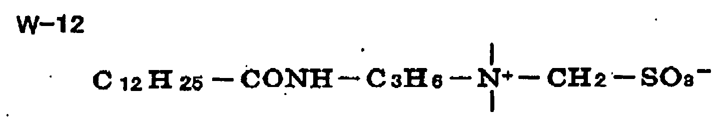

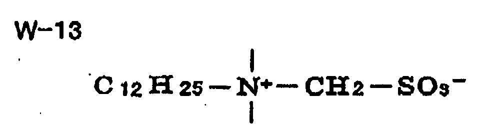

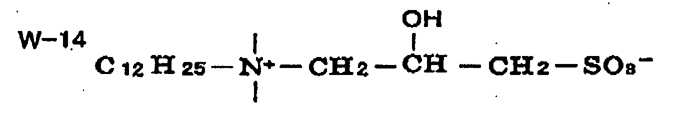

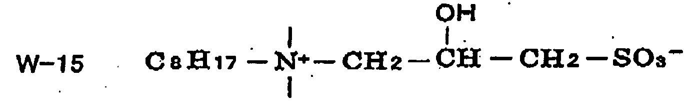

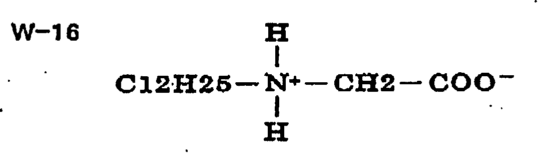

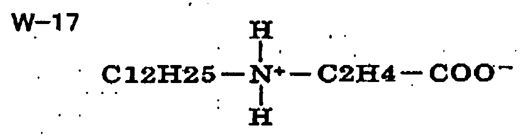

The developer for use in the invention may contain a wetting agent, an antiseptic agent, a chelating agent, a defoaming agent, an organic solvent, an inorganic acid, an inorganic salt, a water-soluble resin or the like in addition the components described above.

As the wetting agent, for example, ethylene glycol, propylene glycol, triethylene glycol, butylene glycol, hexylene glycol, diethylene glycol, dipropylene glycol, glycerin, trimethylol propane or diglycerin is preferably used. The wetting agents may be used individually or in combination of two or more thereof. The wetting agent is ordinarily used in an amount of 0.1 to 5% by weight based on the total weight of the developer.

As the antiseptic agent, for example, phenol or a derivative thereof, formalin, an imidazole derivative, sodium dehydroacetate, a 4-isothiazolin-3-one derivative, benzisotiazolin-3-one, 2-methyl-4-isothiazolin-3-one, a benzotriazole derivative, an amidine guanidine derivative, a quaternary ammonium salt, a pyridine derivative, a quinoline derivative, a guanidine derivative, diazine, a triazole derivative, oxazole, an oxazine derivative or a nitrobromoalcohol-based compound, e.g., 2-bromo-2-nitropropane-1,3-diol, 1,1-dibromo-1-nitro-2-ethanol or 1,1-dibromo-1-nitro-2-propanol is preferably used. It is preferred to use two or more kinds of the antiseptic agents so as to exert the effect to various molds and bacteria. The amount of the antiseptic agent added is an amount stably exerts the effect to bacterium, molds, yeast or the like. Although the amount of the antiseptic agent may be varied depending on the kind of the bacterium, molds, yeast or the like, it is preferably in a range of 0.01 to 4% by weight based on the developer.

As the chelating agent, for example, ethylenediaminetetraacetic acid, potassium salt thereof, sodium salt thereof; diethylenetriaminepentaacetic acid, potassium salt thereof, sodium salt thereof; triethylenetetraminehexaacetic acid, potassium salt thereof, sodium salt thereof; hydroxyethylethylenediaminetriacetic acid, potassium salt thereof, sodium salt thereof; nitrilotriacetic acid, sodium salt thereof; organic phosphonic acids, for example, 1-hydroxyethane-1,1-diphosphonic acid, potassium salt thereof, sodium salt thereof, aminotri(methylenephosphonic acid), potassium salt thereof, sodium salt thereof; and phosphonoalkanetricarboxylic acids are illustrated, A salt of an organic amine is also effectively used in place of the sodium salt or potassium salt in the chelating agent.

The chelating agent is so selected that it is stably present in the developer and does not impair the printing property. The amount of the chelating agent added is preferably from 0.001 to 1.0% by weight based on the developer.

As the defoaming agent, for example, a conventional silicone-based self-emulsifying type or emulsifying type defoaming agent, or a nonionic compound having HLB of 5 or less is used. The silicone defoaming agent is preferably used. Any of emulsifying dispersing type and solubilizing type can be used. The amount of the defoaming agent added is preferably from 0.001 to 1.0% by weight based on the developer.

As the organic solvent, for example, an aliphatic hydrocarbon (e.g., hexane, heptane, Isopar E, Isopar H, Isopar G (produced by Esso Chemical Co., Ltd.), gasoline or kerosene), an aromatic hydrocarbon (e.g., toluene or xylene), a halogenated hydrocarbon (methylene dichloride, ethylene dichloride, trichlene or monochlorobenzene) or a polar solvent is exemplified.

Examples of the polar solvent include an alcohol (e.g., methanol, ethanol, propanol, isopropanol, benzyl alcohol, ethylene glycol monomethyl ether, 2-ethyoxyethanol, diethylene glycol monoethyl ether, diethylene glycol monohexyl ether, triethylene glycol monomethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, methyl phenyl carbinol, n-amyl alcohol or methylamyl alcohol), a ketone (e.g., acetone, methyl ethyl ketone, ethyl butyl ketone, methyl isobutyl ketone or cyclohexanone), an ester (e.g., ethyl acetate, propyl acetate, butyl acetate, amyl acetate, benzyl acetate, methyl lactate, butyl lactate, ethylene glycol monobutyl acetate, polyethylene glycol monomethyl ether acetate, diethylene glycol acetate, diethyl phthalate or butyl levulinate) and others (e.g., triethyl phosphate, tricresyl phosphate, N-phenylethanolamine or N-phenyldiethanolamine).

Further, when the organic solvent is insoluble in water, it may be employed by being solubilized in water using a surfactant or the like. In the case where the developer contains the organic solvent, the concentration of the organic solvent is desirably less than 40% by weight in view of safety and inflammability.

As the inorganic acid or inorganic salt, for example, phosphoric acid, methaphosphoric acid, ammonium primary phosphate, ammonium secondary phosphate, sodium primary phosphate, sodium secondary phosphate, potassium primary phosphate, potassium secondary phosphate, sodium tripolyphosphate, potassium pyrophosphate, sodium hexamethaphosphate, magnesium nitrate, sodium nitrate, potassium nitrate, ammonium nitrate, sodium sulfate, potassium sulfate, ammonium sulfate, sodium sulfate, ammonium sulfite, sodium hydrogen sulfate or nickel sulfate is illustrated. The amount of the inorganic acid or inorganic salt added is preferably from 0.01 to 0.5% by weight based on the total weight of the developer.

As the water-soluble resin which can be contained in the developer used in the invention, for example, soybean polysaccharide, modified starch, gum arabic, dextrin, a cellulose derivative (for example, carboxymethyl cellulose, carboxyethyl cellulose or methyl cellulose) or a modified product thereof, pllulan, polyvinyl alcohol or a derivative thereof, polyvinyl pyrrolidone, polyacrylamide, an acrylamide copolymer, a vinyl methyl ether/maleic anhydride copolymer, a vinyl acetate/maleic anhydride copolymer or a styrene/maleic anhydride copolymer is exemplified. An acid value of the water-soluble resin is preferably from 0 to 3.0 meq/g.

As the soybean polysaccharide, those conventionally known can be used. For example, as a commercial product, Soyafive (produced by Fuji Oil Co., Ltd.) is available and various grade products can be used. The soybean polysaccharide preferably used has viscosity in a range of 10 to 100 mPa/sec in a 10% by weight aqueous solution thereof.

As the modified starch, that represented by formula (III) shown below is exemplified. As a starch represented by formula (III), any starch, for example, of corn, potato, tapioca, rice or wheat can be used. The modification of starch can be performed, for example, by a method wherein starch is decomposed, for example, with an acid or an enzyme to an extent that the number of glucose residue per molecule is from 5 to 30 and then oxypropylene is added thereto in an alkali.

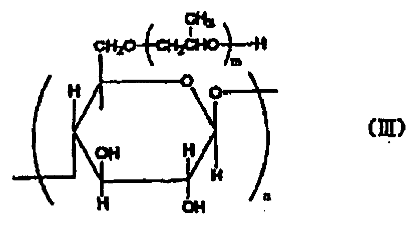

In formula (III), the etherification degree (substitution degree) is in a range of 0.05 to 1.2 per glucose unit, n represents an integer of 3 to 30, and m represents an integer of 1 to 3.

Examples of the modified starch and the derivative thereof include roast starch, for example, British gum, an enzymatically modified dextrin, for example, enzyme dextrin or Shardinger dextrin, oxidized starch, for example, solubilized starch, alphalized starch, for example, modified alphalized starch or unmodified alphalized starch, esterified starch, for example, starch phosphate, starch of fatty acid, starch sulfate, starch nitrate, starch xanthate or starch carbamate, etherified starch, for example, carboxyalkyl starch, hydroxyalkyl starch, sulfoalkyl starch, cyanoethyl starch, allyl starch, benzyl starch, carbamylethyl starch or dialkylamino starch, cross-linked starch, for example, methylol cross-linked starch, hydroxyalkyl cross-linked starch, phosphoric acid cross-linked starch or dicarboxylic acid cross-linked starch, and starch graft copolymer, for example, starch-polyacrylamide copolymer, starch-polyacrylic acid copolymer, starch-polyvinyl acetate copolymer, starch-polyacrylonitrile copolymer, cationic starch-polyacrylate copolymer, cationic starch-vinyl polymer copolymer, starch-polystyrene-maleic acid copolymer, starch-polyethylene oxide copolymer or starch-polypropylene copolymer.

Of the water-soluble resins, for examples, soybean polysaccharide, modified starch, gum arabic, dextrin, carboxymethyl cellulose or polyvinyl alcohol is preferable.

The water-soluble resins may be used in combination of two or more. The content of the water-soluble resin is preferably from 0.1 to 20% by weight, more preferably from 0.5 to 10% by weight, based on the developer.

The development step using the processing solution described above is described in more detail below. A conventional processing process comprises removing a protective layer in a pre-water washing step, conducting alkali development, removing the alkali in a post-water washing step, conducting gum treatment in a gumming step and drying in a drying step. On the contrary, in the method of preparing a lithographic printing plate according to the invention, it is possible to conduct the development and gumming at the same time by further incorporating the water-soluble resin described above into the processing solution having pH of 8.5 to 10.8 and containing a low molecular weight hydroxycarboxylate ion, a pH buffer agent and a surfactant. Thus, the post-water washing step and gumming step are not particularly necessary, and after conducting the development and gumming with one solution in a mono-developing bath, the drying step can be performed. Moreover, since the removal of protective layer can also be conducted simultaneously with the development and gumming, the pre-water washing step is also unnecessary. It is preferred that after the development and gumming, the excess processing solution is removed using a squeeze roller or the like, followed by drying.

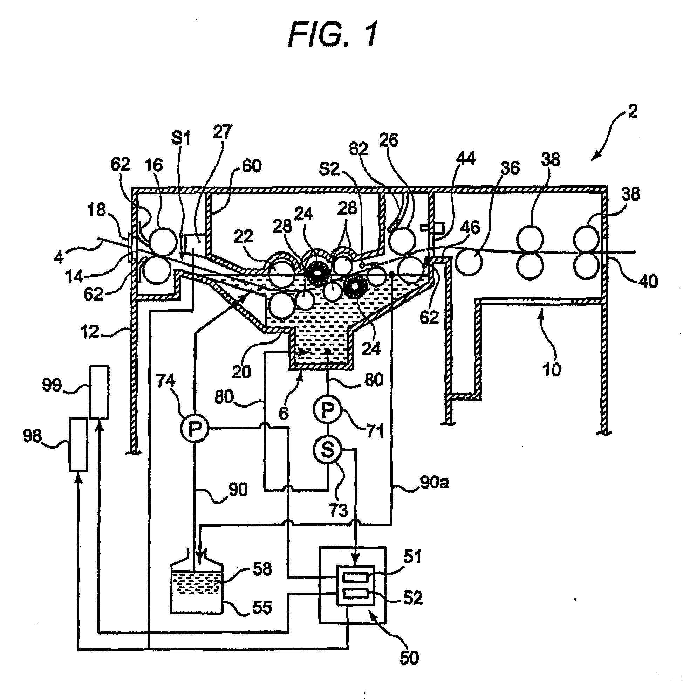

The development step can be preferably performed using an automatic developing apparatus equipped with a rubbing member. In Fig. 1, one example of the automatic developing apparatus is shown. The automatic developing apparatus 2 shown in Fig. 1 comprises a developing unit 6 for developing and further gumming a lithographic printing plate precursor (hereinafter, also referred to as a "PS plate") 4 and a drying unit 10 for drying the developed PS plate 4.

An insertion slot 14 was formed in a side plate 12 of the automatic developing apparatus and the PS plate 4 inserted through the insertion slot 14 was transported into the developing unit 6 by transport rollers (carrying-in rollers) 16 along a processing path line indicated by a dashed line in Fig 1. The insertion slot 14 is provided with a rubber blade 18 and when the PS plat 4 is not inserted therethrough, the insertion slot 14 is closed by the rubber blade 18.

In a developing tank 20 in the developing unit 6, a developer 58 having pH of 8.5 to 10.8 and containing a low molecular weight hydroxycarboxylate ion, a pH buffer agent, a surfactant and a water-soluble resin as described above is charged and transport rollers 22, brush rollers 24 and squeeze rollers 26 are provided in order from the upstream side in the transporting direction and backup rollers 28 are disposed in appropriate positions therebetween. The PS plate 4 is immersed in the developer while being transported by the transport rollers 22 and the non-image area of PS plate 4 was removed by rotation of the brush rollers 24 to conduct development processing. This is described in more detail hereinafter. The PS plate 4 subjected to the development processing is transported into the drying unit 10 by the squeeze rollers (carrying-out rollers) 26.

In the drying unit 10, a guide roller 36 and a pair of skewer rollers 38 are disposed in order from the upstream side in the transporting direction. In the drying unit 10, drying means, for example, hot air supply means or heat generating means (not shown) is also provided, A discharge slot 40 is provided in the drying unit 10 and the PS plate 4 dried by the drying means is discharged through the discharge slot 40. A shutter 44 is disposed in a passage 46 between the drying unit 10 and the developing unit 6 and when the PS plate 4 does not pass through the passage 46, the passage 46 is closed by the shutter 44.

Reference numeral 98 is a display device to visually show various necessary information and reference numeral 99 is an alarm device to aurally tell them.

Now, the developing unit 6 is described in detail below.

The developing tank 20 is provided with a box-shaped shielding cover 60 as integrated with the tank wall. The bottom wall of the shielding cover 60 is continuously arc-wise curved so as not to be in contact with the upper peripheral surfaces of the transport roller 22, the brush roller 24 and the backup roller 28, and not to interfere with the rollers.

Since the shielding cover 60 is box-shaped, an airtight space is formed above the development tank 20 and the amount of air inside the developing unit 6 is kept as small as possible. In addition, since the shielding cover 60 is disposed, the contact area between the developer and air is kept as small as possible.

In the automatic developing apparatus 2 having the constitution described above, a rubber blade 62 is disposed at its inlet, as kept in contact with the carrying-in roller 16 and thus the developing unit 6 is so designed as to be substantially airtight from the external atmosphere and the open air does not flow into it.

A rubber blade 62 is also disposed at its outlet of the developing unit 6, as kept in contact with the carrying-out roller 26 and thus the developing unit 6 is so designed as to be substantially airtight from the external atmosphere, and the air inside the drying unit 10 does not flow into the developing unit 6. Therefore, although some air may flow into the developing unit 6 while the PS plate 4 pass through it, the developing unit 6 is substantially kept airtight, and has a closed constitution with little air flowing thereinto.

To the developing tank 20, a first circulation pipeline 80 of developer is connected. The first circulation pipeline 80 has a developer circulation pump 71, a conductivity sensor 73 and a filter (not shown) disposed therein.

The developer circulation pump 71 acts to suck the developer in the developing tank 20 through a suction hole at the bottom of the developing tank 20 into the first circulation pipeline 80, and acts to make the developer pass through the first circulation pipeline 80 to be again ejected into the developing tank 20. The filter is to filtrate the developer passing through the first circulation pipeline 80. The conductivity sensor 73 is to measure conductivity of the developer passing through the first circulation line 80.

In the developing unit 6, a second circulation pipeline 90, an external tank 55 connected to the second circulation pipeline 90 and a developer supply pump 74 disposed in the second circulation pipeline 90 are disposed, and the developer overflowed from the developing tank 20 is returned to the external tank 55 via the second circulation pipeline 90. Since the developer overflowed is returned to the external tank 55, the liquid level of the developer 58 in the developing tank 20 can be keep constant by the simple constitution.

More specifically, a pair of second circulation pipelines 90, 90a for replenishing the developer 58 is disposed near the developing tank 20. The second circulation pipeline 90 for the developer 58 is connected to the external tank 55 at its one end (lower end in Fig. 1) and in the pipeline, the developer supply pump 74 is disposed. The developer supply pump 74 measures and supplies the developer 58 from the external tank 55 into the developing tank 20. Specifically, the second circulation pipeline 90, the developer supply pump 74 and the external tank 55 constitute the developer circulation means.

The developer supply pump 74 is controlled by a control device 50 provided with control ROM and RAM 51 with memory of developer replenishment conditions and the like inputted therein and a timekeeper 52 based on a plate detection sensor 27 and the timekeeper 52. Specifically, based on the signal from the plate detection sensor 27 capable of detecting the presence or absence of plate transport and measuring the plate area and the like of the transported plate, the control device 50 controls the developer supply pump 74 to conduct the developer replenishment depending on the replenishment condition set in accordance with the actual running conditions of the automatic development apparatus 2. Thus, the control unit 50 replenishes the developer 58 corresponding to the necessary amount for the replenishment condition from the external tank 55, for example, for every processing of each one plate. The processing replenishment may not be designed to conduct for each one plate but may be designed to conduct after processing of plural plates.

In the automatic developing apparatus 2, the PS plate 4 passed through the transport roller pair 16 on the carrying-in side is transported in a downward direction than the horizontal direction and immersed in the developer 58 to be transported in the developer 58. The image-recording surface of the PS plate 4 is rubbed with a brush roller (rubbing member) 24 while the image-recording surface is immersed in the developer 58 to remove the unexposed area of the image-recording layer of the PS plate 4, thereby performing development. Since the plate is rubbed while it is immersed in the developer 58 filled in the developing tank 20, scattering of the developer 58 hardly occurs. Accordingly, the contamination inside the developing apparatus owing to the scattering of developer and the occurrence of scum are prevented.

The rubbing member may be any one capable of being used as a member for rubbing the image-recording surface of the PS plate 4. In particular, a member capable of rotating around its rotation axis as the center thereof to rub the image-recording surface (for example, a known channel brush, a twisted brush, a planted brush, a carpet brush or a Moulton roller) is preferably used. When the plate is rubbed with a rotating brush roller 24 while immersed in the developer 58, the brush roller 24 is immersed in the developer 58 preferably to a degree of at least 1/3 of the diameter thereof, more preferably to a degree of at least 1/2 thereof, from the standpoint of preventing the developer from scattering.

As the channel brush, brushes produced by spirally winding a long so-called channel brush (strip brush) around a surface of a roller body as described in JP-UM-A-62-167253 (the term "JP-UM-A" as used herein means an "unexamined Japanese published utility model application"), JP-UM-A-4-63447, JP-UM-A-4-64128 and JP-A-6-186751 are used.

As the twisted brush, brushes produced by inserting a twisted brush into a spiral groove formed on the surface of a shaft thereby spirally winding it around the shaft as described in JP-A-3-87832 are used.

As the planted brush, brushes produced according to a method of planting a brush material in small holes formed in a shaft roller are used.

As the carpet brush, brushes produced by winding a long and thin strip of textile woven with wool material around a peripheral surface of a shaft roller as described in JP-A-2001-5193 and JP-A-2001-66788 are used.

As the Moulton roller, brushes produced by covering a roller body with a sliding sleeve of a woven fibrous material and firmly tightening the sleeve on the mounted side thereof as described in JP-A-10-198044 are used.

In case where a rotating brush roller 24 is used as the rubbing member, the number of revolution of the rubbing member is preferably as large as possible for improving the removability of the image-recording layer in the unexposed area of the PS plate 4. However, from the standpoint of the durability and the production cost of the automatic developing apparatus and of prevention of scattering of the developer 58 and damage of the exposed area of the PS plate 4, it is preferably from 30 to 1,000 rpm, and more preferably from 50 to 500 rpm.

A number of the brush roller 24 is at least one and plural brush rollers may also be used. In case where 2 or more brush rollers are used, at least one of them may be rotated in the direction opposite to the processing direction of the PS plate 4. Further, the development processing may be performed while the brush roller 24 is rocked in the rotary axis direction. By rocking the brush roller 24 in the rotary axis direction, the non-image area of the PS plate 4 may be removed more effectively and a lithographic printing plate having better quality can be prepared.

As a material of the brush for the brush roller 24, natural fibers, for example, horsehair or pig hair, artificial fibers, metal fibers and the like are known. In view of the chemical resistance thereof, artificial fibers are preferable. Examples of the artificial fiber usable include polyamides, for example, nylon 6, nylon 6.6, nylon 6.10, nylon 6.12 or nylon 12, polyesters, for example, polyethylene terephthalate or polybutylene terephthalate (PBT), polyacrylics, for example, polyacrylonitrile or alkyl poly(meth)acrylate, polyolefins, for example, polyethylene, polypropylene, polystyrene, polyvinyl chloride or polyvinylidene chloride, celluloses, for example, acetyl cellulose, polyurethanes, for example, polyurethane, polyphenylene sulfide and fluorine resins, for example, ethylene/tetrafluoroethylene copolymer or polyvinylidene fluoride. In consideration of the elasticity, rigidity, abrasion resistance, heat resistance, chemical resistance, water absorbability and hygroscopic property thereof, nylon 6, nylon 6.6, nylon 6.10, nylon 6.12, nylon 12, polypropylene, polybutylene terephthalate and polyethylene terephthalate are preferable and nylon 6.6, nylon 6.10, nylon 6.12, nylon 12, polybutylene terephthalate (PBT) and polypropylene are more preferable. Of the polyesters, polybutylene terephthalate (PBT) is particularly preferable. Of the polyolefins, polypropylene is particularly preferable.

A size of the bristle of the brush is not particularly restricted and is preferably from 0.01 to 1.0 mm, and more preferably from 0.1 to 0.5 mm. When the size of the bristle of the brush is smaller than 0.01 mm, the rubbing property may become poor and when it is larger than 1.0 mm, rubbing scratches may be formed on the surface of the plate. A length of the bristle of the brush is also not particularly restricted and is ordinarily from 3 to 50 mm. When the length is shorter than 3 mm, the touch of the brush to the PS plate 4 may become uneven and the brush may often give rubbing scratches to the surface of the plate. When it is longer than 50 mm, it does not give any more advantage of development processing and it is economically disadvantageous. In case of the Moulton roller, since it has a sliding sleeve of a woven material, it is not necessary to define the size and the length of the bristle thereof.

The rubbing treatment with the brush roller 24 is more effectively conducted in case where the PS plate is immersed in the developer, kept therein for a predetermined period of time and then rubbed. According to the development in the automatic developing apparatus 2, the developer 58 first penetrates into the photosensitive layer of the PS plate 4, and then removal of the photosensitive layer in the non-image area is conducted in a simple manner. Accordingly, when the PS plate is immersed in the developer 58 prior to the rubbing treatment, the photosensitive layer may be more effectively removed. According to the experiments, the lapse of time therefor before rubbing is at least 2 seconds after the part to be removed has been immersed in the liquid or has been sprayed with the liquid, more preferably at least 5 seconds, and still more preferably at least 10 seconds. Since the development processing is ordinarily performed within 60 seconds, the lapse of time shall be inevitably shorter than 50 seconds.

Using a spray tube S1 or the like, the photosensitive layer of the PS plate may be contacted with the developer 58 before immersed in the developer 58 in the developing tank 20. In this case, the developer to be sprayed may be the developer in the external tank 55 or may be a fresh developer prepared in a separate tank. Since the time to be taken for the rubbing treatment conducted in the developer 58 in the developing tank 20 after the contact of the photosensitive layer with the developer 58 may be longer, the development may be performed more effectively. Also, by contacting the photosensitive layer with the developer 58 before immersed in the developer 58 in the developing tank 20, the time to be taken for rubbing the plate after immersed in the developer 58 in the developing tank 20 may appropriately reduced. Further, a method of vibrating the PS plate 4 while contacted with the developer 58 may also be appropriately employed in order to promote the penetration of liquid into the PS plate 4.

Thus, when the time to be taken from the immersion of the PS plate 4 in the developer 58 in the developing tank 20 to the leaving of the PS plate 4 from the developer 58 is represented by t sec, the rubbing treatment with the rubbing member 24 is preferably conducted after t/2 seconds or later. Therefore, it is desirable that the development is performed at the intermediate or in the latter part of the developing tank 20. Needless-to-say, in case where the length of the developing tank 20 is increased or the transportation speed is lowered to prolong the time for immersion in the developer 58, the rubbing treatment may be conducted in the former part of the developing tank. However, for the purpose of performing stable development processing all of the time, it is designed that the rubbing treatment with the brush roller 24 is conducted at the intermediate or in the latter part of the developing tank.

After the development processing using the brush roller 24, the PS plate 4 is left from the developer 58 in the developing tank 20. Although depending on the process condition, when the developer 58 is fatigued in this time, scum may readily adhere to the plate in some cases. Even in such a case, the developer 58 in the external tank 55 that is less fatigued than the developer 58 used during the immersion treatment is directly ejected onto the PS plate 4 through a spray tube S2, whereby foreign materials, for example, the scum adhered onto the PS plate can be removed.

The removal of scum by the spraying is extremely effective when the degree of fatigue of the developer 58 in the developing tank 20 is high as described above. In the circulation system for ejecting through the spray tube S2, a filter especially having a small pore size can be appropriately used.

The PS plate 4 that has been subjected to development processing in the developing unit 6 is then dried in the drying unit 10. In the case where the developer 58 contains a water-soluble resin and the treatments of development and gumming are completed only in one bath of the developer 58 in the developing tank 20, the processing steps can be simplified, the apparatus cost can be reduced and the process space can be reduced. In addition, a liquid for gumming is eliminated and the amount of waste liquid can be reduced.

Moreover, since the developer 58 is circulated between the developing bath 20 and the external tank 55 while keeping constant a liquid level of the developer 58 in the developing tank 20, the liquid level of the developer is kept at a fixed level, whereby the development processing is stabilized. Furthermore, in a constitution where a developer stays only in a developing bath, the developer that may still have a developing ability is partly discarded as a waste liquid. However, in the invention, since the developer 58 is circulated, the utilization ratio of developing ability of the developer 58 can be increased, the life of the developer 58 can be prolonged and the amount of waste liquid can be reduced.

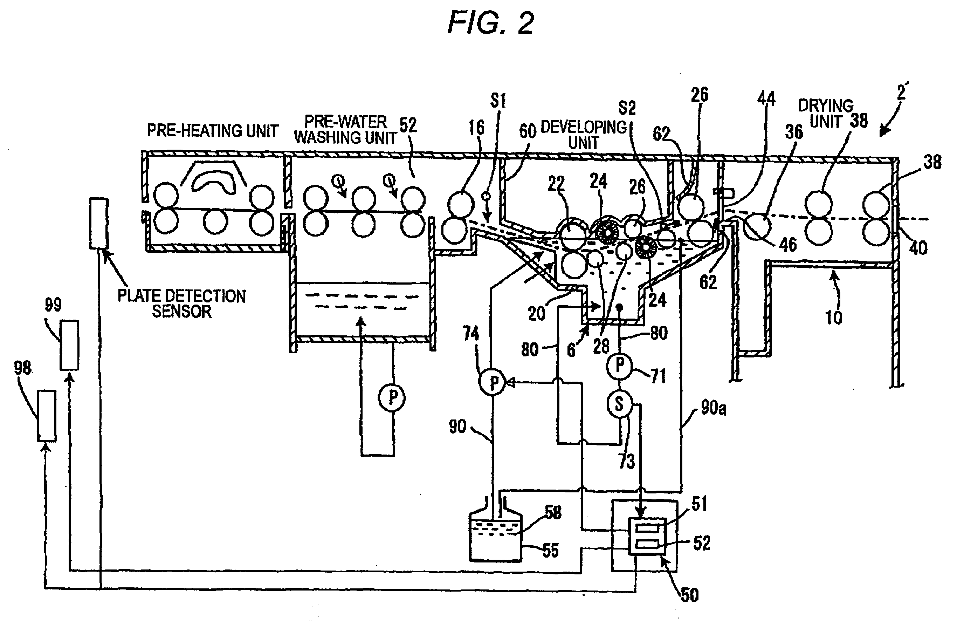

In the method of preparing a lithographic printing plate as described above, the entire surface of the lithographic printing plate precursor may be heated between the exposure and the development, if desired. By the heating, the image-forming reaction in the image-recording layer is accelerated and advantages, for example, improvement in the sensitivity and printing durability and stabilization of the sensitivity may be achieved. In Fig. 2, an example of an automatic developing apparatus is shown which is designed so that the lithographic printing plate precursor is heated between the exposure and the development. In the automatic developing apparatus shown in Fig. 2, the elements common to those in the automatic developing apparatus 2 as described above have the same reference numerals and the descriptions thereof are simplified or omitted.

The automatic developing apparatus 2' shown in Fig. 2 is different from the automatic developing apparatus 2 as described above in that a preheating unit and a pre-water washing unit are disposed upstream the developing unit 6. The preheating unit is disposed upstream the developing unit 6 in the transporting direction and functions to maintain the surface temperature of the PS plate at a predetermined temperature for a predetermined time while the PS plate is transported. The pre-water washing unit is disposed upstream the developing unit 6 in the transporting direction and downstream the preheating unit in the transporting direction and functions to wash and cool the surface of the PS plate with washing water while the PS plate is transported. The PS plate passed through the pre-water washing unit is, as the state of being washed, automatically transported to the next step of the developing unit 6. According to the introduction of these steps, the image-forming reaction in the image-recording layer is accelerated and advantages, for example, improvement in the sensitivity and printing durability and stabilization of the sensitivity may be achieved. The step of the pre-water washing unit may be omitted in some cases.

The conditions of the heating can be appropriately determined in a range for providing such effects. Examples of the heating means include a conventional convection oven, an IR irradiation apparatus, an IR laser, a microwave apparatus or a Wisconsin oven. For instance, the heat treatment can be conducted by maintaining the lithographic printing plate precursor at a plate surface temperature ranging from 70 to 150°C for a period of one second to 5 minutes, preferably at 80 to 140°C for 5 seconds to one minute, more preferably at 90 to 130°C for 10 to 30 seconds. In the above-described range, the effects described above are efficiently achieved and an adverse affect, for example, change in shape of the lithographic printing plate precursor due to the heat can be preferably avoided.

It is preferable that heat treatment means used in the heat treatment step is connected with a plate setter used in the exposure step and a developing apparatus used in the development processing step and the lithographic printing plate precursor is subjected to automatically continuous processing. Specifically, a plate making line wherein the plate setter and the developing apparatus are connected with each other by transport means, for example, a conveyer is illustrated. Also, the heat treatment means may be placed between the plate setter and the developing apparatus or the heat treatment means and the developing apparatus may constitute a unit apparatus.

In case where the lithographic printing plate precursor used is apt to be influenced by surrounding light under a working environment, it is preferable that the plate making line is blinded by a filter, a cover or the like.

The entire surface of lithographic printing plate after development may be exposed to active ray, for example, ultraviolet light to accelerate curing of the image area. As a light source for the entire surface exposure, for example, a carbon arc lamp, a mercury lamp, a gallium lamp, a metal halide lamp, a xenon lamp, a tungsten lamp or various laser beams is exemplified, In order to obtain sufficient printing durability, the amount of the entire surface exposure is preferably 10 mJ/cm² or more, and more preferably 100 mJ/cm² or more.

Heating may be performed at the same time with the entire surface exposure. By performing the heating, further improvement in the printing durability is recognized. Examples of the heating means include a conventional convection oven, an IR irradiation apparatus, an IR laser, a microwave apparatus or a Wisconsin oven. The plate surface temperature at the heating is preferably from 30 to 150°C, more preferably from 35 to 130°C, and still more preferably from 40 to 120°C. Specifically, a method described in JP-A-2000-89478 can be used.

Further, for the purpose of increasing printing durability, the lithographic printing plate after development can be heated under very strong conditions. The heat temperature is ordinarily in a range of 200 to 500°C. When the temperature is too low, a sufficient effect of strengthening the image may not be obtained, whereas when it is excessively high, problems of deterioration of the support and thermal decomposition of the image area may occur sometimes.

The lithographic printing plate thus-obtained is mounted on an off-set printing machine to use for printing a large number of sheets.

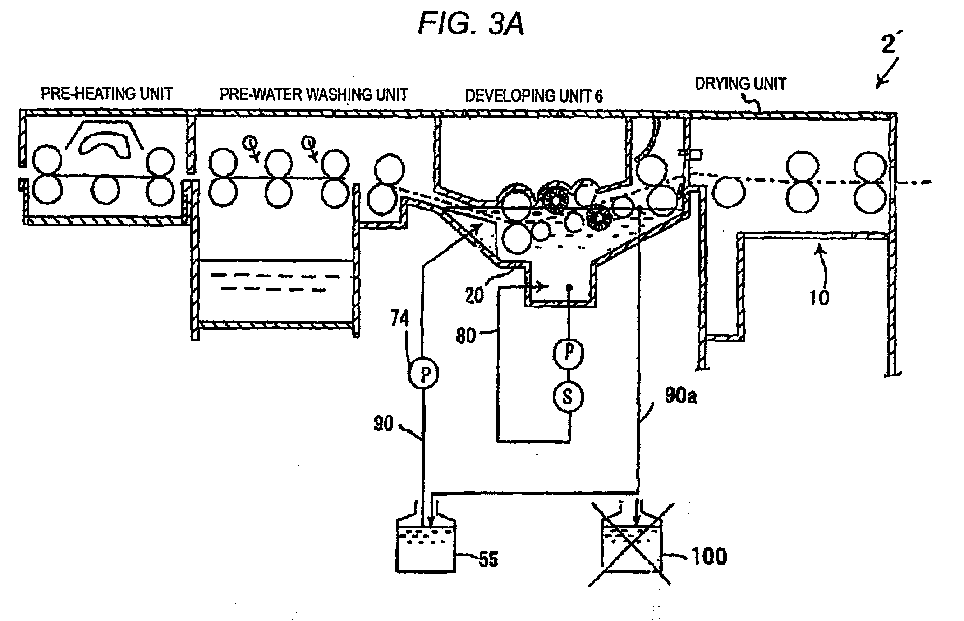

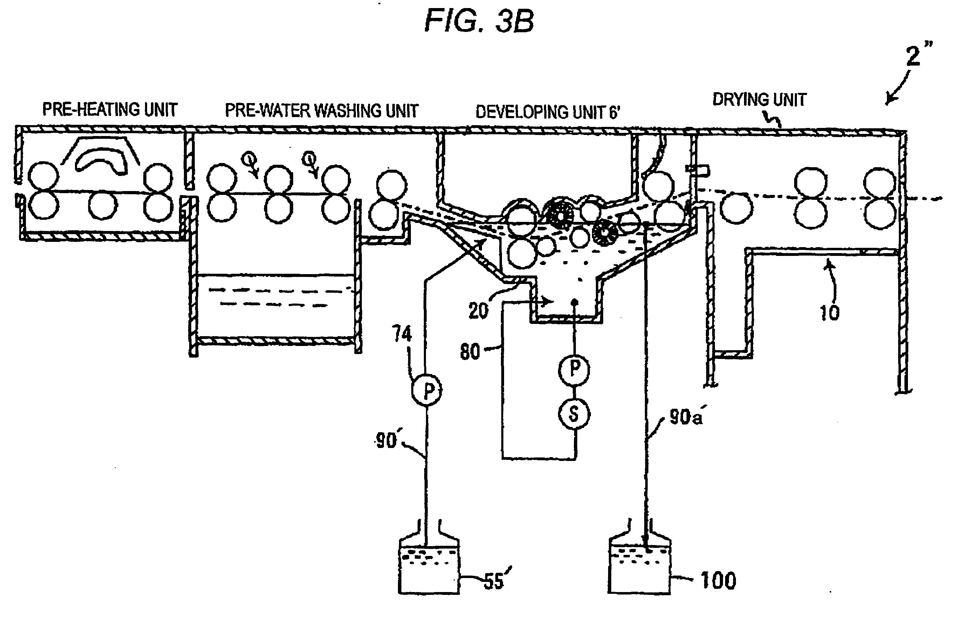

In Fig. 3A, the automatic developing apparatus 2' shown in Fig. 2 is shown and in Fig. 3B, a conventional automatic developing apparatus which is similar to the automatic developing apparatus 2' but does not have an external tank for circulating a developer to a developing bath.

The processing step in the automatic developing apparatus 2" shown in Fig. 3B comprises developing and gumming by immersion in a developer in a developing unit 6' after passing through a pre-heating unit and a pre-water washing unit and then drying in a drying unit

The developer used in the developing unit 6' is supplied from a developer storage tank 55' to the developing tank 20 via a developer replenish pipeline 90'. The developer overflowed from the developing bath 20 is discharged into a waste tank 100 as a used developer (waste liquid) via a waste pipeline 90a'. When the waste tank 100 is fully filled with the waste, the waste tank 100 is taken out of the apparatus, the waste liquid inside it is removed, and it is again returned into the apparatus.

The automatic developing apparatus 2' shown in Fig. 3A can be constituted with a slight improvement in which as a second circulation pipeline 90a, an end of the waste pipeline 90a' in Fig. 3B is connected to the developer storage tank 55' but not to the waste tank 100 and the developer storage tank 55' is used as an external tank 55 for circulating the developer to the developing bath 20. Therefore, the components of a conventional automatic developing apparatus can be effectively utilized.

### EXAMPLES

### EXAMPLE 1

A total area of 2,000 m² of a lithographic printing plate precursor was developed by an automatic developing apparatus as shown in Fig. 3A taking about 1 month. The main specifications of the automatic developing apparatus are shown below.
Capacity of the developing tank: 92 liters
Capacity of the external tank: 8 liters
(total capacity: 100 liters)
Capacity of the developer circulation pump between the external tank and the developing tank: 200 ml/min

The composition of developer used for development processing of the lithographic printing plate precursor in Example 1 is shown below. The amount of the component of developer is indicated in grams.

### Developer 1 (pH: 9.7)

| | |
|---|---|
| Water | 7965 |
| Potassium carbonate | 150 |
| Potassium hydrogen carbonate | 80 |
| Eleminol MON (47% aqueous solution) | 745 |
| (anionic surfactant, aromatic sulfonate) | |
| | |
| Ammonium primary phosphate | 180 |
| Sodium hexametaphosphate | 180 |
| Trisodium citrate | 150 |
| Hydroxy-alkylated starch | 550 |

Replenishment of the developer was not conducted. The total amount of the developer used was 100 liters. The occurrence of scum was not recognized in the developing tank. The lithographic printing plate precursor used in Example 1 was prepared as shown below.

### [Support]

### (a) Mechanical surface roughening treatment

Mechanical surface roughening treatment of an aluminum plate was conducted by means of rotating roller-form nylon brushes while supplying a suspension (having specific gravity of 1.12) of an abrasive (pumice) in water as an abrasion slurry liquid to a surface of the aluminum plate. The average particle size of the abrasive was 30 µm and the maximum particle size was 100 µm The material of the nylon brush was 6·10 nylon and the brush has a bristle length of 45 mm and a bristle diameter of 0.3 mm. The nylon brush was made by making holes in a stainless steel cylinder having a diameter of 300 mm and densely filling the brush bristles. Three of the rotating nylon brushes were used. Two supporting rollers (each having a diameter of 200 mm) were provided under the brush rollers at 300 mm intervals. The brush rollers were pressed against the aluminum plate till the load applied to a driving motor for rotating the brush became 7 kW greater than the load before pressing the brush rollers against the aluminum plate. The rotating direction of the brushes was the same as the moving direction of the aluminum plate. The rotation number of the brushes was 200 rpm.

### (b) Alkali etching treatment

Alkali etching treatment of the aluminum plate was conducted by spraying an aqueous solution having sodium hydroxide concentration of 26% by weight, aluminum ion concentration of 6.5% by weight and temperature of 70°C to dissolve the aluminum plate in an amount of 10 g/m², followed by washing with water by spraying.

### (c) Desmut treatment

Desmut treatment of the aluminum plate was conducted by spraying an aqueous 1% by weight nitric acid solution (containing 0.5% by weight of aluminum ion) having temperature of 30°C, followed by washing with water by spraying. As the aqueous nitric acid solution for the desmut treatment, a waste liquid from a process of electrochemical surface roughening treatment using alternating current in an aqueous nitric acid solution was used.

### (d) Electrochemical surface roughening treatment

Electrochemical surface roughening treatment of the aluminum plate was continuously conducted by applying 60 Hz alternating current voltage. The electrolytic solution used was an aqueous solution containing 10.5 g/liter of nitric acid (containing 5 g/liter of aluminum ion and 0.007% by weight of ammonium ion) and the solution temperature was 50°C. The electrochemical surface roughening treatment was conducted using a trapezoidal rectangular wave alternating current where time (TP) for reaching the current to its peak from zero was 0.8 msec and a duty ratio was 1:1, and using a carbon electrode as a counter electrode. A ferrite was used as an auxiliary anode. The electrolytic cell used was a radial cell type. The current density was 30 A/dm² at the peak current, and the electric quantity was 220 C/dm² in terms of the total electric quantity during the aluminum plate functioning as an anode. To the auxiliary anode, 5% of the current from the electric source was divided. Subsequently, the plate was washed with water by spraying.

### (e) Alkali etching treatment

Alkali etching treatment of the aluminum plate was conducted at 32°C by spraying an aqueous solution having a sodium hydroxide concentration of 26% by weight and an aluminum ion concentration of 6.5% by weight to dissolve the aluminum plate in an amount of 0.50 g/m². Thus, the smut component mainly comprising aluminum hydroxide formed in the precedent step of electrochemical surface roughening treatment using alternating current was removed and an edge portion of the pit formed was dissolved to smoothen the edge portion. Subsequently, the plate was washed with water by spraying.

### (f) Desmut treatment

Desmut treatment of the aluminum plate was conducted by spraying an aqueous 15% by weight sulfuric acid solution (containing 4.5% by weight of aluminum ion) having temperature of 30°C, followed by washing with water by spraying. As the aqueous nitric acid solution for the desmut treatment, a waste liquid from a process of electrochemical surface roughening treatment using alternating current in an aqueous nitric acid solution was used.

### (g) Electrochemical surface roughening treatment

Electrochemical surface roughening treatment of the aluminum plate was continuously conducted by applying 60 Hz alternating current voltage. The electrolytic solution used was an aqueous solution containing 5.0 g/liter of hydrochloric acid (containing 5 g/liter of aluminum ion) and the solution temperature was 35°C. The electrochemical surface roughening treatment was conducted using a trapezoidal rectangular wave alternating current where time (TP) for reaching the current to its peak from zero was 0.8 msec and a duty ratio was 1:1, and using a carbon electrode as a counter electrode. A ferrite was used as an auxiliary anode. The electrolytic cell used was a radial cell type.

The current density was 25 A/dm² at the peak current, and the electric quantity was 50 C/dm² in terms of the total electric quantity during the aluminum plate functioning as an anode. Subsequently, the plate was washed with water by spraying.

### (h) Anodizing treatment

Anodizing treatment of the aluminum plate was conducted using an anodizing treatment apparatus according to a two-stage feeding electrolytic treatment method (lengths of a first electrolytic unit and a second electrolytic unit: 6 m each; lengths of a first feeding unit and a second feeding unit: 3 m each; lengths of a first feeding electrode unit and a second feeding electrode unit: 2.4 m each). The electrolytic solution supplied to the first electrolytic unit and second electrolytic unit was an aqueous solution having sulfuric acid concentration of 50 g/liter (containing 0.5% by weight of aluminum ion) and the solution temperature was 20°C. Subsequently, the plate was washed with water by spraying. The amount of the final anodic oxide film was 2.7 g/m².

On the aluminum plate subjected to conducting steps (a) to (h) described above was coated an undercoat solution shown below using a bar coater so as to have a dry coating amount of 6 mg/m², followed by drying at 80°C for 20 seconds to prepare a support.

### [Undercoat solution]

| | |
|---|---|
| Polymer (SP2) shown below | 0.3 g |
| Pure water | 60.0 g |
| Methanol | 939.7 g |

### Structural formula of Polymer (SP2)

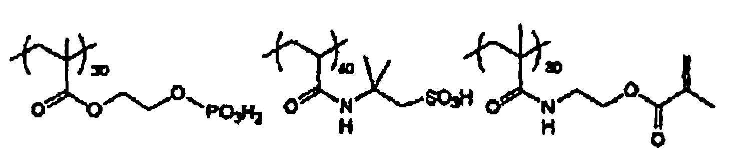

### [Photosensitive layer and Protective layer]

On the support was coated a photosensitive composition having the composition shown below using a bar coater, followed by drying at 90°C for one minute. The weight of the photosensitive composition after drying was 1.35 g/m².

The binder polymer used was PP-3 shown in Table 1 above. The sensitizing dye used was Compound (D40) shown in the specific examples thereof above. The mercapto group-containing heterocyclic compound used was Compound (SH8) shown in the specific examples thereof above.

| | |
|---|---|
| PLEX 6661-O (produced by Degussa AG) | 1.69 parts by weight |
| Binder Polymer PP-3 | 1.87 parts by weight |
| Sensitizing Dye (D40) | 0.13 parts by weight |
| BIMD (hexaarylbisimidazole, produced by Kurogane Kasei Co., Ltd.) | 0.46 parts by weight |
| ε-Phthalocyanine (P1) dispersion (25% MEK dispersion) | 1.70 parts by weight |
| Mercapto Group-containing Heterocyclic Compound (SH8) | 0.34 parts by weight |
| Fluorine-based nonionic surfactant (Megafac F-780F, produced by Dainippon Ink & Chemicals, Inc.) | 0.03 parts by weight |
| Cupferron AL (produced by Wako Pure Chemical Industries, Ltd)(10% tricresyl phosphate solution) | 0.12 parts by weight |
| Methyl ethyl ketone | 27.0 parts by weight |
| Propylene glycol monomethyl ether | 26.7 parts by weight |
| Novoperm Yellow H2G (produced by Clariant Corp.) | 0.20 parts by weight |

In the photopolymerization type photosensitive composition, ε-Phthalooyanine (F1) used was a compound illustrated by the chemical formula shown below. Binder Polymer PP-3 had a molar ratio of repeating units 1-2:a-1:b-1=10:14:76 and a weight average molecular weight of 90,000. BIMD is a compound illustrated by the chemical formula shown below.

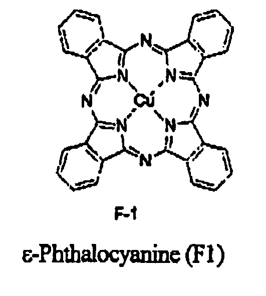

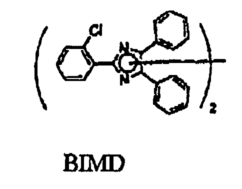

On the photosensitive layer was coated an aqueous solution for protective layer having the composition shown below using a bar coater so as to have a dry coating amount of 2.5 g/m², followed by drying at 120°C for one minute.

| | |
|---|---|
| Goseran CKS-50 (produced by Nippon Synthetic Chemical Industry Co., Ltd.,(saponification degree: 99% by mole, average polymerization degree: 300, modification degree: about 0.4% by mole])) | 1.80 parts by weight |
| Polyvinyl pyrrolidone | 0.40 parts by weight |
| EMALEX 710 (nonionic surfactant produced by Nihon-Emulsion Co., Ltd.) | 0.04 parts by weight |
| Pionin D230 (produced by Takemoto Oil & Fat Co., Ltd.) | 0.05 parts by weight |
| Luviskol V64W (produced by BASF AG) | 0.06 parts by weight |
| 13% Aqueous solution of sulfonic acid group-containing polymer having structure shown below | 0.36 parts by weight |
| Pure water | 36.0 parts by weight |

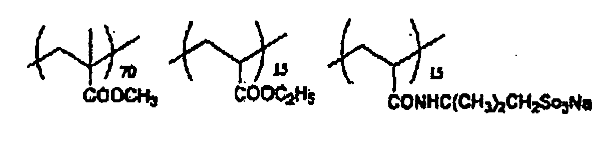

### COMPARATIVE EXAMPLE 1

A total area of 2,000 m² of a lithographic printing plate precursor was developed by an automatic developing apparatus as shown in Fig. 3A taking about 1 month The lithographic printing plate precursor used was same as that used in Example 1.

The composition of developer used for development processing of the lithographic printing plate precursor in Comparative Example 1 is shown below. The amount of the component of developer is indicated in grams.

### Comparative Developer 1 (pH: 9.7)

| | |
|---|---|
| Water | 9779.8 |
| Potassium carbonate | 130 |
| Potassium hydrogen carbonate | 70 |
| Ammonium primary phosphate | 20 |
| 2-Bromo-2-nitropropane-1,3-diol | 0.1 |
| 2-Methyl-4-isothiazolin-3-one | 0.1 |

Since degradation of the developing performance was recognized, the above-described developer was replenished in order to maintain the developing performance. The total amount of the developer used reached 150 liters and the scum precipitated in the developing tank.

### EXAMPLE 2

### (Preparation of aqueous dispersion of silica-containing organic resin particle)

### (1) Preparation of aqueous dispersion of Art Pearl J-7P

For the purpose of increasing dispersion stability, 3.0 parts by weight of a nonionic surfactant (Emalex 710, produced by Nihon-Emulsion Co., Ltd.) and 77.0 parts by weight of a mica dispersion (Somasif MEB-3L, produced by CO-OP Chemical Co., Ltd., solid content concentration: 3.4%) were mixed. To the aqueous solution was added 20 parts by weight of silica composite crosslinked acrylic resin particles (Art Pearl J-7P, produced by Negami Chemical Industrial Co., Ltd., average particle size: 6.6 µm) and the mixture was dispersed by Ace Homogenizer (produced by Nihonseiki Kaisha Ltd.) at 10,000 rpm for 15 minutes to obtain an aqueous dispersion of Art Pearl J-7P. As the result of TEM observation and X-ray fluorescence analysis, it was confirmed that silica was present on the surface of Art Pearl J-7P. The aqueous dispersion was used in a coating solution for a protective layer described hereinafter.

### [Preparation of lithographic printing plate precursor]

An aluminum plate of JIS A1050 having a thickness of 0.30 mm and a width of 1,030 mm was subjected to surface treatment shown below.

The surface treatment was carried out by continuously conducting the following processes (a) to (f). After each process and water washing, liquid removal was conducted with a nip roller.
(a) Alkali etching treatment of the aluminum plate was conducted by spraying an aqueous solution having sodium hydroxide concentration of 26% by weight, aluminum ion concentration of 6.5% by weight and temperature of 70°C to dissolve the aluminum plate in an amount of 5 g/m², followed by washing with water.
(b) Desmut treatment of the aluminum plate was conducted by spraying an aqueous 1 % by weight nitric acid solution (containing 0.5% by weight of aluminum ion) having temperature of 30°C, followed by washing with water.
(c) Electrochemical surface roughening treatment of the aluminum plate was continuously conducted by applying 60 Hz alternating current voltage. The electrolytic solution used was an aqueous 1% by weight nitric acid solution (containing 0.5% by weight of aluminum ion and 0.007% by weight of ammonium ion) and the solution temperature was 30°C. The electrochemical surface roughening treatment was conducted using a trapezoidal rectangular wave alternating current where time (TP) for reaching the current to its peak from zero was 0.8 msec and a duty ratio was 1:1 as an alternating current source, and using a carbon electrode as a counter electrode. A ferrite was used as an auxiliary anode. The current density was 25 A/dm² at the peak current, and the electric quantity was 250 C/dm² in terms of the total electric quantity during the aluminum plate functioning as an anode. To the auxiliary anode, 5% of the current from the electric source was divided. Subsequently, the plate was washed with water.
(d) Alkali etching treatment of the aluminum plate was conducted at 35°C by spraying an aqueous solution having a sodium hydroxide concentration of 26% by weight and an aluminum ion concentration of 6.5% by weight to dissolve the aluminum plate in an amount of 0.2 g/m². Thus, the smut component mainly comprising aluminum hydroxide formed in the precedent step of electrochemical surface roughening treatment using alternating current was removed and an edge portion of the pit formed was dissolved to smoothen the edge portion. Subsequently, the plate was washed with water.
(e) Desmut treatment of the aluminum plate was conducted by spraying an aqueous 25% by weight sulfuric acid solution (containing 0.5% by weight of aluminum ion) having temperature of 60°C, followed by washing with water by spraying.
(e) Anodizing treatment of the aluminum plate was conducted in an aqueous solution having sulfuric acid concentration of 170 g/liter (containing 0.5% by weight of aluminum ion) at temperature of 33°C and an electric density of 5 A/dm² for 50 seconds. Subsequently, the plate was washed with water. The amount of the anodic oxide film was 2.7 g/m².

The aluminum support thus-obtained had a surface roughness (Ra) of 0.27µm (measured using Surfcom having a stylus with a tip diameter of 2 µm, produced by Tokyo Seimitsu Co. Ltd.,).

A coating solution (1) for intermediate layer shown below was coated on the aluminum support subjected to the surface treatment so as to have a dry coating amount of 10 mg/m² and dried.

### [Coating solution (1) for intermediate layer]

| | |
|---|---|
| Compound (1) shown below | 0.017 g |
| Methanol | 9.00 g |
| Water | 1.00 g |

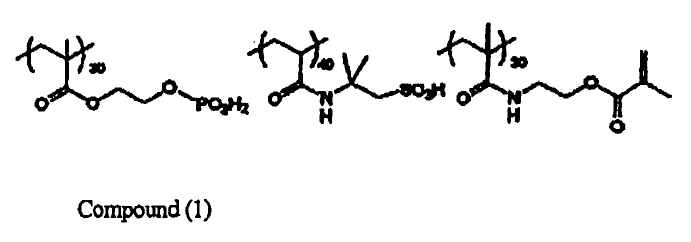

A coating solution (1) for image-forming layer (photosensitive layer) shown below was coated on the support provided with the intermediate layer using a bar and dried in an oven at 100°C for 75 seconds to from an image-forming layer (photosensitive layer) having a dry coating amount of 1.0 g /m². Further, a coating solution (1) for protective layer having the composition shown below was coated on the image-forming layer using a bar so as to have a dry coating amount of 0.5 g /m² and dried in an oven at 100°C for 90 seconds to prepare Lithographic printing plate precursor A.

The coating solution (1) for image-forming layer (photosensitive layer) was prepared by mixing Photosensitive solution (1) shown below with Microcapsule solution (1) shown below just before coating, followed by stirring.

### (Photosensitive solution (1))

| | |
|---|---|
| Binder Polymer PP-3 shown above | 0.162 parts by weight |
| Polymerization Initiator (1) shown below | 0.100 parts by weight |
| Infrared Absorbing Agent (1) shown below | 0.020 parts by weight |
| Ethylenically unsaturated compound (Aronix M-315, produced by Toa Gosei Co., Ltd., isocyanuric acid of 3 mole ethylene oxide adduct of triacrylate) | 0.385 parts by weight |
| Fluorine-Based Surfactant (1) shown below | 0.044 parts by weight |
| Crystal Violet (produced by Hodogaya Chemical Co., Ltd.) | 0.050 parts by weight |
| Methyl ethyl ketone | 1.091 parts by weight |
| 1-Methoxy-2-propanol | 8.609 parts by weight |

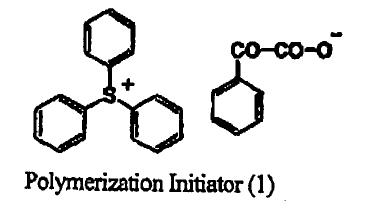

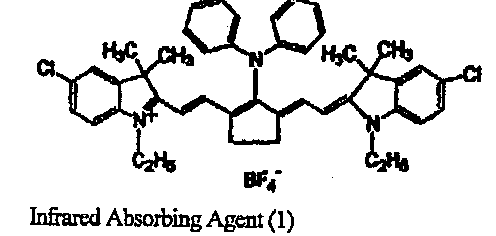

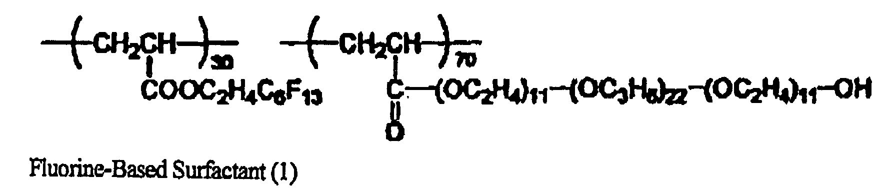

### (Microcapsule solution (1))

| | |
|---|---|
| Microcapsule (I) prepared as shown below | 2.640 parts by weight |
| Water | 2.425 parts by weight |

### Preparation of Microcapsule (1)

As an oil phase component, 10 parts by weight of adduct of trimethylolpropane and xylene diisocyanate (Takenate D-110N, produced by Mitsui Takeda Chemicals, Inc., 75% by weight ethyl acetate solution), 6.00 parts by weight of Aronix M-215 (produced by Toa Gosei Co., Ltd, bis(acryloyloxyethyl)isocyanurate) and 0.12 parts by weight of Pionin A-41C (produced by Takemoto Oil & Fat Co., Ltd.) were dissolved in 16.67 parts by weight of ethyl acetate. As an aqueous phase component, 37.5 parts by weight of an aqueous 4% by weight PVA-205 solution was prepared. The oil phase component and the aqueous phase component were mixed and emulsified using a homogenizer at 12,000 rpm for 10 minutes. The resulting emulsion was added to 25 parts by weight of distilled water and the mixture was stirred at room temperature for 30 minutes and then stirred at 40°C for 2 hours. The thus-obtained microcapsule solution was diluted with distilled water to have a solid content concentration of 15% by weight to prepare Microcapsule (1). The average particle size of the microcapsule was 0.2 µm.

### (Coating solution (1) for protective layer)

| | |
|---|---|
| Polyvinyl alcohol (aqueous 6% by weight solution) (CKS 50, produced by Nippon Synthetic Chemical Industry Co., Ltd., saponification degree: 98.5%; polymerization degree: 300) | 2.24 parts by weight |
| Surfactant (Emalex 710, produced by Nihon Emulsion Co., Ltd., aqueous 1 % by weight solution) | 2.15 parts by weight |
| Mica dispersion (aqueous 3.4% by weight dispersion)(Scale-like synthetic mica (Somasif MEB-3L, produced by CO-OP Chemical Co., Ltd.) | 3.75 parts by weight |
| Aqueous dispersion of Art Pearl J-7P described above | 0.20 parts by weight |
| Distilled water | 10.60 parts |

A total area of 2,000 m² of the lithographic printing plate precursor thus-prepared was developed by an automatic developing apparatus as shown in Fig. 3A using the developer same as in Example 1 taking about 1 month. Replenishment of the developer was not conducted. The total amount of the developer used was 100 liters. The occurrence of scum was not recognized in the developing tank.

### COMPARATIVE EXAMPLE 2

A total area of 2,000 m² of a lithographic printing plate precursor was developed by an automatic developing apparatus as shown in Fig. 3A taking about 1 month. The lithographic printing plate precursor used was same as that used in Example 2 and the developer for development processing of the lithographic printing plate precursor was same as that used in Comparative Example 1.

Since degradation of the developing performance was recognized, the above-described developer was replenished in order to maintain the developing performance. The total amount of the developer used reached 200 liters and the occurrence of scum was observed in the developing tank.

## Claims

1. A method for preparing a lithographic printing plate, comprising:
exposing imagewise a lithographic printing plate precursor comprising a hydrophilic support and an image-recording layer comprising a sensitizing dye, a polymerization initiator, an addition polymerizable compound having an ethylenically unsaturated double bond and a binder polymer;
wherein the binder polymer has an acid group in a side chain; and
processing the imagewise exposed lithographic printing plate precursor in a state where the imagewise exposed lithographic printing plate precursor is immersed in a developing tank holding an aqueous solution having pH of 8.5 to 10.8 and comprising a low molecular weight hydroxycarboxylate ion having a molecular weight of 500 or less, a pH buffer agent and a surfactant with circulation of the aqueous solution between the developing tank and an external tank provided outside a processing path line including the developing tank so as to keep constant a liquid level of the aqueous solution in the developing tank,
wherein the exposed lithographic printing plate precursor is processed with only one solution of the aqueous solution.

2. The method for preparing a lithographic printing plate as claimed in claim 1, wherein the lithographic printing plate precursor is contacted with at least one rubbing member which rotates in the aqueous solution in the developing tank to remove a non-image area of the lithographic printing plate precursor.

3. The method for preparing a lithographic printing plate as claimed in claim 2, wherein the removal operation of the non-image area of the lithographic printing plate precursor by contact with the rubbing member which rotates is performed at least 2 seconds after a part of the lithographic printing plate precursor to be subjected to contact with the rubbing member is contacted with the aqueous solution.

4. The method for preparing a lithographic printing plate as claimed in claim 3, wherein the rubbing member is provided on a downstream side of a center of transporting path of the lithographic printing plate precursor in the developing tank in a transporting direction.

5. The method for preparing a lithographic printing plate as claimed in claim 4, wherein the aqueous solution in the external tank is sprayed to the lithographic printing plate precursor near a lead-in roller provided on an upstream side than the developing tank in a transporting direction and a lead-out roller provided on a downstream side than the developing tank in a transporting direction in a transporting path of the lithographic printing plate precursor.

6. The method for preparing a lithographic printing plate as claimed in any one of claims 1 to 5, wherein the imagewise exposed lithographic printing plate precursor is subjected to a heat treatment, and, after the heat treatment, processed in a state where the imagewise exposed lithographic printing plate precursor is immersed in the developing tank.

7. The method for preparing a lithographic printing plate as claimed in any one of claims 1 to 6, wherein the aqueous solution comprises a water-soluble resin.

8. The method for preparing a lithographic printing plate as claimed in any one of claims 1 to 7, wherein the low molecular weight hydroxycarboxylate ion is a hydroxycarboxylate ion having at least two carboxylic acid groups.

9. The method for preparing a lithographic printing plate as claimed in any one of claims 1 to 7, wherein the low molecular weight hydroxycarboxylate ion is at least one selected from the group consisting of a citrate ion, a tartarate ion and a malate ion.

10. The method for preparing a lithographic printing plate as claimed in any one of claims 1 to 9, wherein the pH buffer agent is at least one selected from the group consisting of a carbonate ion and a hydrogen carbonate ion, a borate ion, and a water-soluble amine compound and an ion of the amine compound.

11. The method for preparing a lithographic printing plate as claimed in any one of claims 1 to 10, wherein the sensitizing dye is a sensitizing dye represented by one of the following formulae (1) to (5): 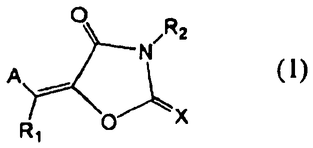 wherein, in the formula (1), A represents an aromatic cyclic group which may have a substituent or a heterocyclic group which may have a substituent, X represents an oxygen atom, a sulfur atom or =N-R₃ , and R_{1,} R₂ and R₃ each independently represents a monovalent non-metallic atomic group, or A and R₁ or R₂ and R₃ may be combined with each other to form an aliphatic or aromatic ring; 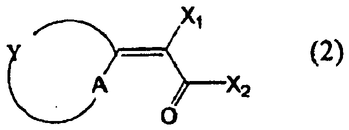 wherein, in the formula (2), A represents a sulfur atom or NR₆, R₆ represents a monovalent non-metallic atomic group, Y represents a non-metallic atomic group necessary for forming a basic nucleus of the dye together with adjacent A and the adjacent carbon atom, and X₁ and X₂ each independently represents a monovalent non-metallic atomic group or X₁ and X₂ may be combined with each other to form an acidic nucleus of the dye; 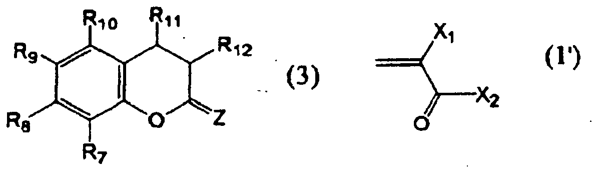 wherein, in the formula (3), =Z represents an oxo group, a thioxo group, an imino group or an alkylydene group represented by partial structure of the foregoing formula (I'), X₁ and X₂ each independently represents a monovalent non-metallic atomic group or X₁ and X₂ may be combined with each other to form an acidic nucleus of the dye, and R₇ to R₁₂ each independently represents a monovalent non-metallic atomic group; 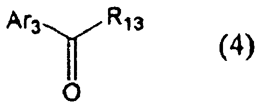 wherein, in the formula (4), Ar₃ represents an aromatic group which may have a substituent or a heteroaromatic group which may have a substituent, and R₁₃ represents a monovalent non-metallic atomic group or Ar₃ and R₁₃ may be combined with each other to form a ring; 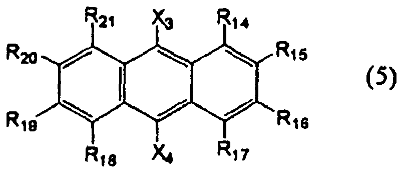 wherein, in the formula (5), X₃, X₄ and R₁₄ to R₂₁ each independently represents a monovalent non-metallic atomic group.

12. The method for preparing a lithographic printing plate as claimed in any one of claims 1 to 11, wherein the lithographic printing plate precursor is exposed imagewise by a laser beam having a wavelength of 350 to 450 nm.

13. The method for preparing a lithographic printing plate as claimed in any one of claims 1 to 12, wherein the lithographic printing plate precursor further comprises a protective layer so that the hydrophilic support, the image-recording layer and the protective layer are provided in this order.

## Patentansprüche

1. Verfahren zum Herstellen einer lithographischen Druckplatte, umfassend:
das bildweise Belichten einer lithographischen Druckplattenvorstufe umfassend einen hydrophilen Träger und eine Bildaufzeichnungsschicht umfassend einen Sensibilisierungsfarbstoff, einen Polymerisationsinitiator, eine additionspolymerisierbare Verbindung mit einer ethylenisch ungesättigten Doppelbindung und ein Bindemittelpolymer;
wobei das Bindemittelpolymer eine Säuregruppe in einer Seitenkette aufweist; und
das Verarbeiten der bildweise belichteten lithographischen Druckplattenvorstufe in einem Zustand, bei dem die bildweise belichtete lithographische Druckplattenvorstufe in einen Entwicklungstank eingetaucht ist, der eine wässrige Lösung enthält, die einen pH von 8,5 bis 10,8 aufweist und ein Hydroxycarboxylation mit niedrigem Molekulargewicht, das ein Molekulargewicht von 500 oder weniger aufweist, eine pH-Puffersubstanz und eine oberflächenaktive Substanz umfasst, wobei die wässrige Lösung zwischen dem Entwicklungstank und einem externen Tank zirkuliert, der außerhalb einer Verarbeitungsweglinie bereitgestellt ist, die den Entwicklungstank einschließt, um einen Flüssigkeitsspiegel der wässrigen Lösung in dem Entwicklungstank konstant zu halten,
wobei die belichtete lithographische Druckplattenvorstufe mit nur einer Lösung der wässrigen Lösung verarbeitet wird.

2. Verfahren zum Herstellen einer lithographischen Druckplatte nach Anspruch 1, wobei die lithographische Druckplattenvorstufe mit wenigstens einem reibenden Element in Kontakt gebracht wird, welches in der wässrigen Lösung in dem Entwicklungstank rotiert, um einen Nichtbildbereich der lithographischen Druckplattenvorstufe zu entfernen.

3. Verfahren zum Herstellen einer lithographischen Druckplatte nach Anspruch 2, wobei der Arbeitsgang des Entfernens des Nichtbildbereichs der lithographischen Druckplattenvorstufe durch Kontakt mit dem reibenden Element, welches rotiert, wenigstens 2 Sekunden nachdem ein Teil der lithographischen Druckplattenvorstufe, der bzw. die mit dem reibenden Element in Kontakt gebracht werden soll, mit der wässrigen Lösung in Kontakt gebracht wurde, durchgeführt wird.

4. Verfahren zum Herstellen einer lithographischen Druckplatte nach Anspruch 3, wobei das reibende Element auf einer stromabwärts liegenden Seite von einer Mitte des Transportweges der lithographischen Druckplattenvorstufe in dem Entwicklungstank in einer Transportrichtung bereitgestellt wird.

5. Verfahren zum Herstellen einer lithographischen Druckplatte nach Anspruch 4, wobei die wässrige Lösung in dem externen Tank in der Nähe einer Einführwalze, die auf einer stromaufwärts von dem Entwicklungstank liegenden Seite in einer Transportrichtung bereitgestellt ist, und einer Ausführwalze, die auf einer stromabwärts von dem Entwicklungstank liegenden Seite in einer Transportrichtung in einem Transportweg der lithographischen Druckplattenvorstufe bereitgestellt ist, auf die lithographische Druckplattenvorstufe gesprüht wird.

6. Verfahren zum Herstellen einer lithographischen Druckplatte nach einem der Ansprüche 1 bis 5, wobei die bildweise belichtete lithographische Druckplattenvorstufe einer Wärmebehandlung unterworfen wird und nach der Wärmebehandlung in einem Zustand verarbeitet wird, bei dem die bildweise belichtete lithographische Druckplattenvorstufe in den Entwicklungstank eingetaucht ist.

7. Verfahren zum Herstellen einer lithographischen Druckplatte nach einem der Ansprüche 1 bis 6, wobei die wässrige Lösung ein wasserlösliches Harz umfasst.

8. Verfahren zum Herstellen einer lithographischen Druckplatte nach einem der Ansprüche 1 bis 7, wobei das Hydroxycarboxylation mit niedrigem Molekulargewicht ein Hydroxycarboxylation ist, das wenigstens zwei Carbonsäuregruppen aufweist.

9. Verfahren zum Herstellen einer lithographischen Druckplatte nach einem der Ansprüche 1 bis 7, wobei das Hydroxycarboxylation mit niedrigem Molekulargewicht wenigstens eines, ausgewählt aus der Gruppe bestehend aus einem Citration, einem Tartration und einem Malation, ist.

10. Verfahren zum Herstellen einer lithographischen Druckplatte nach einem der Ansprüche 1 bis 9, wobei die pH-Puffersubstanz wenigstens eine, ausgewählt aus der Gruppe bestehend aus einem Carbonation und einem Hydrogencarbonation, einem Boration und einer wasserlöslichen Aminverbindung und einem Ion der Aminverbindung, ist.

11. Verfahren zum Herstellen einer lithographischen Druckplatte nach einem der Ansprüche 1 bis 10, wobei der Sensibilisierungsfarbstoff ein Sensibilisierungsfarbstoff ist, der durch eine der folgenden Formeln (1) bis (5) wiedergegeben ist: 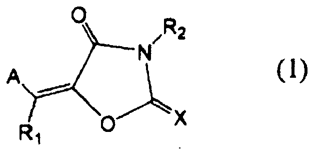 wobei in der Formel (1) A eine aromatische cyclische Gruppe, welche einen Substituenten aufweisen kann, oder eine heterocyclische Gruppe, welche einen Substituenten aufweisen kann, bedeutet, X ein Sauerstoffatom, ein Schwefelatom oder =N-R₃ bedeutet, und R₁, R₂ und R₃ jeweils unabhängig voneinander eine einwertige Nichtmetallatomgruppe bedeutet, oder A und R₁ oder R₂ und R₃ miteinander kombiniert sein können unter Bildung eines aliphatischen oder aromatischen Rings; 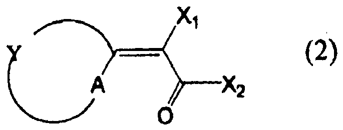 wobei in der Formel (2) A ein Schwefelatom oder NR₆ bedeutet, R₆ eine einwertige Nichtmetallatomgruppe bedeutet, Y eine Nichtmetallatomgruppe bedeutet, die zum Bilden eines basischen Kerns des Farbstoffs zusammen mit dem benachbarten A und dem benachbarten Kohlenstoffatom erforderlich ist, und X₁ und X₂ jeweils unabhängig voneinander eine einwertige Nichtmetallatomgruppe bedeutet oder X₁ und X₂ miteinander kombiniert sein können unter Bildung eines sauren Kerns des Farbstoffs; 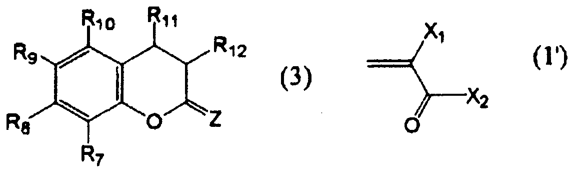 wobei in der Formel (3) =Z eine Oxogruppe, eine Thioxogruppe, eine Iminogruppe oder eine Alkylidengruppe, die durch die Teilstruktur der vorstehenden Formel (I') wiedergegeben ist, bedeutet, X₁ und X₂ jeweils unabhängig voneinander eine einwertige Nichtmetallatomgruppe bedeutet oder X₁ und X₂ miteinander kombiniert sein können unter Bildung eines sauren Kerns des Farbstoffs, und R₇ bis R₁₂ jeweils unabhängig voneinander eine einwertige Nichtmetallatomgruppe bedeutet; 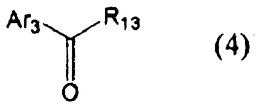 wobei in der Formel (4) Ar₃ eine aromatische Gruppe, welche einen Substituenten aufweisen kann, oder eine heteroaromatische Gruppe, welche einen Substituenten aufweisen kann, bedeutet und R₁₃ eine einwertige Nichtmetallatomgruppe bedeutet oder Ar₃ und R₁₃ miteinander kombiniert sein können unter Bildung eines Rings; 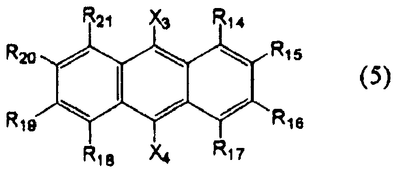 wobei in der Formel (5) X₃, X₄ und R₁₄ bis R₂₁ jeweils unabhängig voneinander eine einwertige Nichtmetallatomgruppe bedeutet.

12. Verfahren zum Herstellen einer lithographischen Druckplatte nach einem der Ansprüche 1 bis 11, wobei die lithographische Druckplattenvorstufe mit einem Laserstrahl mit einer Wellenlänge von 350 bis 450 nm bildweise belichtet wird.

13. Verfahren zum Herstellen einer lithographischen Druckplatte nach einem der Ansprüche 1 bis 12, wobei die lithographische Druckplattenvorstufe außerdem eine Schutzschicht umfasst, so dass der hydrophile Träger, die Bildaufzeichnungsschicht und die Schutzschicht in dieser Reihenfolge bereitgestellt sind.

## Revendications

1. Procédé de préparation d'une plaque d'impression lithographique, comprenant :
l'exposition, conformément à une image, d'un précurseur de plaque d'impression lithographique comprenant un support hydrophile et une couche d'enregistrement d'image comprenant un colorant sensibilisateur, un initiateur de polymérisation, un composé polymérisable par addition possédant une double liaison éthyléniquement insaturée et un liant polymère ;
où le liant polymère possède un groupe acide dans une chaîne latérale ; et
le traitement du précurseur de plaque d'impression lithographique exposé conformément à une image, dans un état où le précurseur de plaque d'impression lithographique exposé conformément à une image est immergé dans une cuve de développement contenant une solution aqueuse ayant un pH de 8,5 à 10,8 et comprenant un ion hydroxycarboxylate de faible masse moléculaire ayant une masse moléculaire de 500 ou moins, un agent tampon de pH et un tensioactif avec une circulation de la solution aqueuse entre la cuve de développement et une cuve externe disposée à l'extérieur d'une ligne de trajet de traitement incluant la cuve de développement de façon à maintenir constant le niveau de liquide de la solution aqueuse dans la cuve de développement,
où le précurseur de plaque d'impression lithographique exposé est traité avec une seule solution de la solution aqueuse.

2. Procédé de préparation d'une plaque d'impression lithographique selon la revendication 1, dans lequel le précurseur de plaque d'impression lithographique est mis en contact avec au moins un élément de frottement qui tourne dans la solution aqueuse dans la cuve de développement pour éliminer une région sans image du précurseur de plaque d'impression lithographique.

3. Procédé de préparation d'une plaque d'impression lithographique selon la revendication 2, dans lequel l'opération d'élimination de la région sans image du précurseur de plaque d'impression lithographique par contact avec l'élément de frottement qui tourne est effectuée au moins 2 secondes après qu'une partie du précurseur de plaque d'impression lithographique à mettre en contact avec l'élément de frottement est mis en contact avec la solution aqueuse.

4. Procédé de préparation d'une plaque d'impression lithographique selon la revendication 3, dans lequel l'élément de frottement est disposé du côté aval par rapport au milieu du trajet de transport du précurseur de plaque d'impression lithographique dans la cuve de développement dans un sens de transport.

5. Procédé de préparation d'une plaque d'impression lithographique selon la revendication 4, dans lequel la solution aqueuse dans la cuve externe est pulvérisée sur le précurseur de plaque d'impression lithographique près d' un rouleau d'entrée disposé du côté amont par rapport à la cuve de développement dans un sens de transport et d'un rouleau de sortie disposé du côté aval par rapport à la cuve de développement dans un sens de transport sur un trajet de transport du précurseur de plaque d'impression lithographique.

6. Procédé de préparation d'une plaque d'impression lithographique selon l'une quelconque des revendications 1 à 5, dans lequel le précurseur de plaque d'impression lithographique exposé conformément à une image est soumis à un traitement thermique, et, après le traitement thermique, traité dans un état où le précurseur de plaque d'impression lithographique exposé conformément à une image est immergé dans la cuve de développement.

7. Procédé de préparation d'une plaque d'impression lithographique selon l'une quelconque des revendications 1 à 6, dans lequel la solution aqueuse comprend une résine hydrosoluble.

8. Procédé de préparation d'une plaque d'impression lithographique selon l'une quelconque des revendications 1 à 7, dans lequel l'ion hydroxycarboxylate de faible masse moléculaire est un ion hydroxycarboxylate possédant au moins deux groupes acide carboxylique.

9. Procédé de préparation d'une plaque d'impression lithographique selon l'une quelconque des revendications 1 à 7, dans lequel l'ion hydroxycarboxylate de faible masse moléculaire est au moins un ion sélectionné dans le groupe constitué par un ion citrate, par un ion tartrate et par un ion malate.

10. Procédé de préparation d'une plaque d'impression lithographique selon l'une quelconque des revendications 1 à 9, dans lequel l'agent tampon de pH est au moins un agent sélectionné dans le groupe constitué par un ion carbonate et un ion hydrogénocarbonate, par un ion borate, et par un composé d'amine hydrosoluble et un ion de ce composé d'amine.

11. Procédé de préparation d'une plaque d'impression lithographique selon l'une quelconque des revendications 1 à 10, dans lequel le colorant sensibilisateur est un colorant sensibilisateur représenté par l'une des formules (1) à (5) suivantes : 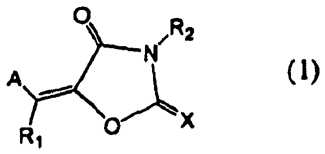 où, dans la formule (1), A représente un groupe cyclique aromatique qui peut posséder un substituant ou un groupe hétérocyclique qui peut posséder un substituant, X représente un atome d'oxygène, un atome de soufre, ou =N-R₃, et R₁, R₂, et R₃ représentent chacun indépendamment un groupe d'atomes non métallique monovalent, ou A et R₁ ou R₂ et R₃ peuvent être combinés l'un avec l'autre pour former un cycle aliphatique ou aromatique ; 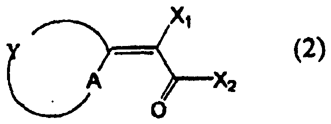 où, dans la formule (2), A représente un atome de soufre ou NR₆, R₆ représente un groupe d'atomes non métallique monovalent, Y représente un groupe d'atomes non métallique monovalent nécessaire pour former un noyau basique du colorant conjointement avec un A adjacent et l'atome de carbone adjacent, et X₁ et X₂ représentent chacun indépendamment un groupe d'atomes non métallique monovalent, ou X₁ et X₂ peuvent être combinés l'un avec l'autre pour former un noyau acide du colorant ; 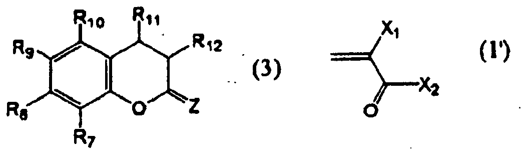 où, dans la formule (3), =Z représente un groupe oxo, un groupe thioxo, un groupe imino ou un groupe alkylidène représenté par une structure partielle de formule (I') précédente, X₁ et X₂ représentent chacun indépendamment un groupe d'atomes non métallique monovalent ou X₁ et X₂ peuvent être combinés l'un avec l'autre pour former un noyau acide du colorant, et les R₇ à R₁₂ représentent chacun indépendamment un groupe d'atomes non métallique monovalent ; 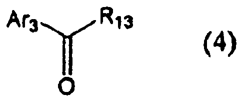 où, dans la formule (4), Ar₃ représente un groupe aromatique qui peut posséder un substituant ou un groupe hétéroaromatique qui peut posséder un substituant, et R₁₃ représente un groupe d'atomes non métallique monovalent, ou Ar₃ et R₁₃ peuvent être combinés l'un avec l'autre pour former un cycle ; 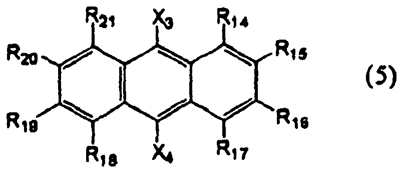 où, dans la formule (5), X₃ , X₄ et les R₁₄ à R₂₁ représentent chacun indépendamment un groupe d'atomes non métallique monovalent.

12. Procédé de préparation d'une plaque d'impression lithographique selon l'une quelconque des revendications 1 à 11, dans lequel le précurseur de plaque d'impression lithographique est exposé conformément à une image au moyen d'un faisceau laser ayant une longueur d'onde de 350 à 450 nm.

13. Procédé de préparation d'une plaque d'impression lithographique selon l'une quelconque des revendications 1 à 12, dans lequel le précurseur de plaque d'impression lithographique comprend en outre une couche protectrice de façon à ce que le support hydrophile, la couche d'enregistrement d'image et la couche protectrice soient disposés dans cet ordre.
